# EUROPEAN PATENT SPECIFICATION

(11) **EP 4 357 385 B1**
(45) Date of publication and mention of the grant of the patent: **07.05.2025**
(21) Application number: 22846058.0
(22) Date of filing: 21.06.2022
(51) Int. Cl.: C08G 61/12, C09D 165/00, C09K 11/06, H10K 85/10, C08L 65/00

(54) **POLYMER, AND ORGANIC LIGHT-EMITTING ELEMENT USING SAME**
POLYMER UND ORGANISCHES LICHTEMITTIERENDES ELEMENT DAMIT
POLYMÈRE ET ÉLÉMENT ÉLECTROLUMINESCENT ORGANIQUE L'UTILISANT

(30) Priority: 21.07.2021 KR 20210095599; 21.07.2021 KR 20210095600
(43) Date of publication of application: 24.04.2024
(73) Proprietor: LG Chem, Ltd., Yeongdeungpo-gu Seoul 07336 (KR)
(72) Inventor: KIM, Ji Hoon, Daejeon 34122 (KR); KIM, Juhwan, Daejeon 34122 (KR); KANG, Sungkyoung, Daejeon 34122 (KR); KHIM, Dongyoon, Daejeon 34122 (KR); WOO, Yu Jin, Daejeon 34122 (KR); LEE, Jaechol, Daejeon 34122 (KR); LEE, Jiyoung, Daejeon 34122 (KR); JUNG, Sejin, Daejeon 34122 (KR)
(74) Representative: Hoffmann Eitle
(86) International application number: PCT/KR2022/008796
(87) International publication number: WO 2023/003186

(56) References cited:
- WO-A1-2012/067212
- KR-A- 20100 098 533
- KR-A- 20160 131 947
- KR-A- 20200 011 153
- KR-A- 20220 045 781

## Description

### [Technical Field]

The present specification relates to a polymer and an organic light emitting device formed by using the same.

### [Background Art]

An organic light emission phenomenon is one of the examples of converting an electric current into visible rays through an internal process of a specific organic molecule. The principle of the organic light emission phenomenon is as follows. When an organic material layer is disposed between a positive electrode and a negative electrode, if electric current is applied between the two electrodes, electrons and holes are injected from the negative electrode and the positive electrode, respectively, into the organic material layer. The electrons and the holes which are injected into the organic material layer are recombined to form an exciton, and the exciton falls down again to the ground state to emit light. An organic electroluminescent device using this principle may be generally composed of a negative electrode, a positive electrode, and an organic material layer disposed therebetween, for example, an organic material layer including a hole injection layer, a hole transport layer, a light emitting layer, an electron transport layer, and an electron injection layer.

A material used in the organic light emitting device is mostly a pure organic material or a complex compound where an organic material and metal form a complex, and may be classified into a hole injection material, a hole transport material, a light emitting material, an electron transport material, an electron injection material, and the like according to the use thereof. Herein, an organic material having a p-type property, that is, an organic material, which is easily oxidized and has an electrochemically stable state during oxidation, is usually used as the hole injection material or the hole transport material. Meanwhile, an organic material having an n-type property, that is, an organic material, which is easily reduced and has an electrochemically stable state during reduction, is usually used as the electron injection material or the electron transport material. As the light emitting material, a material having both p-type and n-type properties, that is, a material having a stable form in both oxidation and reduction states is preferred, and a material having high light emitting efficiency for converting an exciton into light when the exciton is formed is preferred.

Hole transport materials for OLEDS are known, for example, from KR 2016 0131947 A.

In addition to those mentioned above, it is preferred that the material used in the organic light emitting device additionally has the following properties.

First, it is preferred that the material used in the organic light emitting device has excellent thermal stability. This is because joule heating occurs due to the movement of electric charges in the organic light emitting device. Currently, since N,N'-di(1-naphthyl)-N,N'-diphenyl-(1,1'-biphenyl)-4,4'-diamine (NPB) typically used as a hole transport material has a glass transition temperature value of 100°C or less, there is a problem in that it is difficult to use the material in an organic light emitting device requiring a high electric current.

Second, in order to obtain a high-efficiency organic light emitting device which is capable of being driven at low voltage, holes or electrons injected into the organic light emitting device need to be smoothly transferred to a light emitting layer, and simultaneously, the injected holes and electrons need to be prevented from being released out of the light emitting layer. For this purpose, a material used in the organic light emitting device needs to have an appropriate band gap and an appropriate highest occupied molecular orbital (HOMO) or lowest unoccupied molecular orbital (LUMO) energy level. Since poly(3,4-ethylenedioxythiophene) doped : poly(styrenesulfonic acid) (PEDOT:PSS) currently used as a hole transport material in an organic light emitting device to be manufactured by a solution application method has a lower LUMO energy level than the LUMO energy level of an organic material used as a light emitting layer material, it is difficult to manufacture an organic light emitting device having high efficiency and a long service life.

In addition, the material used in the organic light emitting device needs to have excellent chemical stability, excellent charge mobility, excellent interface characteristics with electrodes or adjacent layers, and the like. That is, the material used in the organic light emitting device needs to be minimally deformed by moisture or oxygen. Further, the material used in the organic light emitting device needs to have appropriate hole or electron mobility so as to make a balance between densities of holes and electrons in a light emitting layer of the organic light emitting device, thereby maximally forming excitons. Moreover, the material used in the organic light emitting device needs to improve the interface with an electrode including a metal or a metal oxide for the stability of the device.

In addition to those mentioned above, a material used in an organic light emitting device for a solution process needs to additionally have the following properties.

First, the material used in the organic light emitting device needs to form a storable homogenous solution. Since a commercialized material for a deposition process has good crystallinity so that the material is not dissolved well in a solution or the crystals thereof are easily formed even though the material forms a solution, it is highly likely that according to the storage period, the concentration gradient of the solution varies or a defective device is formed.

Second, layers where the solution process is performed need to have solvent and material resistance to other layers. For this purpose, a material capable of forming a polymer self-cross-linked on a substrate through a heat treatment or ultraviolet (UV) irradiation after a curing group is introduced and a solution is applied, like N4,N4'-di(naphthalen-1-yl)-N4,N4'-bis(4-vinylphenyl)biphenyl-4,4'-diamine (VNPB), or capable of forming a polymer having sufficient resistance in the next process is preferred, and a material capable of having solvent resistance itself, like hexaazatriphenylenehexacarbonitrile (HATCN), is also preferred.

Therefore, there is a need for developing an organic material having the aforementioned requirements in the art.

### [Detailed Description of the Invention]

### [Technical Problem]

The present specification provides a polymer and an organic light emitting device formed using the same.

### [Technical Solution]

An exemplary embodiment of the present specification provides a polymer including: a first unit represented by the following Chemical Formula 1; a second unit represented by the following Chemical Formula 1 and different from the first unit; a third unit represented by the following Chemical Formula 2; and an end group represented by the following Chemical Formula 3.

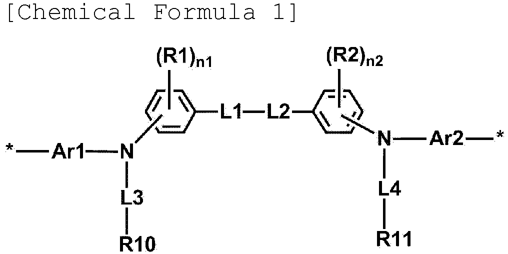

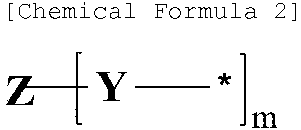

[Chemical Formula 3] * -[E]

In Chemical Formulae 1 to 3,
L1, L3 and L4 are the same as or different from each other, and are each independently a direct bond; or a substituted or unsubstituted arylene group,
Ar1, Ar2 and L2 are the same as or different from each other, and are each independently a substituted or unsubstituted arylene group,
R1 and R2 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
R10 and R11 are the same as or different from each other, and are each independently a substituted or unsubstituted alkyl group; a substituted or unsubstituted aryl group; a substituted or unsubstituted heterocyclic group; or a substituted or unsubstituted arylamine group,
n1 and n2 are each an integer from 1 to 4, and when n1 and n2 are each 2 or higher, substituents in the parenthesis are the same as or different from each other,
m is an integer of 3 or 4,
when m is 3, Z is CRa; SiRa; N; or a substituted or unsubstituted trivalent aryl group,
when m is 4**,** Z is C; Si; or a substituted or unsubstituted tetravalent aryl group,
Ra is hydrogen; deuterium; a substituted or unsubstituted alkyl group; or a substituted or unsubstituted aryl group,
Y is a direct bond; a substituted or unsubstituted alkylene group; or a substituted or unsubstituted arylene group,
when Y is a direct bond; or a substituted or unsubstituted alkylene group, Z is a substituted or unsubstituted trivalent or tetravalent aryl group,
E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a substituted or unsubstituted heterocyclic group; a cross-linkable group; or a combination thereof, and
* is an attachment point in the polymer.

Another exemplary embodiment of the present specification provides an organic light emitting device including: a first electrode; a second electrode; and an organic material layer having one or more layers provided between the first electrode and the second electrode, in which one or more layers of the organic material layer include the polymer.

### [Advantageous Effects]

The polymer according to an exemplary embodiment of the present specification easily adjusts electrical characteristics by simultaneously including a first unit and a second unit which are different from each other. Accordingly, an effect in which the hole mobility is improved is exhibited.

Further, the polymer according to an exemplary embodiment of the present specification can be applied to an organic material layer of an organic light emitting device, and thus can improve the performance and life characteristics of the device. Specifically, the polymer according to an exemplary embodiment of the present specification can be applied to a hole transport layer of the organic light emitting device to improve the efficiency and/or service life of the device.

### [Brief Description of Drawings]

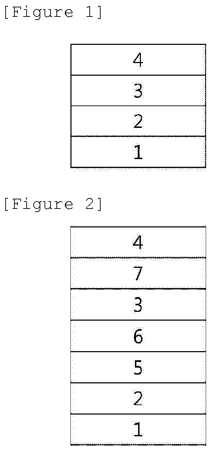

FIGS. 1 and 2 are views exemplifying the structure of an organic light emitting device according to some exemplary embodiments of the present specification.
- 1:: Substrate
- 2:: Anode
- 3:: Light emitting layer
- 4:: Cathode
- 5:: Hole injection layer
- 6:: Hole transport layer
- 7:: Electron injection and transport layer

### [Best Mode]

Hereinafter, the present specification will be described in detail.

The present specification provides a polymer including: a first unit represented by the following Chemical Formula 1; a second unit represented by the following Chemical Formula 1 and different from the first unit; a third unit represented by the following Chemical Formula 2; and an end group represented by the following Chemical Formula 3.

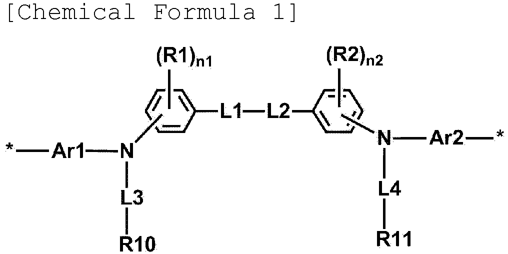

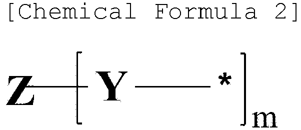

[Chemical Formula 3] *-[E]

In Chemical Formulae 1 to 3,
L1, L3 and L4 are the same as or different from each other, and are each independently a direct bond; or a substituted or unsubstituted arylene group,
Ar1, Ar2 and L2 are the same as or different from each other, and are each independently a substituted or unsubstituted arylene group,
R1 and R2 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
R10 and R11 are the same as or different from each other, and are each independently a substituted or unsubstituted alkyl group; a substituted or unsubstituted aryl group; a substituted or unsubstituted heterocyclic group; or a substituted or unsubstituted arylamine group,
n1 and n2 are each an integer from 1 to 4, and when n1 and n2 are each 2 or higher, substituents in the parenthesis are the same as or different from each other,
m is an integer of 3 or 4,
when m is 3, Z is CRa; SiRa; N; or a substituted or unsubstituted trivalent aryl group,
when m is 4**,** Z is C; Si; or a substituted or unsubstituted tetravalent aryl group,
Ra is hydrogen; deuterium; a substituted or unsubstituted alkyl group; or a substituted or unsubstituted aryl group,
Y is a direct bond; a substituted or unsubstituted alkylene group; or a substituted or unsubstituted arylene group,
when Y is a direct bond; or a substituted or unsubstituted alkylene group, Z is a substituted or unsubstituted trivalent or tetravalent aryl group,
E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a substituted or unsubstituted heterocyclic group; a cross-linkable group; or a combination thereof, and
* is an attachment point in the polymer.

In an exemplary embodiment of the present specification, the polymer includes a first unit and a second unit which are different from each other. When the first unit is included alone or the second unit is included alone, there is a problem in that it is difficult to finely adjust electrical characteristics because the electrical characteristics are determined only by the first unit or the second unit. In contrast, the polymer of the present specification has an advantage in that the electrical characteristics can be finely adjusted by adjusting the two units by including all of the first unit and the second unit having different electrical characteristics. Therefore, the polymer according to an exemplary embodiment of the present specification includes all of the first unit and the second unit which are different from each other to exhibit an effect of improving the hole mobility compared to the case where the first unit or the second unit is included alone, and accordingly, it is possible to obtain an effect of improving the efficiency and service life of the organic light emitting device to which the polymer is applied.

When one member (layer) is disposed "on" another member (layer) in the present specification, this includes not only a case where the one member (layer) is brought into contact with another member, but also a case where still another member (layer) is present between the two members (layers).

When one part "includes" one constituent element in the present specification, unless otherwise specifically described, this does not mean that another constituent element is excluded, but means that another constituent element may be further included.

In the present specification, the "mole fraction" means a ratio of the mole number of a given component to the total mole number of all the components.

In the present specification, the "adjacent" group may mean a substituent substituted with an atom directly linked to an atom in which the corresponding substituent is substituted, a substituent disposed to be sterically closest to the corresponding substituent, or another substituent substituted with an atom in which the corresponding substituent is substituted. For example, two substituents substituted at the ortho position in a benzene ring and two substituents substituted with the same carbon in an aliphatic ring may be interpreted as groups which are "adjacent" to each other.

In the present specification, in a ring formed by bonding adjacent groups, the "ring" means a substituted or unsubstituted hydrocarbon ring; or a substituted or unsubstituted hetero ring.

Unless otherwise defined in the present specification, all technical and scientific terms used in the present specification have the same meaning as commonly understood by one with ordinary skill in the art to which the present invention pertains. Although methods and materials similar to or equivalent to those described in the present invention may be used in the practice or in the test of exemplary embodiments of the present invention, suitable methods and materials will be described below.

The materials, methods, and examples are illustrative only and are not intended to be limiting.

Examples of the substituents in the present specification will be described below, but are not limited thereto.

In the present specification, "------" means a moiety linked to another substituent or a bonding portion.

In the present specification, "*" is an attachment point in the polymer.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being substituted with one or two or more substituents selected from the group consisting of deuterium; a halogen group; an alkyl group; a cycloalkyl group; an alkoxy group; an aryloxy group; an amine group; an aryl group; a heterocyclic group; and a cross-linkable group, being substituted with a substituent to which two or more substituents among the exemplified substituents are linked, or having no substituent. For example, "the substituent to which two or more substituents are linked" may be a biphenyl group. That is, the biphenyl group may also be an aryl group, and may be interpreted as a substituent to which two phenyl groups are linked.

Examples of the substituents will be described below, but are not limited thereto.

In the present specification, examples of a halogen group include fluorine (F), chlorine (Cl), bromine (Br) or iodine (I).

In the present specification, an alkyl group may be straight-chained or branched, and the number of carbon atoms thereof is not particularly limited, but is preferably 1 to 60. According to an exemplary embodiment, the number of carbon atoms of the alkyl group is 1 to 30. Specific examples of the alkyl group include a methyl group, an ethyl group, a propyl group, an isopropyl group, a butyl group, an isobutyl group, a tert-butyl group, a pentyl group, a hexyl group, a heptyl group, an octyl group, and the like, but are not limited thereto.

In the present specification, an alkylene group means a group having two bonding positions in an alkyl group, that is, a divalent group. The above-described description on the alkyl group may be applied to the alkylene group, except for a divalent alkylene group.

In the present specification, the number of carbon atoms of the cycloalkyl group is not particularly limited, but is preferably 3 to 60. According to an exemplary embodiment, the number of carbon atoms of the cycloalkyl group is 3 to 30. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present specification, an alkoxy group may be straight-chained, branched, or cyclic. The number of carbon atoms of the alkoxy group is not particularly limited, but is preferably 1 to 30. Specific examples of the alkoxy group may be a methoxy group, an ethoxy group, an n-propoxy group, an isopropoxy group, an n-butoxy group, an isobutoxy group, a tert-butoxy group, a sec-butoxy group, an n-pentyloxy group, a neopentyloxy group, an isopentyloxy group, an n-hexyloxy group, a 3,3-dimethylbutyloxy group, a 2-ethylbutyloxy group, an n-octyloxy group, an n-nonyloxy group, an n-decyloxy group and the like, but are not limited thereto.

In the present specification, an amine group may be selected from the group consisting of -NH₂; an alkylamine group; an arylalkylamine group; an arylamine group; an arylheteroarylamine group; an alkylheteroarylamine group; and a heteroarylamine group, and is not limited thereto. The number of carbon atoms of the amine group is not particularly limited, but is preferably 1 to 60.

In the present specification, the number of carbon atoms of the aryl group is not particularly limited, but is preferably 6 to 60. According to an exemplary embodiment, the number of carbon atoms of the aryl group is 6 to 30. In an exemplary embodiment of the present specification, the aryl group may be a monocyclic aryl group or a polycyclic aryl group. Specific examples of the monocyclic aryl group include a phenyl group, a biphenyl group, a terphenyl group, and the like, but are not limited thereto. Examples of the polycyclic aryl group include a naphthyl group, an anthracenyl group, a phenanthrenyl group, a pyrenyl group, a perylenyl group, a triphenylenyl group, a chrysenyl group, a fluorenyl group, and the like, but are not limited thereto.

In the present specification, an arylene group means that there are two bonding positions in an aryl group, that is, a divalent group. The above-described description on the aryl group may be applied to the arylene group, except that the arylene groups are each a divalent group.

In the present specification, examples of an arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include a monocyclic aryl group, a polycyclic aryl group, or both a monocyclic aryl group and a polycyclic aryl group. For example, the aryl group in the arylamine group may be selected from the above-described examples of the aryl group. The number of carbon atoms of the arylamine group is not particularly limited, but is preferably 6 to 60.

In the present specification, a heterocyclic group is an aromatic, aliphatic or fused ring group of the aromatic group and the aliphatic group, which includes one or more atoms other than carbon, that is, one or more heteroatoms. Specifically, the heteroatom may include one or more atoms selected from the group consisting of O, N, Se, S, and the like. The number of carbon atoms of the heterocyclic group is not particularly limited, but may be 2 to 60. Examples of the heterocyclic group include a thiophene group, a furan group, a pyrrole group, an imidazole group, a thiazole group, an oxazole group, an oxadiazole group, a pyridine group, a bipyridine group, a pyrimidine group, a triazine group, a triazole group, an acridine group, a pyridazine group, a pyrazine group, a quinoline group, a quinazoline group, a quinoxaline group, a phthalazine group, a pyridopyrimidine group, a pyridopyrazine group, a pyrazinopyrazine group, an isoquinoline group, an indole group, a carbazole group, a benzoxazole group, a benzimidazole group, a benzothiazole group, a benzocarbazole group, a benzothiophene group, a dibenzothiophene group, a benzofuran group, a phenanthridine group, a phenanthroline group, an isoxazole group, a thiadiazole group, a phenothiazine group, a dibenzofuran group, and the like, but are not limited thereto.

In the present specification, a heteroaryl group is an aromatic ring group including one or more heteroatoms. The number of carbon atoms of the heteroaryl group is not particularly limited, but may be 2 to 60. Examples of the heteroaryl group include a pyridine group, a pyrrole group, a pyrimidine group, a pyridazine group, a furan group, a thiophene group, a benzothiophene group, a benzofuran group, a dibenzothiophene group, a dibenzofuran group, a carbazole group, and the like, but are not limited thereto.

In the present specification, the aryloxy group is a group represented by -OR₂₀₀, and R₂₀₀ is an aryl group. The aryl group in the aryloxy group is the same as the above-described examples of the aryl group. Specific examples of the aryloxy group include a phenoxy group, benzyloxy, p-methylbenzyloxy, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group, and the like, but are not limited thereto.

In the present specification, a silyl group is a group represented by -SiR₂₀₁R₂₀₂R₂₀₃, and R₂₀₁, R₂₀₂ and R₂₀₃ are the same as or different from each other, and are each independently hydrogen; deuterium; a substituted or unsubstituted alkyl group; or a substituted or unsubstituted aryl group. Examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

In the present specification, a siloxane group is a group represented by -Si(R₂₀₄)₂OSi(R₂₀₅)₃, and R₂₀₄ and R₂₀₅ are the same as or different from each other, and are each independently hydrogen; deuterium; a substituted or unsubstituted alkyl group; or a substituted or unsubstituted aryl group.

In the present specification, the hydrocarbon ring group may be an aromatic ring, an aliphatic ring or a ring in which an aromatic ring and an aliphatic ring are fused.

In the present specification, the above-described description on the aryl group may be applied to an aromatic ring.

In the present specification, the above-described description on the cycloalkyl group may be applied to an aliphatic ring.

In the present specification, a combination of substituents means a substituent in which two or more substituents of the exemplified substituents are linked. For example, in hydrogen; deuterium; a substituted or unsubstituted alkyl group; a substituted or unsubstituted aryl group; a cross-linkable group; or a combination thereof, the 'combination' means a substituent in which two or more substituents of the exemplified substituents are linked. As an example, the combination may have a structure in which an alkyl group and a cross-linkable group are linked or a structure in which an alkyl group and an aryl group are linked, but is not limited thereto.

In the present specification, a cross-linkable group may mean a reactive substituent which cross-links compounds by being exposed to heat, light, and/or radiation. A cross-linkage may be produced while radicals produced by decomposing carbon-carbon multiple bonds and cyclic structures by means of a heat treatment, light irradiation, and/or radiation irradiation are linked to each other.

In the present specification, the cross-linkable group is any one of the following structures.

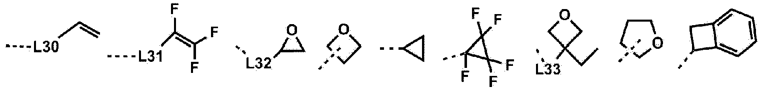

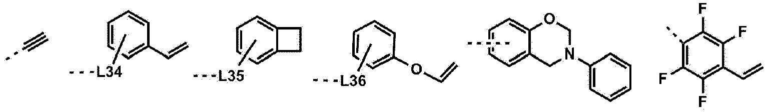

In the structures,
L30 to L36 are the same as or different from each other, and are each independently a direct bond; -O-; -COO-; a substituted or unsubstituted alkylene group; a substituted or unsubstituted arylene group; or a combination thereof, and
------ is a moiety bonded to Chemical Formula 3.
Hereinafter, a first unit and a second unit will be described.

In an exemplary embodiment of the present specification, the first unit and the second unit are units having two attachment points.

In an exemplary embodiment of the present specification, both the first unit and the second unit are represented by Chemical Formula 1, but are different from each other.

In an exemplary embodiment of the present specification, L1 is a direct bond; or a substituted or unsubstituted arylene group having 6 to 30 carbon atoms.

In an exemplary embodiment of the present specification, L1 is a direct bond; a substituted or unsubstituted phenylene group; or a substituted or unsubstituted naphthylene group.

In an exemplary embodiment of the present specification, L2 is a substituted or unsubstituted arylene group having 6 to 30 carbon atoms.

In an exemplary embodiment of the present specification, L2 is a substituted or unsubstituted phenylene group; or a substituted or unsubstituted naphthylene group.

In an exemplary embodiment of the present specification, Chemical Formula 1 is represented by any one of the following Chemical Formulae 1-1 to 1-4.

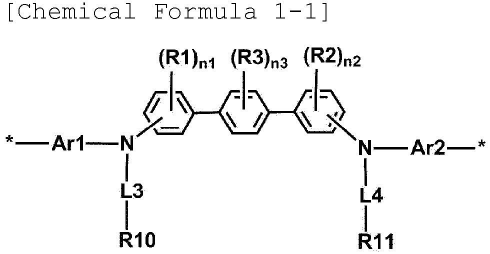

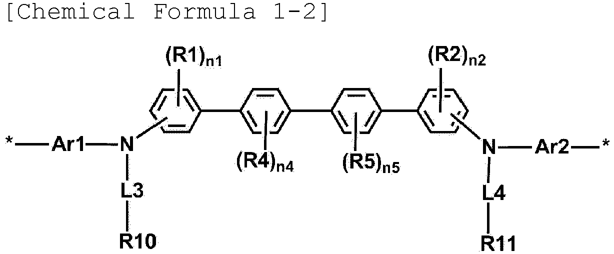

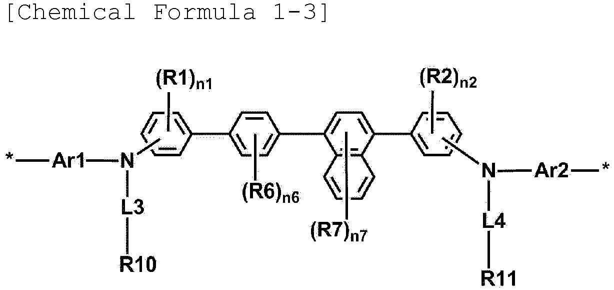

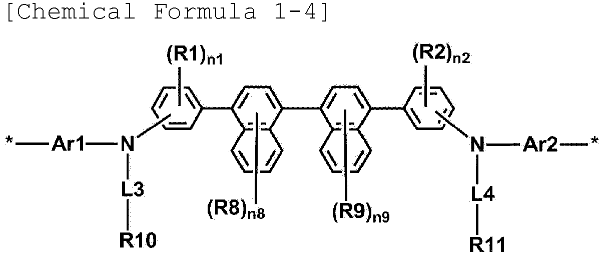

In Chemical Formulae 1-1 to 1-4,
R1, R2, R10, R11, Ar1, Ar2, L3, L4, n1 and n2 are the same as those defined in Chemical Formula 1,
R3 to R9 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n3 to n6 are each an integer from 1 to 4, and when n3 to n6 are each 2 or higher, substituents in the parenthesis are the same as or different from each other,
n7 to n9 are each an integer from 1 to 6, and when n7 to n9 are each 2 or higher, substituents in the parenthesis are the same as or different from each other, and
* is an attachment point in the polymer.

In an exemplary embodiment of the present specification, Chemical Formula 1 is represented by any one of the following Chemical Formulae 1-11 to 1-18.

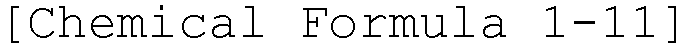

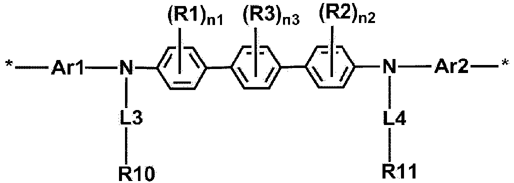

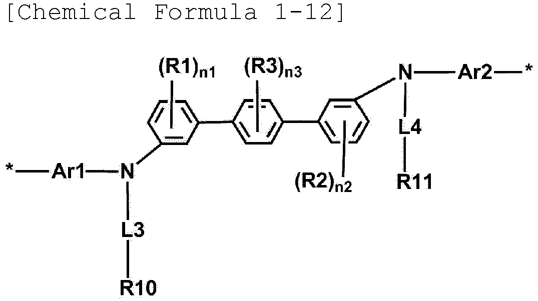

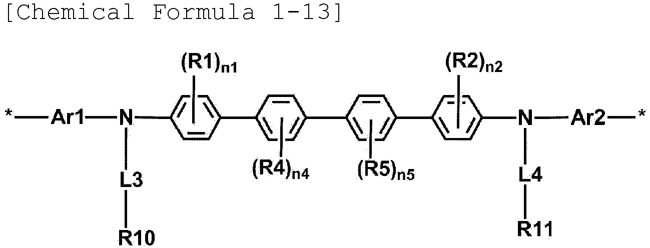

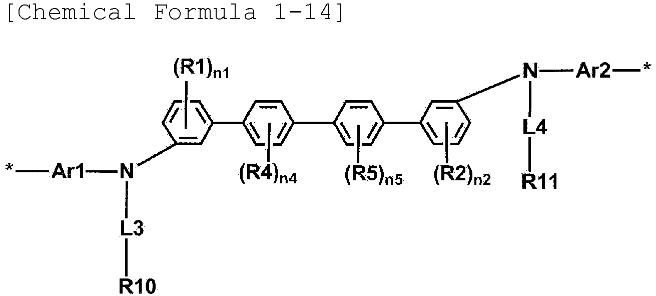

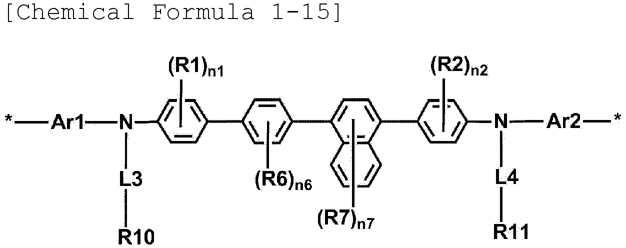

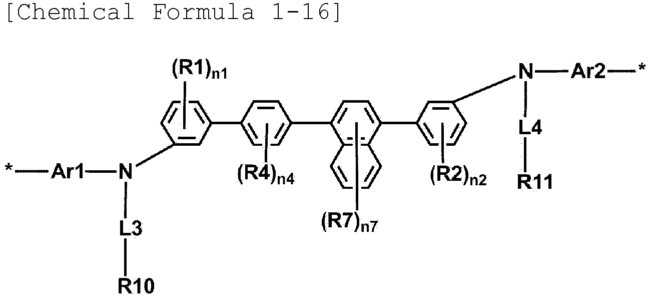

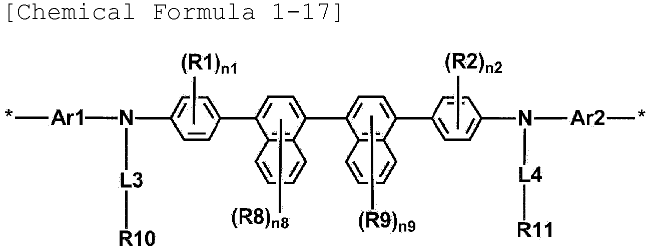

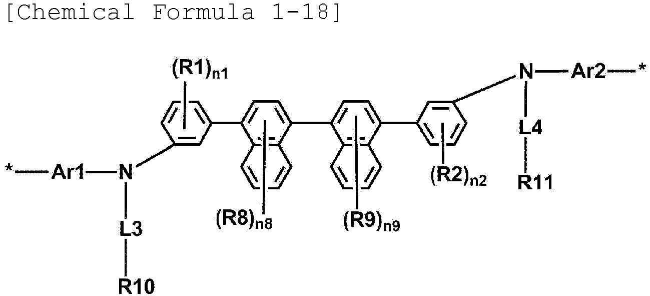

In Chemical Formulae 1-11 to 1-18,
R1, R2, R10, R11, Ar1, Ar2, L3, L4, n1 and n2 are the same as those defined in Chemical Formula 1,
R3 to R9 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n3 to n6 are each an integer from 1 to 4, and when n3 to n6 are each 2 or higher, substituents in the parenthesis are the same as or different from each other,
n7 to n9 are each an integer from 1 to 6, and when n7 to n9 are each 2 or higher, substituents in the parenthesis are the same as or different from each other, and
* is an attachment point in the polymer.

In an exemplary embodiment of the present specification, L3 and L4 are the same as or different from each other, and are each independently a substituted or unsubstituted arylene group.

In an exemplary embodiment of the present specification, L3 and L4 are the same as or different from each other, and are each independently a substituted or unsubstituted arylene group having 6 to 30 carbon atoms.

In an exemplary embodiment of the present specification, L3 and L4 are the same as or different from each other, and are each independently a substituted or unsubstituted phenylene group; a substituted or unsubstituted biphenylene group; or a substituted or unsubstituted naphthylene group.

In an exemplary embodiment of the present specification, Ar1 and Ar2 are the same as or different from each other, and are a substituted or unsubstituted arylene group having 6 to 30 carbon atoms.

In an exemplary embodiment of the present specification, Ar1 and Ar2 are the same as or different from each other, and are each independently a substituted or unsubstituted phenylene group; a substituted or unsubstituted biphenylene group; or a substituted or unsubstituted naphthylene group.

In an exemplary embodiment of the present specification, Chemical Formula 1 is represented by any one of the following Chemical Formulae 1-5 to 1-8.

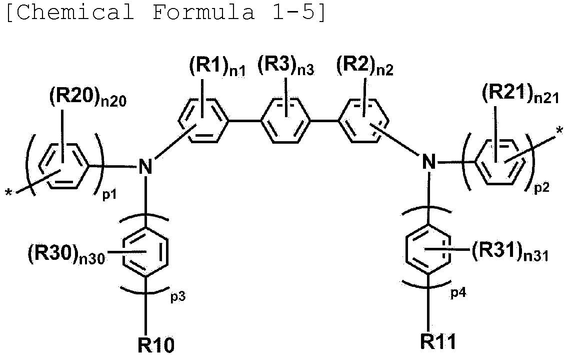

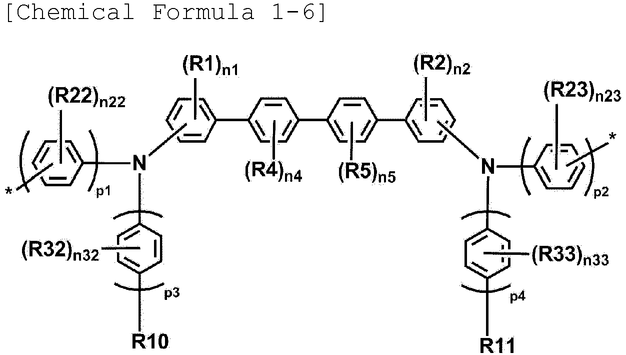

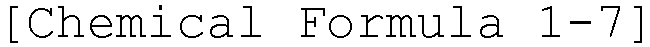

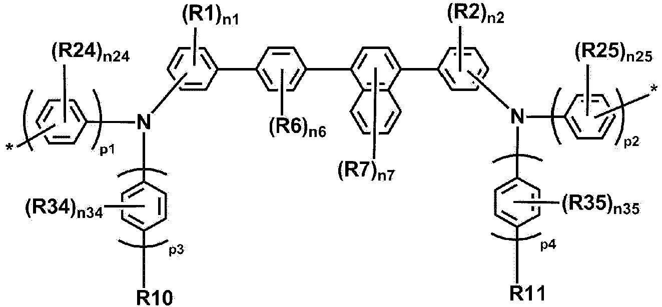

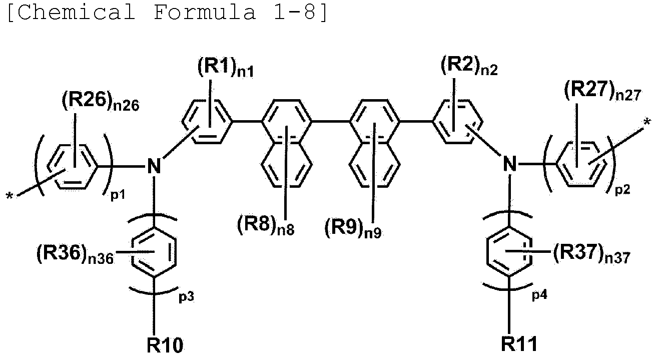

In Chemical Formulae 1-5 to 1-8,
R1, R2, R10, R11, n1 and n2 are the same as those defined in Chemical Formula 1,
R3 to R9, R20 to R27 and R30 to R37 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n3 to n6, n20 to n27 and n30 to n37 are each an integer from 1 to 4, n7 to n9 are each an integer from 1 to 6, and when n3 to n9, n20 to n27 and n30 to n37 are each 2 or higher, substituents in the parenthesis are the same as or different from each other,
p1 to p4 are each an integer from 1 to 3, and when p1 to p4 are each 2 or higher, structures in the parenthesis are the same as or different from each other, and
* is an attachment point in the polymer.

In an exemplary embodiment of the present specification, Chemical Formula 1 is represented by any one of the following Chemical Formulae 1-21 to 1-28.

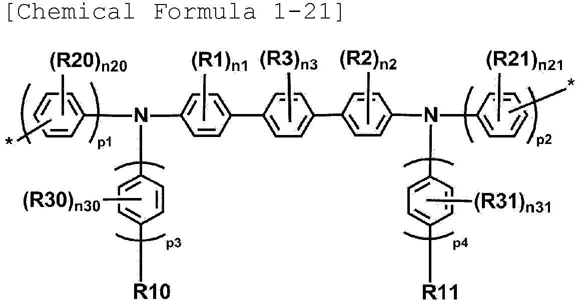

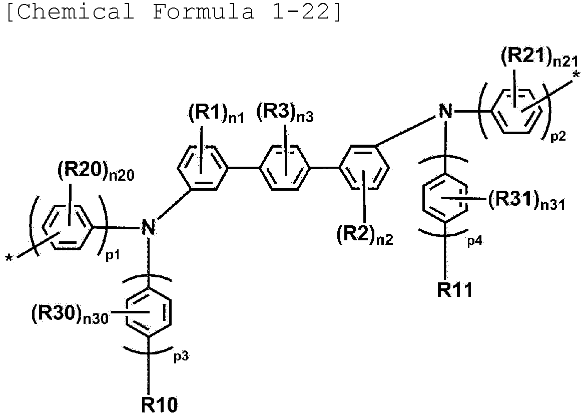

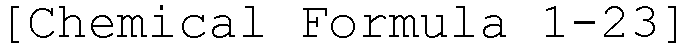

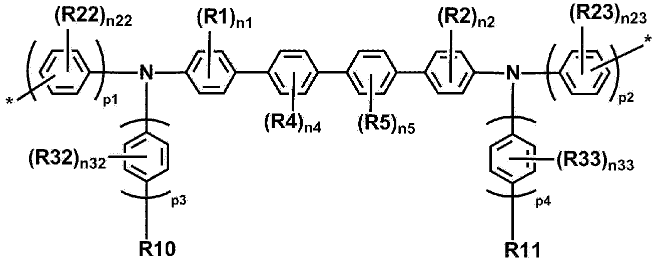

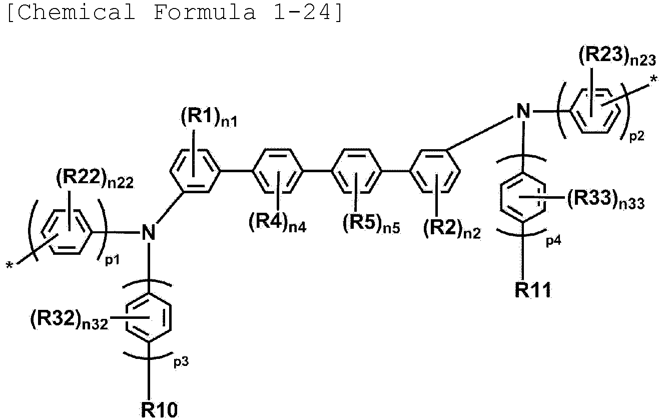

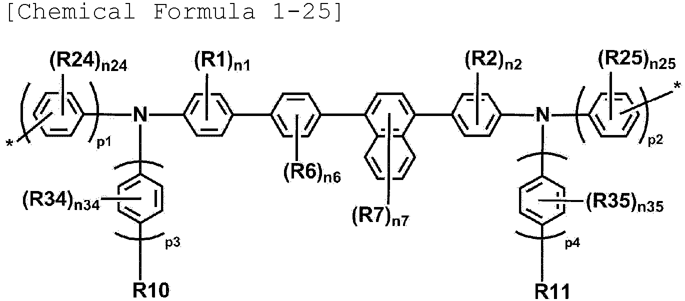

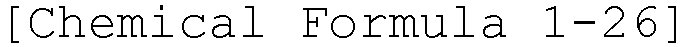

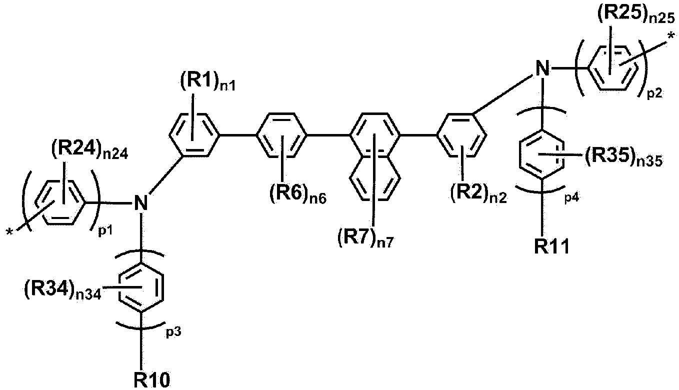

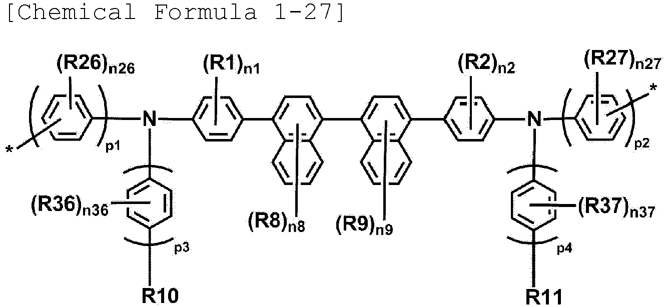

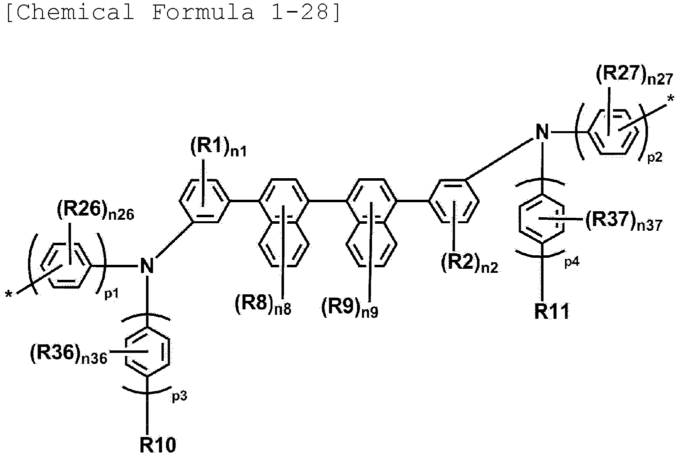

In Chemical Formulae 1-21 to 1-28,
R1, R2, R10, R11, n1 and n2 are the same as those defined in Chemical Formula 1,
R3 to R9, R20 to R27 and R30 to R37 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n3 to n6, n20 to n27 and n30 to n37 are each an integer from 1 to 4, n7 to n9 are each an integer from 1 to 6, and when n3 to n9, n20 to n27 and n30 to n37 are each 2 or higher, substituents in the parenthesis are the same as or different from each other,
p1 to p4 are each an integer from 1 to 3, and when p1 to p4 are each 2 or higher, structures in the parenthesis are the same as or different from each other, and
* is an attachment point in the polymer.

In an exemplary embodiment of the present specification, p1 to p4 are each 1 or 2.

In an exemplary embodiment of the present specification, p1 and p2 are 2.

In an exemplary embodiment of the present specification, p3 and p4 are 1 or 2.

In an exemplary embodiment of the present specification, R10 and R11 are the same as or different from each other, and are each independently a substituted or unsubstituted alkyl group having 1 to 30 carbon atoms; a substituted or unsubstituted arylamine group having 6 to 60 carbon atoms; a substituted or unsubstituted aryl group having 6 to 30 carbon atoms; or a substituted or unsubstituted heterocyclic group having 2 to 30 carbon atoms.

In an exemplary embodiment of the present specification, R10 and R11 are the same as or different from each other, and are each independently a substituted or unsubstituted arylamine group; or a substituted or unsubstituted aryl group.

In an exemplary embodiment of the present specification, R10 and R11 are the same as or different from each other, and are each independently an arylamine group; or an aryl group unsubstituted or substituted with an alkyl group.

In an exemplary embodiment of the present specification, R10 and R11 are the same as or different from each other, and are each independently an arylamine group; a phenyl group unsubstituted or substituted with an alkyl group; a biphenyl group unsubstituted or substituted with an alkyl group; or a naphthyl group unsubstituted or substituted with an alkyl group.

In an exemplary embodiment of the present specification, R10 and R11 are the same as or different from each other, and are each independently an arylamine group; or a phenyl group unsubstituted or substituted with an alkyl group.

In an exemplary embodiment of the present specification, Chemical Formula 1 is the following Chemical Formula 1-A or 1-B.

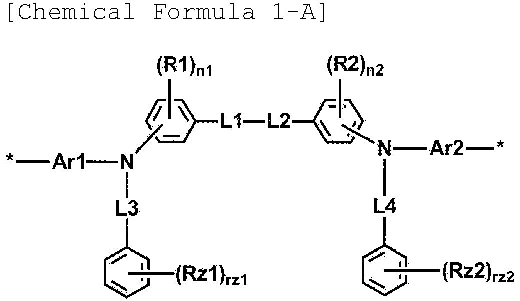

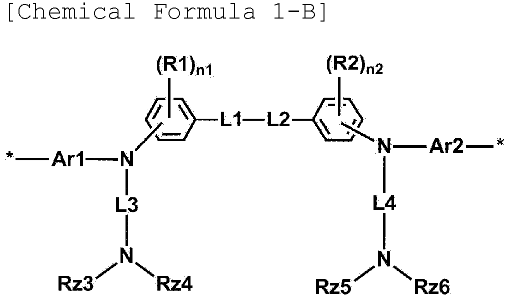

In Chemical Formulae 1-A and 1-B,
L1 to L4, Ar1, Ar2, R1, R2, n1 and n2 are the same as those defined in Chemical Formula 1,
Rz1 and Rz2 are the same as or different from each other, and are each independently hydrogen; deuterium; or a substituted or unsubstituted alkyl group,
Rz3 to Rz6 are the same as or different from each other, and are each independently hydrogen; deuterium; or a substituted or unsubstituted aryl group,
rz1 and rz2 are an integer from 1 to 5, and when rz1 and rz2 are each 2 or higher, substituents in the parenthesis are the same as or different from each other, and
* is an attachment point in the polymer.

In an exemplary embodiment of the present specification, at least one of Rz3 and Rz4 and at least one of Rz5 and Rz6 are a substituted or unsubstituted aryl group.

In an exemplary embodiment of the present specification, Rz3 to Rz6 are the same as or different from each other, and are each independently a substituted or unsubstituted aryl group.

In an exemplary embodiment of the present specification, Chemical Formula 1 is the following Chemical Formula 1-A-1 or 1-B-1.

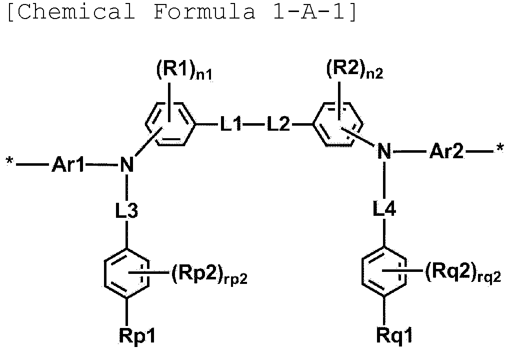

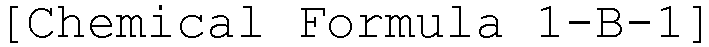

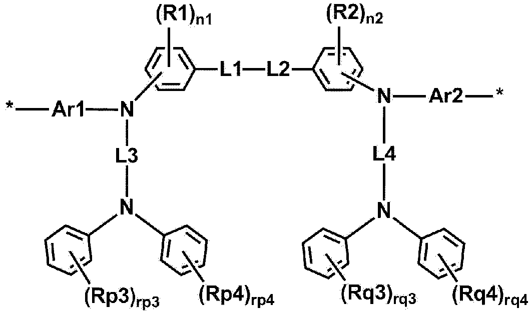

In Chemical Formulae 1-A-1 and 1-B-1,
L1 to L4, R1, R2, Ar1, Ar2, n1 and n2 are the same as those defined in Chemical Formula 1,
Rp1 and Rq1 are the same as or different from each other, and are each independently a substituted or unsubstituted alkyl group,
Rp2 to Rp4 and Rq2 to Rq4 are the same as or different from each other, and are each independently hydrogen; deuterium; or a substituted or unsubstituted alkyl group,
rp2 and rq2 are each an integer from 1 to 4, rp3, rp4, rq3 and rq4 are each an integer from 1 to 5, and when rp2, rp3, rp4, rq2, rq3 and rq4 are each 2 or higher, substituents in the parenthesis are the same as or different from each other, and
* is an attachment point in the polymer.

In an exemplary embodiment of the present specification, at least one of the first unit and the second unit is Chemical Formula 1-A-1.

In an exemplary embodiment of the present specification, Chemical Formula 1 is the following Chemical Formula 1-A1.

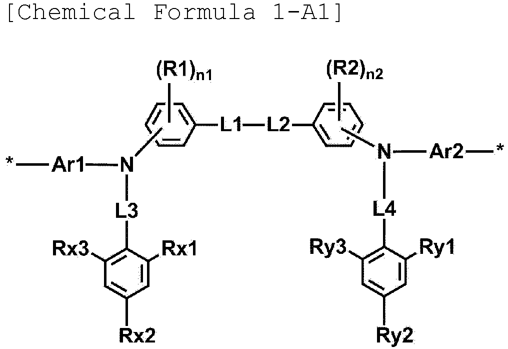

In Chemical Formula 1-A1,
L1 to L4, R1, R2, Ar1, Ar2, n1 and n2 are the same as those defined in Chemical Formula 1,
Rx1 to Rx3 and Ry1 to Ry3 are the same as or different from each other, and are each independently hydrogen; deuterium; or a substituted or unsubstituted alkyl group,
at least one of Rx1 to Rx3 and at least one of Ry1 to Ry3 are a substituted or unsubstituted alkyl group, and
* is an attachment point in the polymer.

In an exemplary embodiment of the present specification, at least one of the first unit and the second unit is Chemical Formula 1-A1.

In an exemplary embodiment of the present specification, Rx1 to Rx3 and Ry1 to Ry3 are the same as or different from each other, and are each independently hydrogen; deuterium; or a substituted or unsubstituted alkyl group having 1 to 30 carbon atoms, and at least one of Rx1 to Rx3 and at least one of Ry1 to Ry3 are a substituted or unsubstituted alkyl group having 1 to 30 carbon atoms.

In an exemplary embodiment of the present specification, Rx1 to Rx3 and Ry1 to Ry3 are the same as or different from each other, and are each independently hydrogen; deuterium; or a substituted or unsubstituted alkyl group having 1 to 10 carbon atoms, and at least one of Rx1 to Rx3 and at least one of Ry1 to Ry3 are a substituted or unsubstituted alkyl group having 1 to 10 carbon atoms.

In an exemplary embodiment of the present specification, Rx1 to Rx3 and Ry1 to Ry3 are the same as or different from each other, and are each independently hydrogen; deuterium; a straight-chained alkyl group having 1 to 10 carbon atoms; or a branched alkyl group having 4 to 10 carbon atoms, and at least one of Rx1 to Rx3 and at least one of Ry1 to Ry3 are a straight-chained alkyl group having 1 to 10 carbon atoms; or a branched alkyl group having 4 to 10 carbon atoms.

In an exemplary embodiment of the present specification, Rx1 to Rx3 and Ry1 to Ry3 are the same as or different from each other, and are each independently hydrogen; deuterium; a methyl group; an ethyl group; a propyl group; an n-butyl group; a sec-butyl group; an isobutyl group; or a tert-butyl group, and at least one of Rx1 to Rx3 and at least one of Ry1 to Ry3 are a methyl group; an ethyl group; a propyl group; an n-butyl group; a sec-butyl group; an isobutyl group; or a tert-butyl group.

In an exemplary embodiment of the present specification, at least one of Rx1 to Rx3 and at least one of Ry1 to Ry3 are a methyl group; a sec-butyl group; an isobutyl group; or a tert-butyl group.

In an exemplary embodiment of the present specification, at least one of Rx1 to Rx3 and at least one of Ry1 to Ry3 are a sec-butyl group; an isobutyl group; or a tert-butyl group.

In an exemplary embodiment of the present specification, Rx2 and Ry2 are the same as or different from each other, and are each independently a substituted or unsubstituted alkyl group having 1 to 30 carbon atoms.

In an exemplary embodiment of the present specification, Rx2 and Ry2 are the same as or different from each other, and are each independently a substituted or unsubstituted alkyl group having 1 to 10 carbon atoms.

In an exemplary embodiment of the present specification, Rx2 and Ry2 are the same as or different from each other, and are each independently a substituted or unsubstituted straight-chained alkyl group having 1 to 30 carbon atoms or a substituted or unsubstituted branched alkyl group having 4 to 30 carbon atoms.

In an exemplary embodiment of the present specification, Rx2 and Ry2 are the same as or different from each other, and are each independently a substituted or unsubstituted straight-chained alkyl group having 1 to 10 carbon atoms or a substituted or unsubstituted branched alkyl group having 4 to 10 carbon atoms.

In an exemplary embodiment of the present specification, Rx2 and Ry2 are the same as or different from each other, and are each independently a straight-chained alkyl group having 1 to 10 carbon atoms or a branched alkyl group having 4 to 10 carbon atoms.

In an exemplary embodiment of the present specification, Rx2 and Ry2 are the same as or different from each other, and are each independently a substituted or unsubstituted branched alkyl group having 4 to 30 carbon atoms.

In an exemplary embodiment of the present specification, Rx2 and Ry2 are the same as or different from each other, and are each independently hydrogen; deuterium; a methyl group; an ethyl group; a propyl group; an n-butyl group; a sec-butyl group; an isobutyl group; or a tert-butyl group.

In an exemplary embodiment of the present specification, Rx2 and Ry2 are the same as or different from each other, and are each independently a methyl group; an ethyl group; a propyl group; an n-butyl group; a sec-butyl group; an isobutyl group; or a tert-butyl group.

In an exemplary embodiment of the present specification, Rx2 and Ry2 are the same as or different from each other, and are each independently a methyl group; a sec-butyl group; an isobutyl group; or a tert-butyl group.

In an exemplary embodiment of the present specification, Rx2 and Ry2 are the same as or different from each other, and are each independently a sec-butyl group; an isobutyl group; or a tert-butyl group.

In an exemplary embodiment of the present specification, L1 of Chemical Formula 1-A1 is a direct bond, and L2 is a substituted or unsubstituted phenylene group.

In an exemplary embodiment of the present specification, Chemical Formula 1-A is any one of the following Chemical Formulae 1-A2 to 1-A4.

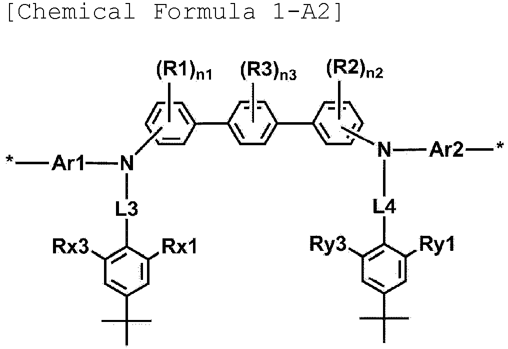

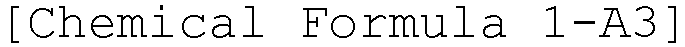

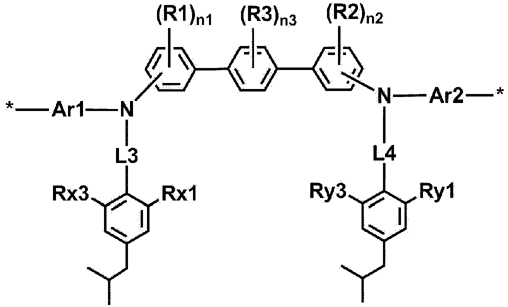

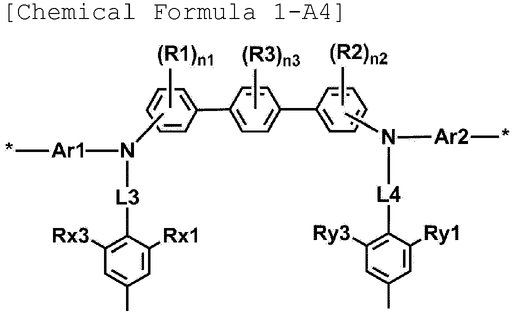

In Chemical Formulae 1-A2 to 1-A4,
L3, L4, Ar1 and Ar2 are the same as those defined in Chemical Formula 1,
R1 to R3, Rx1, Rx3, Ry1 and Ry3 are the same as or different from each other, and are each independently hydrogen; deuterium; or a substituted or unsubstituted alkyl group,
n1 to n3 are each an integer from 1 to 4, and when n1 to n3 are each 2 or higher, substituents in the parenthesis are the same as or different from each other, and
* is an attachment point in the polymer.

In an exemplary embodiment of the present specification, at least one of the first unit and the second unit is Chemical Formula 1-A2, 1-A3 or 1-A4.

In an exemplary embodiment of the present specification, Chemical Formula 1 is any one of the following Chemical Formulae 1-A-11 to 1-A-14 and 1-B-11 to 1-B-14.

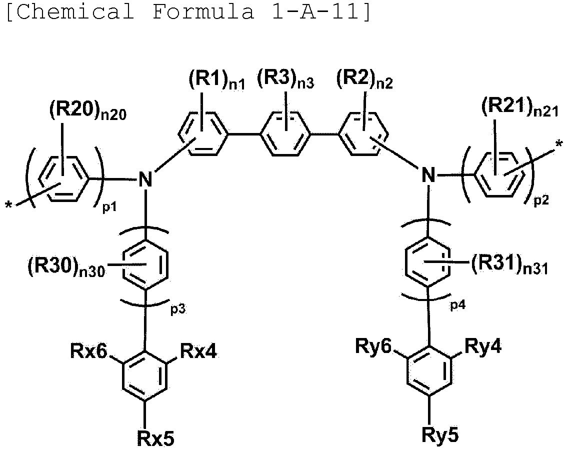

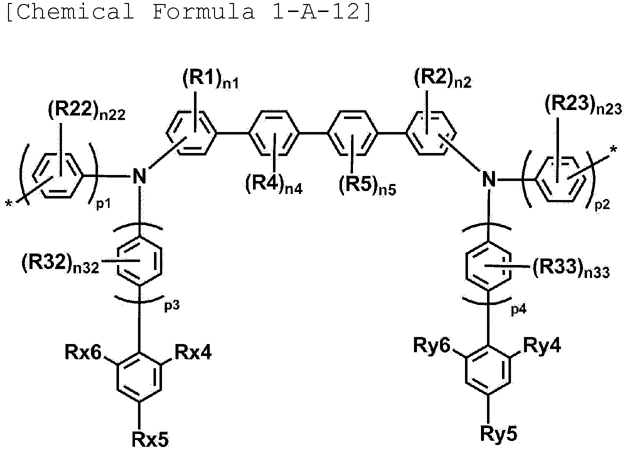

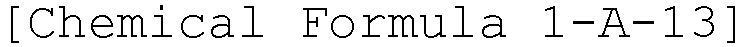

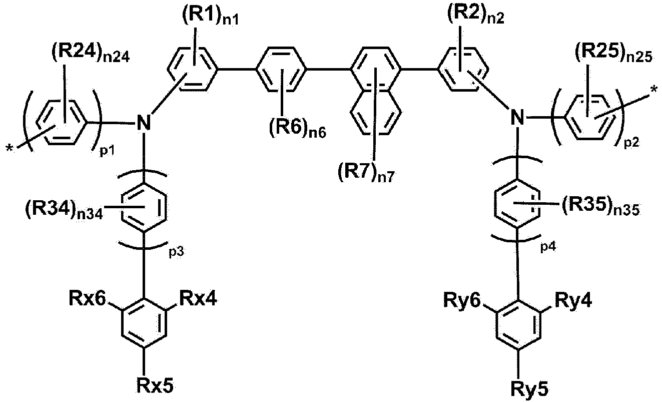

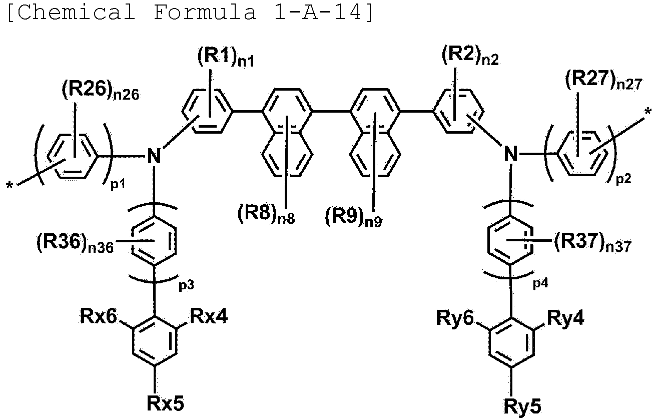

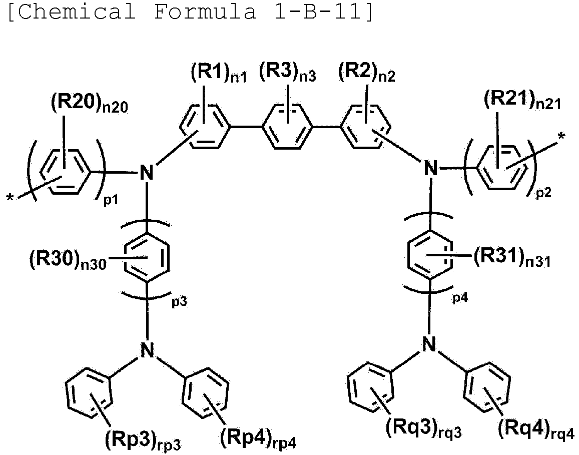

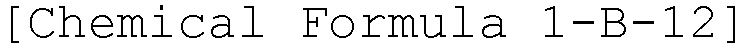

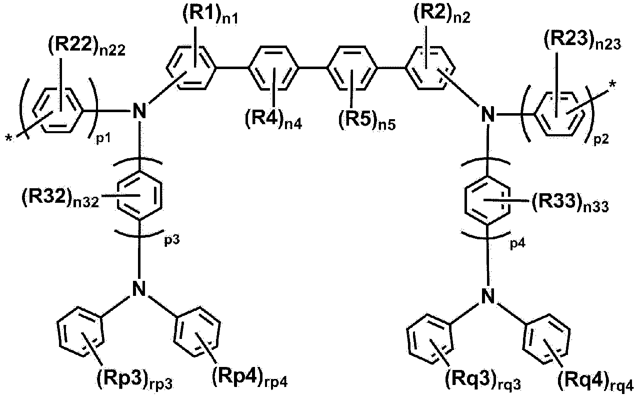

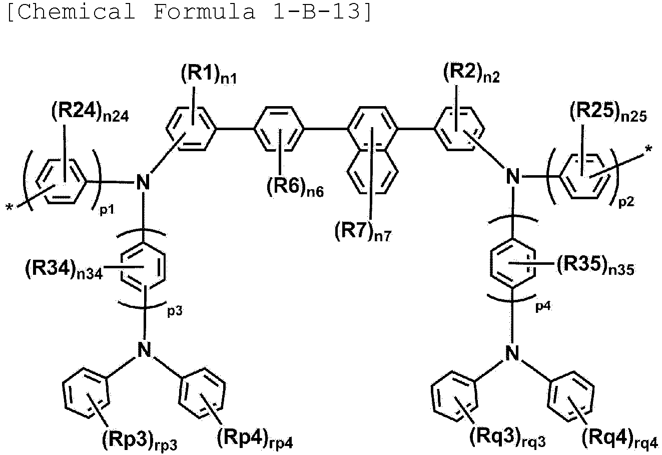

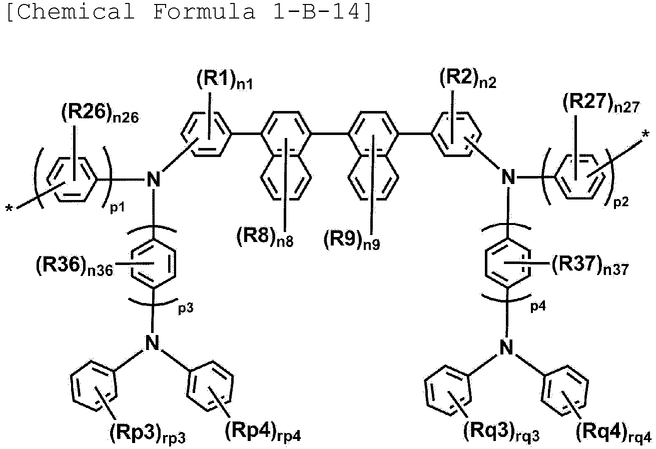

In Chemical Formulae 1-A-11 to 1-A-14 and 1-B-11 to 1-B-14,
R1, R2, n1 and n2 are the same as those defined in Chemical Formula 1,
R3 to R9, R20 to R27 and R30 to R37 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
Rx4 to Rx6, Ry4 to Ry6, Rp3, Rp4, Rq3 and Rq4 are the same as or different from each other, and are each independently hydrogen; deuterium; or a substituted or unsubstituted alkyl group,
n3 to n6, n20 to n27 and n30 to n37 are each an integer from 1 to 4, n7 to n9 are each an integer from 1 to 6, and when n3 to n9, n20 to n27 and n30 to n37 are each 2 or higher, substituents in the parenthesis are the same as or different from each other,
p1 to p4 are each an integer from 1 to 3, and when p1 to p4 are each 2 or higher, structures in the parenthesis are the same as or different from each other,
rp3, rp4, rq3 and rq4 are each an integer from 1 to 5, and when rp3, rp4, rq3 and rq4 are each 2 or higher, substituents in the parenthesis are the same as or different from each other, and
* is an attachment point in the polymer.

In an exemplary embodiment of the present specification, the first unit and the second unit are different from each other, and are each any one of Chemical Formulae 1-A-11 to 1-A-14 and 1-B-11 to 1-B-14.

In an exemplary embodiment of the present specification, at least one of the first unit and the second unit is Chemical Formula 1-A-11.

In an exemplary embodiment of the present specification, R20 to R27 are the same as or different from each other, and are each independently hydrogen; deuterium; a halogen group; or a substituted or unsubstituted alkyl group.

In an exemplary embodiment of the present specification, R20 to R27 are the same as or different from each other, and are each independently hydrogen; deuterium; or a substituted or unsubstituted alkyl group having 1 to 10 carbon atoms.

In an exemplary embodiment of the present specification, R20 to R27 are the same as or different from each other, and are each independently hydrogen or deuterium.

In an exemplary embodiment of the present specification, R30 to R37 are the same as or different from each other, and are each independently hydrogen; deuterium; a halogen group; or a substituted or unsubstituted alkyl group.

In an exemplary embodiment of the present specification, R30 to R37 are the same as or different from each other, and are each independently hydrogen; deuterium; or a substituted or unsubstituted alkyl group having 1 to 10 carbon atoms.

In an exemplary embodiment of the present specification, R30 to R37 are the same as or different from each other, and are each independently hydrogen or deuterium.

In an exemplary embodiment of the present specification, Rx4 to Rx6 and Ry4 to Ry6 are the same as or different from each other, and are each independently hydrogen; deuterium; or a substituted or unsubstituted alkyl group having 1 to 30 carbon atoms.

In an exemplary embodiment of the present specification, Rx4 to Rx6 and Ry4 to Ry6 are the same as or different from each other, and are each independently hydrogen; deuterium; a substituted or unsubstituted straight-chained alkyl group having 1 to 30 carbon atoms; or a substituted or unsubstituted branched alkyl group having 4 to 30 carbon atoms.

In an exemplary embodiment of the present specification, at least one of Rx4 to Rx6 and at least one of Ry4 to Ry6 are a substituted or unsubstituted alkyl group having 1 to 30 carbon atoms.

In an exemplary embodiment of the present specification, Rx4 to Rx6 and Ry4 to Ry6 are the same as or different from each other, and are each independently hydrogen; deuterium; a straight-chained alkyl group having 1 to 30 carbon atoms; or a branched alkyl group having 4 to 30 carbon atoms.

In an exemplary embodiment of the present specification, Rx4 to Rx6 and Ry4 to Ry6 are the same as or different from each other, and are each independently hydrogen; deuterium; a straight-chained alkyl group having 1 to 10 carbon atoms; or a branched alkyl group having 4 to 10 carbon atoms.

In an exemplary embodiment of the present specification, at least one of Rx4 to Rx6 and at least one of Ry4 to Ry6 are a straight-chained alkyl group having 1 to 10 carbon atoms; or a branched alkyl group having 4 to 10 carbon atoms.

In an exemplary embodiment of the present specification, at least one of Rx4 to Rx6 and at least one of Ry4 to Ry6 are a branched alkyl group having 4 to 10 carbon atoms.

In an exemplary embodiment of the present specification, any one of Rx4 to Rx6 and any one of Ry4 to Ry6 are a straight-chained alkyl group having 1 to 30 carbon atoms; or a branched alkyl group having 4 to 30 carbon atoms.

In an exemplary embodiment of the present specification, any one of Rx4 to Rx6 and any one of Ry4 to Ry6 are a branched alkyl group having 4 to 30 carbon atoms.

In an exemplary embodiment of the present specification, Rx4 to Rx6 and Ry4 to Ry6 are the same as or different from each other, and are each independently hydrogen; deuterium; a methyl group; an ethyl group; a propyl group; an n-butyl group; a sec-butyl group; an isobutyl group; or a tert-butyl group.

In an exemplary embodiment of the present specification, at least one of Rx4 to Rx6 and at least one of Ry4 to Ry6 are a methyl group; a sec-butyl group; an isobutyl group; or a tert-butyl group.

In an exemplary embodiment of the present specification, at least one of Rx4 to Rx6 and at least one of Ry4 to Ry6 are a sec-butyl group; an isobutyl group; or a tert-butyl group.

In an exemplary embodiment of the present specification, Rx5 and Ry5 are the same as or different from each other, and are each independently an alkyl group having 1 to 30 carbon atoms.

In an exemplary embodiment of the present specification, Rx5 and Ry5 are the same as or different from each other, and are each independently a branched alkyl group having 4 to 30 carbon atoms.

In an exemplary embodiment of the present specification, Rx5 and Ry5 are the same as or different from each other, and are each independently a methyl group; a sec-butyl group; an isobutyl group; or a tert-butyl group.

In an exemplary embodiment of the present specification, Rx5 and Ry5 are the same as or different from each other, and are each independently a sec-butyl group; an isobutyl group; or a tert-butyl group.

In an exemplary embodiment of the present specification, Rp3, Rp4, Rq3 and Rq4 are the same as or different from each other, and are each independently hydrogen; deuterium; a halogen group; or a substituted or unsubstituted alkyl group.

In an exemplary embodiment of the present specification, Rp3, Rp4, Rq3 and Rq4 are the same as or different from each other, and are each independently hydrogen or deuterium.

In an exemplary embodiment of the present specification, at least one of R1 to R3 is a substituted or unsubstituted alkyl group.

In an exemplary embodiment of the present specification, one of R1 to R3 is a substituted or unsubstituted alkyl group.

In an exemplary embodiment of the present specification, two of R1 to R3 are a substituted or unsubstituted alkyl group.

In an exemplary embodiment of the present specification, all of R1 to R3 are a substituted or unsubstituted alkyl group.

In an exemplary embodiment of the present specification, at least one of R1, R2, R4 and R5 is a substituted or unsubstituted alkyl group.

In an exemplary embodiment of the present specification, one of R1, R2, R4 and R5 is a substituted or unsubstituted alkyl group.

In an exemplary embodiment of the present specification, two of R1, R2, R4 and R5 are a substituted or unsubstituted alkyl group.

In an exemplary embodiment of the present specification, all of R1, R2, R4 and R5 are a substituted or unsubstituted alkyl group.

In an exemplary embodiment of the present specification, at least one of R1, R2, R6 and R7 is a substituted or unsubstituted alkyl group.

In an exemplary embodiment of the present specification, one of R1, R2, R6 and R7 is a substituted or unsubstituted alkyl group.

In an exemplary embodiment of the present specification, two of R1, R2, R6 and R7 are a substituted or unsubstituted alkyl group.

In an exemplary embodiment of the present specification, all of R1, R2, R6 and R7 are a substituted or unsubstituted alkyl group.

In an exemplary embodiment of the present specification, at least one of R1, R2, R8 and R9 is a substituted or unsubstituted alkyl group.

In an exemplary embodiment of the present specification, one of R1, R2, R8 and R9 is a substituted or unsubstituted alkyl group.

In an exemplary embodiment of the present specification, two of R1, R2, R8 and R9 are a substituted or unsubstituted alkyl group.

In an exemplary embodiment of the present specification, all of R1, R2, R8 and R9 are a substituted or unsubstituted alkyl group.

In an exemplary embodiment of the present specification, R1 to R9 are the same as or different from each other, and are each independently hydrogen; deuterium; or a substituted or unsubstituted alkyl group having 1 to 10 carbon atoms.

In an exemplary embodiment of the present specification, at least one of R1, R2, R8 and R9 is an alkyl group.

In an exemplary embodiment of the present specification, at least one of R1, R2, R8 and R9 is an alkyl group having 1 to 10 carbon atoms.

In an exemplary embodiment of the present specification, R1 to R9 are the same as or different from each other, and are each independently hydrogen; deuterium; or a substituted or unsubstituted alkyl group having 1 to 10 carbon atoms, and at least one of R1 to R9 is an alkyl group having 1 to 10 carbon atoms.

In an exemplary embodiment of the present specification, Chemical Formula 1 is the following Chemical Formula 1-31 or the following Chemical Formula 1-32.

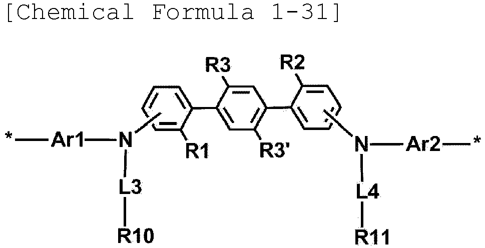

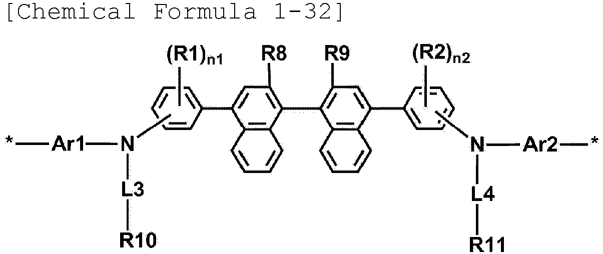

In Chemical Formulae 1-31 and 1-32,
R1, R2, R10, R11, Ar1, Ar2, L3, L4, n1 and n2 are the same as those defined in Chemical Formula 1,
R3, R3', R8 and R9 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group, and
* is an attachment point in the polymer.

In an exemplary embodiment of the present specification, Chemical Formula 1 is Chemical Formula 1-31 or the following Chemical Formula 1-33.

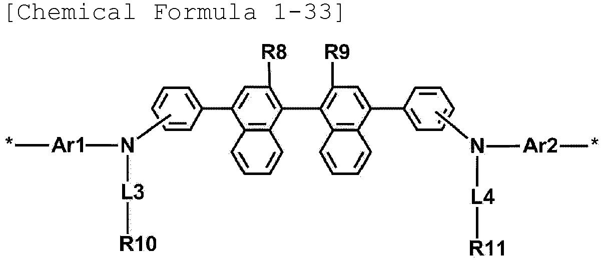

In Chemical Formula 1-33,
R10, R11, Ar1, Ar2, L3 and L4 are the same as those defined in Chemical Formula 1,
R8 and R9 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group, and
* is an attachment point in the polymer.

In an exemplary embodiment of the present specification, Chemical Formula 1 is the following Chemical Formula 1-34 or the following Chemical Formula 1-35.

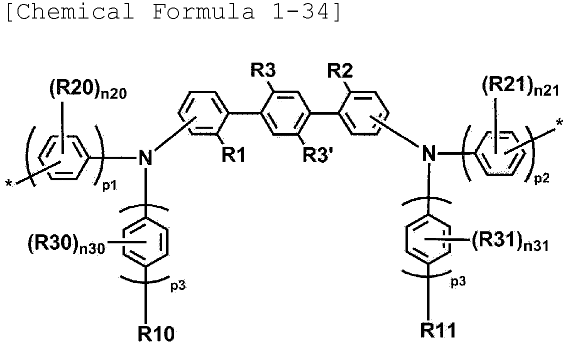

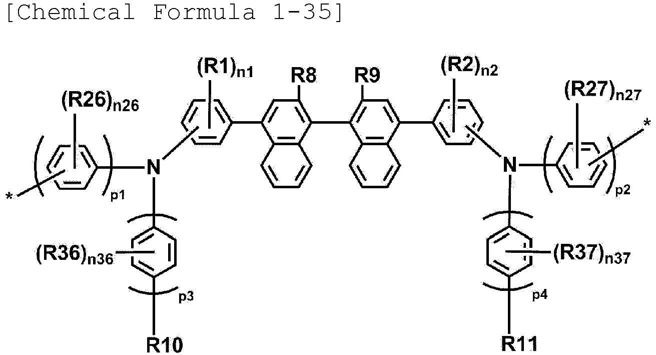

In Chemical Formulae 1-34 and 1-35,
R1, R2, R10, R11, n1 and n2 are the same as those defined in Chemical Formula 1,
R3, R3', R8, R9, R20, R21, R26, R27, R30, R31, R36 and R37 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n20, n21, n26, n27, n30, n31, n36 and n37 are each an integer from 1 to 4, and when n20, n21, n26, n27, n30, n31, n36 and n37 are each 2 or higher, substituents in the parenthesis are the same as or different from each other,
p1 to p4 are each an integer from 1 to 3, and when p1 to p4 are each 2 or higher, structures in the parenthesis are the same as or different from each other, and
* is an attachment point in the polymer.

In an exemplary embodiment of the present specification, Chemical Formula 1 is Chemical Formula 1-34 or the following Chemical Formula 1-36.

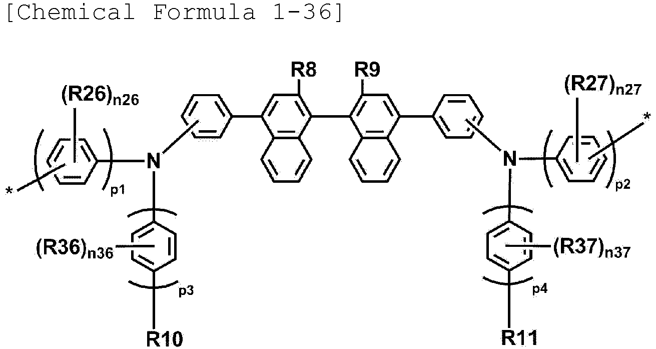

In Chemical Formula 1-36,
R10 and R11 are the same as those defined in Chemical Formula 1,
R8, R9, R26, R27, R36 and R37 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n26, n27, n36 and n37 are each an integer from 1 to 4, and when n26, n27, n36 and n37 are each 2 or higher, substituents in the parenthesis are the same as or different from each other,
p1 to p4 are each an integer from 1 to 3, and when p1 to p4 are each 2 or higher, structures in the parenthesis are the same as or different from each other, and
* is an attachment point in the polymer.

In an exemplary embodiment of the present specification, R1, R2, R3, R3', R8 and R9 are the same as or different from each other, and are each independently a substituted or unsubstituted alkyl group.

In an exemplary embodiment of the present specification, R1, R2, R3, R3', R8 and R9 are the same as or different from each other, and are each independently a substituted or unsubstituted alkyl group having 1 to 30 carbon atoms.

In an exemplary embodiment of the present specification, R1, R2, R3, R3', R8 and R9 are the same as or different from each other, and are each independently a substituted or unsubstituted alkyl group having 1 to 10 carbon atoms.

In an exemplary embodiment of the present specification, R1, R2, R3, R3', R8 and R9 are the same as or different from each other, and are each independently a straight-chained alkyl group having 1 to 30 carbon atoms.

In an exemplary embodiment of the present specification, R1, R2, R3, R3', R8 and R9 are the same as or different from each other, and are each independently a substituted or unsubstituted straight-chained alkyl group having 1 to 10 carbon atoms.

In an exemplary embodiment of the present specification, R1, R2, R3, R3', R8 and R9 are the same as or different from each other, and are each independently a methyl group; a hexyl group; or an octyl group.

In an exemplary embodiment of the present specification, R1 and R2 are each a methyl group.

In an exemplary embodiment of the present specification, R3 and R3' are each a hexyl group or an octyl group.

In an exemplary embodiment of the present specification, R8 and R9 are each a hexyl group or an octyl group.

In an exemplary embodiment of the present specification, the first unit and the second unit are different from each other, and are each any one of the following structures.

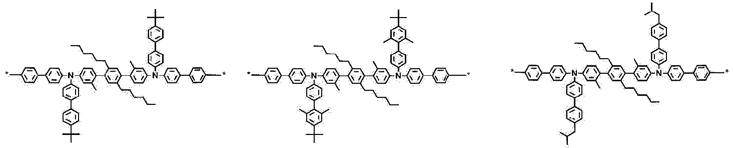

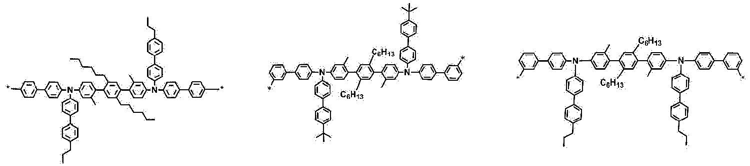

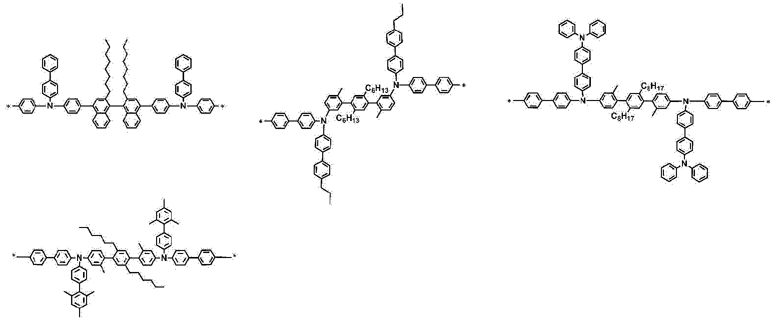

In the structure, * is an attachment point in the polymer.

In an exemplary embodiment of the present specification, hydrogen can be replaced with deuterium. For example, hydrogen included in the structure can be replaced with deuterium.

Hereinafter, a third unit will be described.

In an exemplary embodiment of the present specification, the third unit is a unit having 3 or 4 attachment points.

In an exemplary embodiment of the present specification, Y is a direct bond; or a substituted or unsubstituted arylene group.

In an exemplary embodiment of the present specification, Y is a direct bond; or a substituted or unsubstituted phenylene group.

In an exemplary embodiment of the present specification, Chemical Formula 2 is any one of the following Chemical Formulae 2-1 to 2-4.

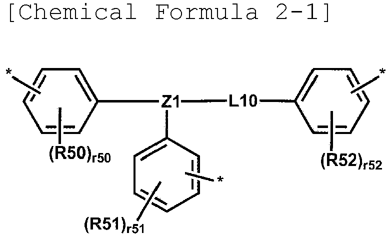

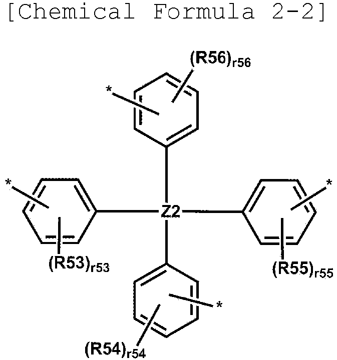

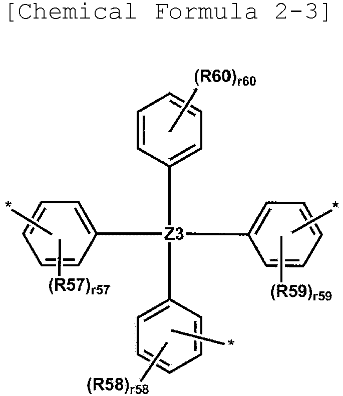

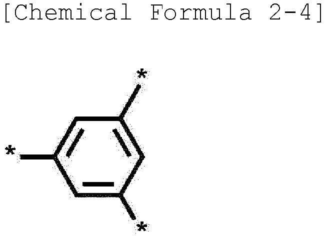

In Chemical Formulae 2-1 to 2-4,
Z1 is CRa; SiRa; N; or a substituted or unsubstituted trivalent aryl group,
Z2 and Z3 are the same as or different from each other, and are each independently C; Si; or a substituted or unsubstituted tetravalent aryl group,
L10 is a direct bond; or a substituted or unsubstituted arylene group,
Ra is hydrogen; deuterium; a substituted or unsubstituted alkyl group; or a substituted or unsubstituted aryl group,
R50 to R60 are the same as or different from each other, and are each independently hydrogen; deuterium; a halogen group; a cyano group; an alkoxy group; an aryloxy group; a siloxane group; a substituted or unsubstituted amine group; a substituted or unsubstituted alkyl group; a substituted or unsubstituted aryl group; a substituted or unsubstituted heterocyclic group; or a cross-linkable group, and adjacent groups may be bonded to each other to form a ring,
r50 to r59 are each an integer from 1 to 4, r60 is an integer from 1 to 5, and when r50 to r60 are each 2 or higher, substituents in the parenthesis are the same as or different from each other, and
* is an attachment point in the polymer.

In an exemplary embodiment of the present specification, Chemical Formula 2 is Chemical Formula 2-1.

In an exemplary embodiment of the present specification, Z1 is CRa or SiRa, and when Ra is a substituted or unsubstituted aryl group, L10 is a substituted or unsubstituted arylene group.

In an exemplary embodiment of the present specification, Z1 is CH; SiH; N; or a substituted or unsubstituted trivalent aryl group.

In an exemplary embodiment of the present specification, Z1 is CH; SiH; N; or a substituted or unsubstituted trivalent phenyl group.

In an exemplary embodiment of the present specification, Z1 is N; or a trivalent phenyl group.

In an exemplary embodiment of the present specification, L10 is a direct bond; or a substituted or unsubstituted arylene group having 6 to 30 carbon atoms.

In an exemplary embodiment of the present specification, L10 is a direct bond; or an arylene group having 6 to 30 carbon atoms.

In an exemplary embodiment of the present specification, L10 is a direct bond; or a phenylene group.

In an exemplary embodiment of the present specification, L10 is a direct bond.

In an exemplary embodiment of the present specification, Chemical Formula 2 is Chemical Formula 2-2.

In an exemplary embodiment of the present specification, Z2 is C; or Si.

In an exemplary embodiment of the present specification, Chemical Formula 2 is Chemical Formula 2-3.

In an exemplary embodiment of the present specification, Z3 is C; or Si.

In an exemplary embodiment of the present specification, Chemical Formula 2 is Chemical Formula 2-4.

In an exemplary embodiment of the present specification, Chemical Formula 2 is any one of the following structures.

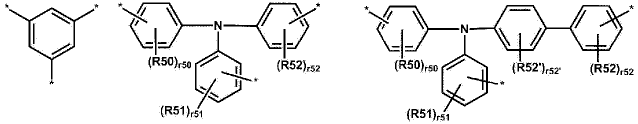

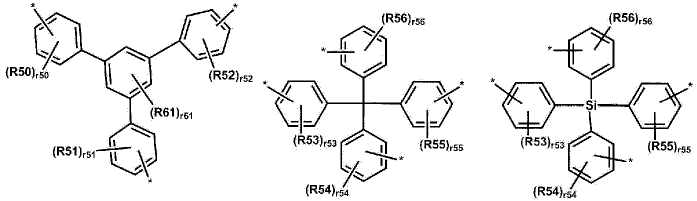

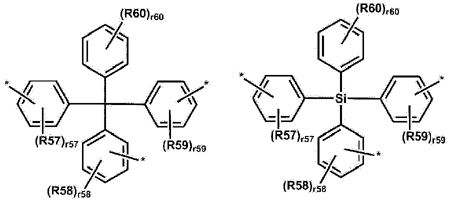

In the structures,
R50 to R60, R52' and R61 are the same as or different from each other, and are each independently hydrogen; deuterium; a halogen group; a cyano group; an alkoxy group; an aryloxy group; a fluoroalkoxy group; a siloxane group; a substituted or unsubstituted amine group; a substituted or unsubstituted alkyl group; a substituted or unsubstituted aryl group; a substituted or unsubstituted heterocyclic group; or a cross-linkable group, and adjacent groups may be bonded to each other to form a ring,
r50 to r59 and r52' are each an integer from 1 to 4, r60 is an integer from 1 to 5, r61 is an integer from 1 to 3, and when r50 to r61 and r52' are each 2 or higher, substituents in the parenthesis are the same as or different from each other, and
* is an attachment point in the polymer.

In an exemplary embodiment of the present specification, R50 to R61 and R52' are each hydrogen; or deuterium.

Specifically, Chemical Formula 2 is any one of the following structures.

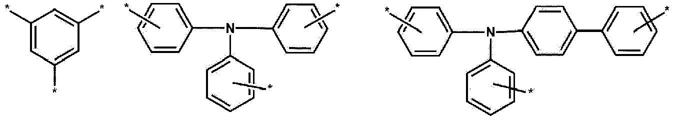

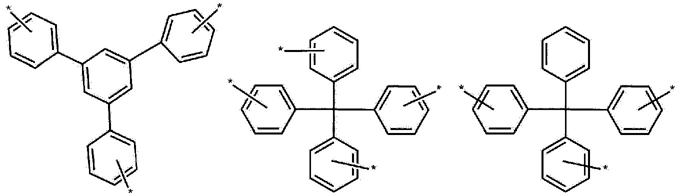

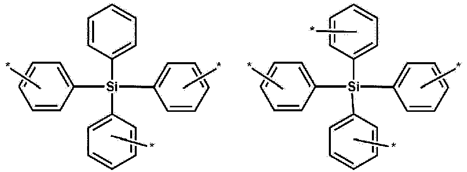

In the structure, * is an attachment point in the polymer.

More specifically, Chemical Formula 2 is any one of the following structures.

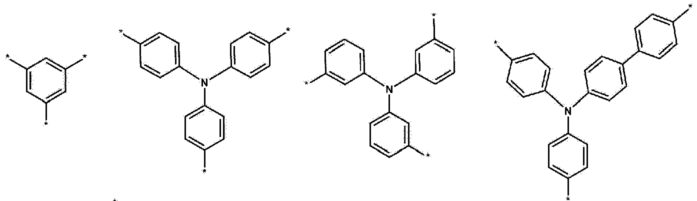

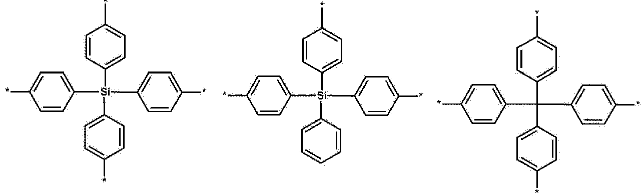

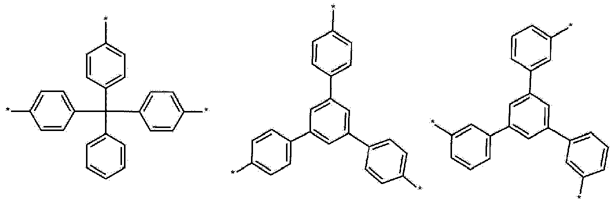

In the structure, * is an attachment point in the polymer.

More specifically, Chemical Formula 2 is any one of the following structures.

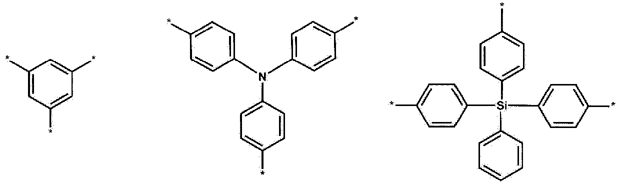

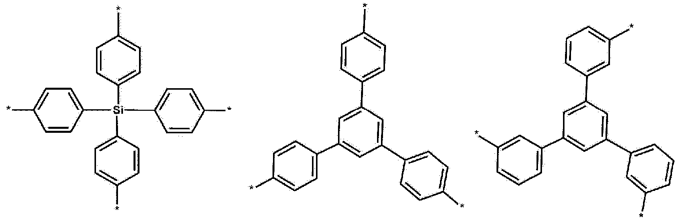

In the structure, * is an attachment point in the polymer.

Hereinafter, an end group will be described.

In an exemplary embodiment of the present specification, E is an end-capping unit of a polymer.

In an exemplary embodiment of the present specification, E is a unit having only one attachment point.

In an exemplary embodiment of the present specification, E is a substituted or unsubstituted alkyl group; a substituted or unsubstituted aryl group; a cross-linkable group; or a combination thereof.

In an exemplary embodiment of the present specification, E is a substituted or unsubstituted alkyl group having 1 to 30 carbon atoms; a substituted or unsubstituted aryl group having 6 to 30 carbon atoms; a cross-linkable group; or a combination thereof.

In an exemplary embodiment of the present specification, E is a substituted or unsubstituted alkyl group having 1 to 10 carbon atoms; a substituted or unsubstituted phenyl group; a substituted or unsubstituted biphenyl group; a cross-linkable group; or a combination thereof.

In an exemplary embodiment of the present specification, E is a cross-linkable group; or any one of the following structures.

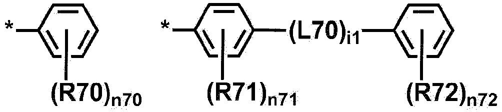

In the structures,
R70 to R72 are the same as or different from each other, and are each independently hydrogen; deuterium; a substituted or unsubstituted alkyl group; a substituted or unsubstituted aryl group; a substituted or unsubstituted heterocyclic group; or a cross-linkable group,
L70 is a direct bond; a substituted or unsubstituted alkylene group; or a substituted or unsubstituted arylene group,
i1 is an integer from 1 to 10, and when i1 is 2 or higher, two or more L70's are the same as or different from each other,
n70 and n72 are each an integer from 1 to 5, n71 is an integer from 1 to 4, and when n70 to n72 are each 2 or higher, substituents in the parenthesis are the same as or different from each other, and
* is an attachment point in the polymer.

In an exemplary embodiment of the present specification, E is any one of the following structures.

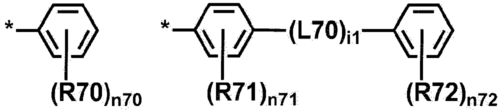

In the structures,
R70 to R72, L70, i1, n70 to n72 and * are as described above.

In an exemplary embodiment of the present specification, R70 to R72 are the same as or different from each other, and are each independently hydrogen; deuterium; an alkyl group having 1 to 10 carbon atoms; or a cross-linkable group.

In an exemplary embodiment of the present specification, L70 is a direct bond; an alkylene group having 1 to 10 carbon atoms; or an arylene group having 6 to 30 carbon atoms.

In an exemplary embodiment of the present specification, E is any one of the following structures.

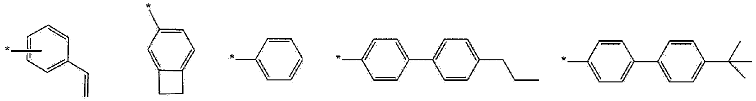

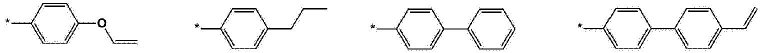

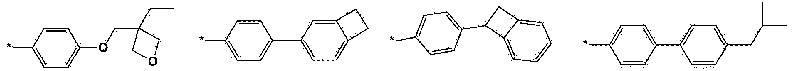

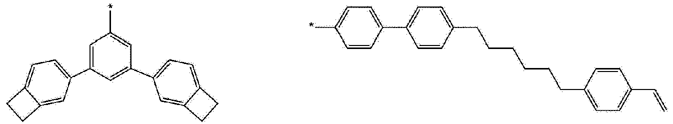

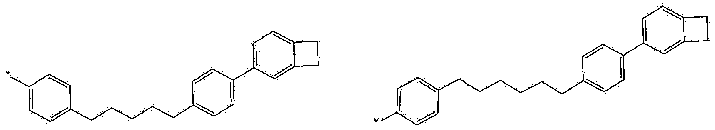

In the structure, * is an attachment point in the polymer.

More specifically, E is any one of the following structures.

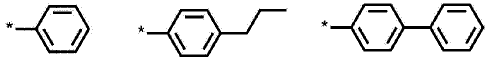

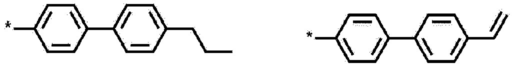

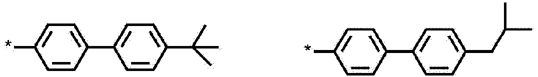

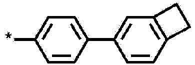

In the structure, * is an attachment point in the polymer.

Hereinafter, a polymer will be described.

In an exemplary embodiment of the present specification, the polymer is represented by the following Chemical Formula 4.

[Chemical Formula 4] **E1-[A1]ₐ-[B1]_{b}-[C1]_{c}-E2**

In Chemical Formula 4,
A1 is the first unit represented by Chemical Formula 1,
B1 is a second unit represented by Chemical Formula 1 and different from the first unit,
C1 is the third unit represented by Chemical Formula 2,
E1 and E2 are the same as or different from each other, and are each independently an end group represented by Chemical Formula 3,
a, b and c are each a mole fraction, a is a real number of 0<a<1, b is a real number of 0<b<1, c is a real number of 0<c<1, and a+b+c is 1.

In an exemplary embodiment of the present specification, a, b, and c are determined by the equivalent ratio of the monomers used in the preparation of the polymer.

In an exemplary embodiment of the present specification, a is a real number of 0.05 or more and less than 1.

In an exemplary embodiment of the present specification, a is a real number of 0.1 or more and less than 1.

In an exemplary embodiment of the present specification, a is a real number from 0.1 to 0.9.

In an exemplary embodiment of the present specification, a is a real number from 0.1 to 0.8.

In an exemplary embodiment of the present specification, a is a real number from 0.2 to 0.9.

In an exemplary embodiment of the present specification, a is a real number from 0.2 to 0.8.

In an exemplary embodiment of the present specification, b is a real number of 0.05 or more and less than 1.

In an exemplary embodiment of the present specification, b is a real number of 0.1 or more and less than 1.

In an exemplary embodiment of the present specification, b is a real number from 0.1 to 0.9.

In an exemplary embodiment of the present specification, b is a real number from 0.1 to 0.8.

In an exemplary embodiment of the present specification, b is a real number from 0.2 to 0.9.

In an exemplary embodiment of the present specification, b is a real number from 0.2 to 0.8.

In an exemplary embodiment of the present specification, c is a real number of more than 0 and less than 1.

In an exemplary embodiment of the present specification, c is a real number of more than 0 and 0.9 or less.

In an exemplary embodiment of the present specification, c is a real number from 0.1 to 0.8.

In an exemplary embodiment of the present specification, a is a real number of 0.05 or more and less than 1, b is a real number of 0.05 or more and less than 1, and c is a real number of more than 0 and 0.9 or less.

In an exemplary embodiment of the present specification, a is a real number from 0.1 to 0.8, b is a real number from 0.1 to 0.8, and c is a real number from 0.1 to 0.8.

In the present specification, a, b, and c are not based on the mole fraction of the entire polymer represented by Chemical Formula 4 including E1 and E2, but are a mole fraction based on the sum of A1, B1 and C1.

In an exemplary embodiment of the present specification, the molar ratio of (A1+B1+C1): (E1+E2) is 40:60 to 98:2.

In an exemplary embodiment of the present specification, the polymer is an alternating polymer, a block polymer, or a random polymer.

In an exemplary embodiment of the present specification, Chemical Formula 4 does not mean that A1, B1 and C1 are only in this order in the polymer. Specifically, A1, B1 and C1 may be in various orders in the polymer. For example, the polymer may be in the order of E1-A1-B1-C1-E2, E1-A1-C1-B1-E2, E1-B1-A1-C1-E2, E1-B1-C1-A1-E2, E1-C1-A1-B1-E2 or E1-C1-B1-A1-E2.

In addition, Chemical Formula 4 does not have a structure in which only each one of A1, B1 and C1 is linked in the polymer. For example, the polymer may be linked in various content ranges in the polymer, such as E1-A1-B1-A1-C1-E2, E1-A1-C1-B1-C1-E2, and E1-A1-B1-C1-A1-E2. In this case, the content range of A1, B1 and C1 is determined by the equivalent ratio of the monomers used during the preparation of the polymer.

In an exemplary embodiment of the present specification, the polymer has a weight average molecular weight (Mw) of 10,000 g/mol to 3,000,000 g/mol. Specifically, the polymer has a weight average molecular weight (Mw) of 10,000 g/mol to 1,000,000 g/mol. More specifically, the polymer has a weight average molecular weight (Mw) of 10,000 g/mol to 300,000 g/mol.

In an exemplary embodiment of the present specification, the polymer has a number average molecular weight (Mn) of 5,000 g/mol to 3,000,000 g/mol. Specifically, the polymer has a number average molecular weight (Mn) of 5,000 g/mol to 1,000,000 g/mol. More specifically, the polymer has a number average molecular weight (Mn) of 10,000 g/mol to 300,000 g/mol.

The molecular weight may be measured as a relative value to a standard polystyrene (PS) sample through gel permeation chromatography (GPC, waters breeze) using tetrahydrofuran (THF) as an eluate, and specifically, is a value obtained by applying a polystyrene-converted weight average molecular weight (Mw) and a number average molecular weight (Mn) obtained by gel permeation chromatography (GPC, PLgel HFIPGEL, Agilent Technologies).

Specifically, the polymer to be measured is dissolved in tetrahydrofuran to a concentration of 1%, 10 µl of the resulting solution is injected into GPC and flowed at a flow rate of 0.3 mL/min, and the sample may be analyzed at 30°C for a sample concentration of 2.0 mg/mL (100 µl injection). Here, two PLgel HFIPGELs manufactured by Waters as columns are connected in series, the polymer is measured at 40°C using an RI detector (product manufactured by Agilent Waters, 2414) as a detector, and then data may be processed using ChemStation.

When the weight average molecular weight of the polymer satisfies the above range, the viscosity is appropriate to show an effect of facilitating the manufacture of an inkjet device and the manufacture of an organic light emitting device using fine pixels.

In an exemplary embodiment of the present specification, the polymer has a polydispersity index (PDI) of 1 to 10. Specifically, the polymer has polydispersity index of 1 to 8.

In an exemplary embodiment of the present specification, the first unit represented by Chemical Formula 1; the second unit represented by Chemical Formula 1 and different from the first unit; the third unit represented by Chemical Formula 2; and the end group represented by Chemical Formula 3 in the polymer may be distributed such that the characteristics of the polymer are optimized.

In an exemplary embodiment of the present specification, when the mole fraction of the first unit represented by Chemical Formula 1, the mole fraction of the second unit represented by Chemical Formula 1 and different from the first unit, the mole fraction of the third unit represented by Chemical Formula 2, and the mole fraction of the end group represented by Chemical Formula 3 in the polymer are defined as a1, b1, c1 and e1, respectively, a1, b1, c1 and e1 are each a real number, 0<a1<1, 0<b1<1, 0<c1<1, and 0<e1<1, and a1+b1+c1+e1=1.

In an exemplary embodiment of the present specification, a1, b1, c1 and e1 are each a real number, 0<a1<1, 0<b1<1, 0<c1<1, and 0<e1<1, and a1+b1+c1+e1=1.

In an exemplary embodiment of the present specification, a1 is a real number of 0.05 or higher and less than 1.

In an exemplary embodiment of the present specification, a1 is a real number from 0.05 to 0.95.

In an exemplary embodiment of the present specification, a1 is a real number from 0.1 to 0.9.

In an exemplary embodiment of the present specification, a1 is a real number from 0.05 to 0.8.

In an exemplary embodiment of the present specification, a1 is a real number from 0.1 to 0.8.

In an exemplary embodiment of the present specification, b1 is a real number of 0.05 or more and less than 1.

In an exemplary embodiment of the present specification, b1 is a real number from 0.05 to 0.95.

In an exemplary embodiment of the present specification, b1 is a real number from 0.1 to 0.9.

In an exemplary embodiment of the present specification, b1 is a real number from 0.05 to 0.8.

In an exemplary embodiment of the present specification, b1 is a real number from 0.1 to 0.8.

In an exemplary embodiment of the present specification, c1 is a real number of 0 or more and less than 1.

In an exemplary embodiment of the present specification, c1 is a real number of 0.05 or more and less than 1.

In an exemplary embodiment of the present specification, c1 is a real number from 0.1 to 0.9.

In an exemplary embodiment of the present specification, c1 is a real number from 0.1 to 0.8.

In an exemplary embodiment of the present specification, e1 is a real number of 0.05 or more and less than 1.

In an exemplary embodiment of the present specification, e1 is a real number from 0.05 to 0.95.

In an exemplary embodiment of the present specification, e1 is a real number from 0.1 to 0.9.

In an exemplary embodiment of the present specification, e1 is a real number from 0.05 to 0.8.

In an exemplary embodiment of the present specification, e1 is a real number from 0.1 to 0.8.

In an exemplary embodiment of the present specification, a1 is a real number of 0.05 or more and less than 1, b1 is a real number of 0.05 or more and less than 1, c1 is a real number from 0.05 to 0.9, e1 is a real number from 0.05 to 0.95, and a1+b1+c1+e1=1.

In an exemplary embodiment of the present specification, a1 is a real number from 0.05 to 0.8, b1 is a real number from 0.05 to 0.8, c1 is a real number from 0.1 to 0.8, e1 is a real number from 0.05 to 0.8, and a1+b1+c1+e1=1.

In an exemplary embodiment of the present specification, the polymer is any one of the following structures.

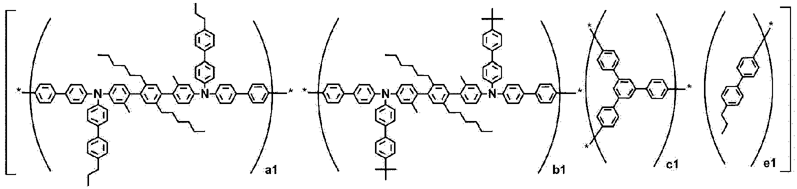

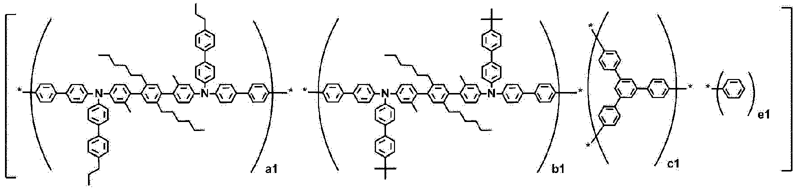

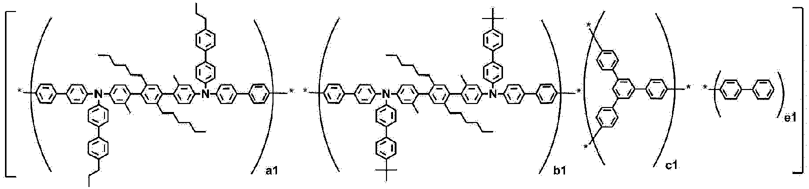

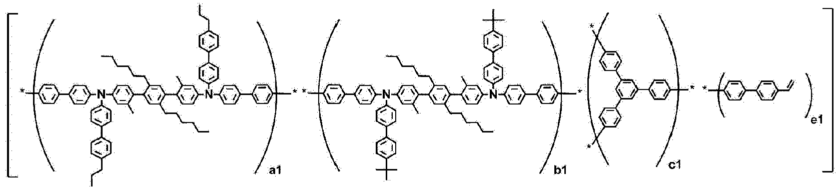

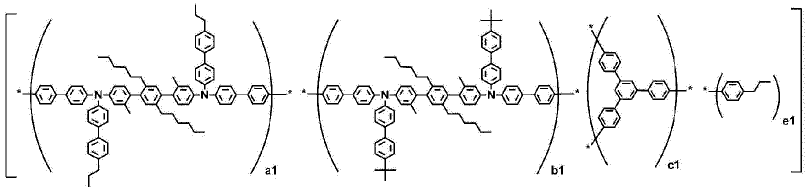

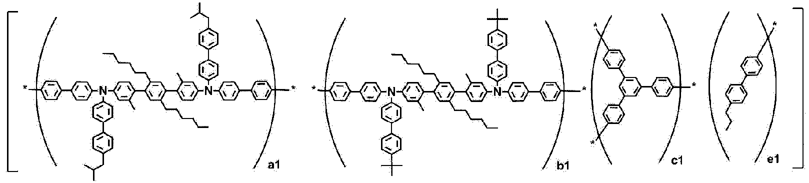

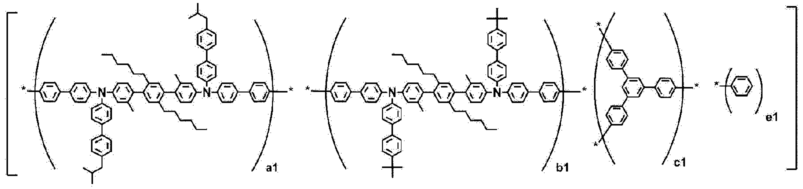

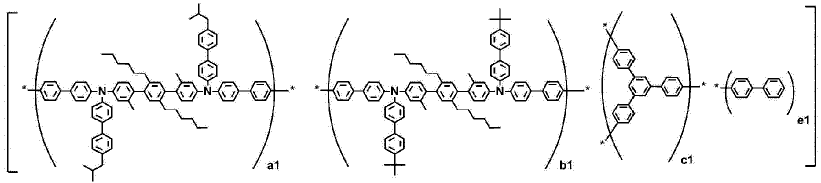

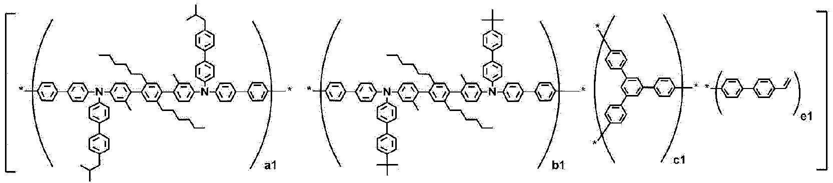

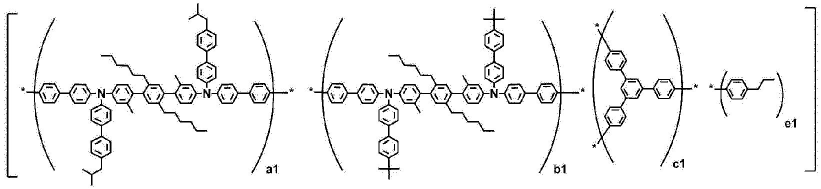

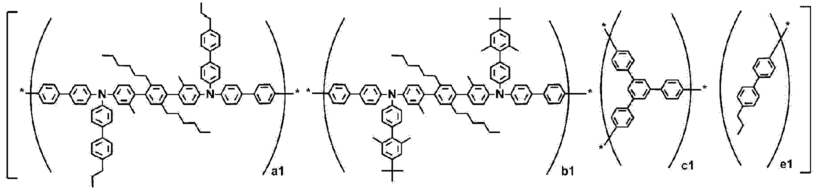

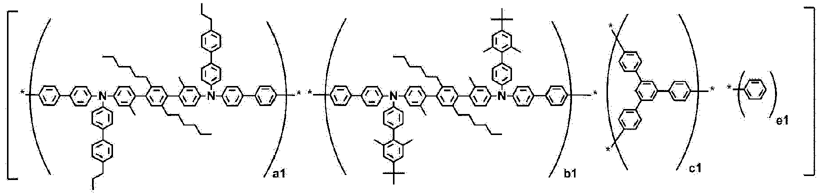

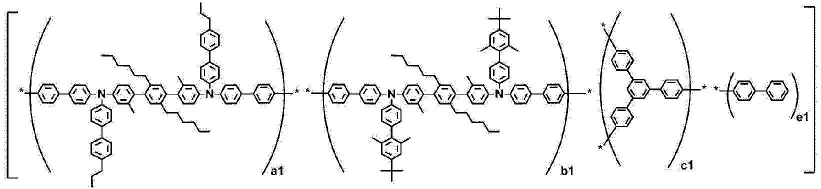

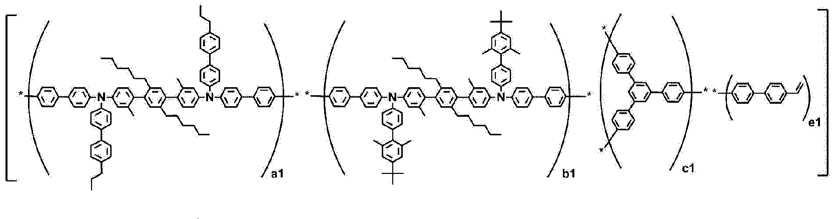

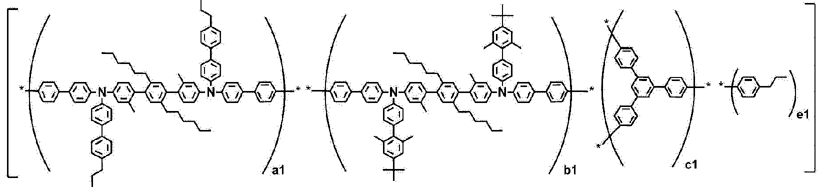

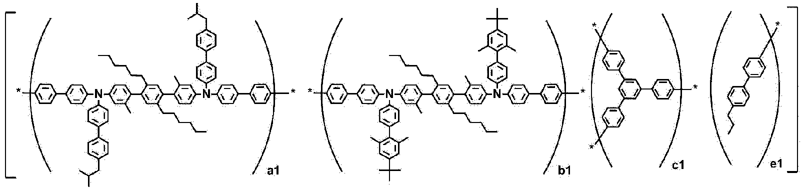

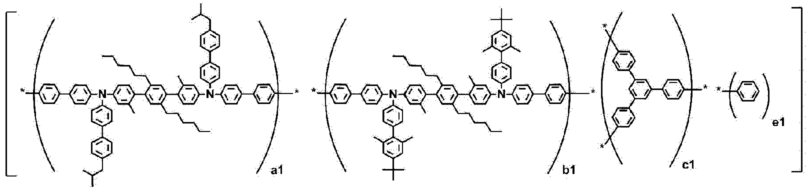

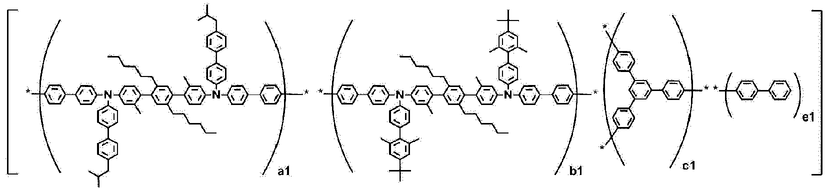

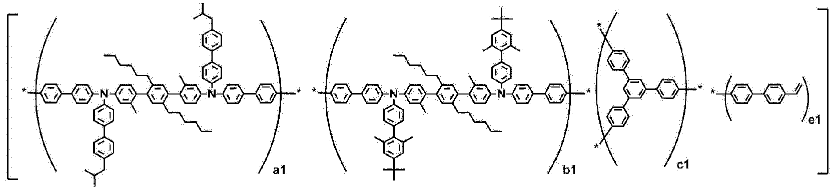

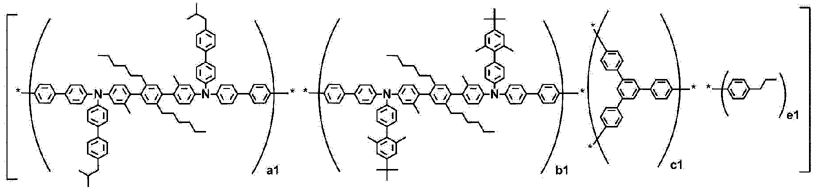

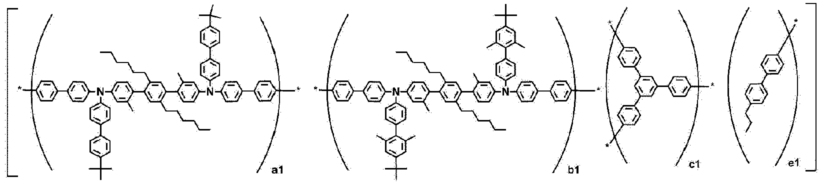

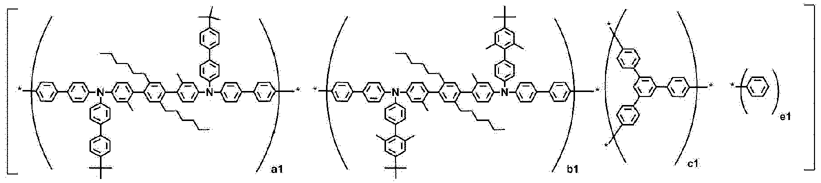

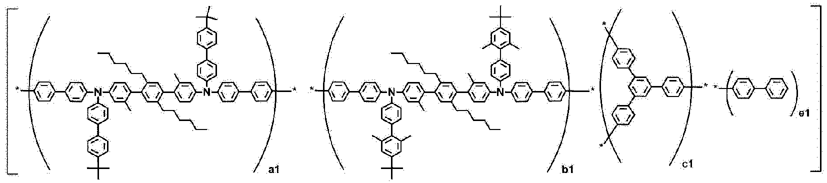

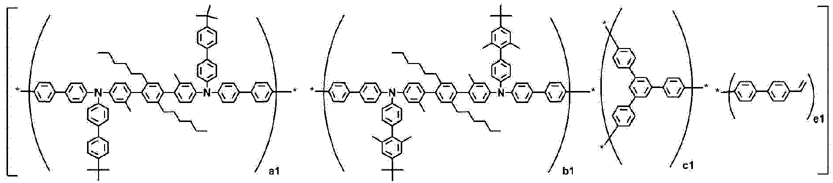

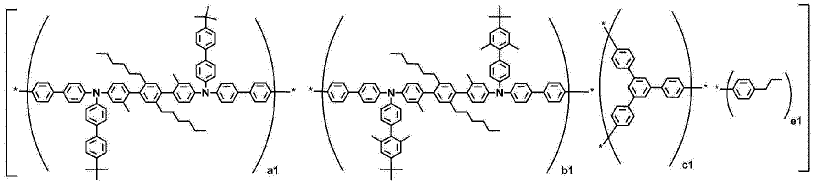

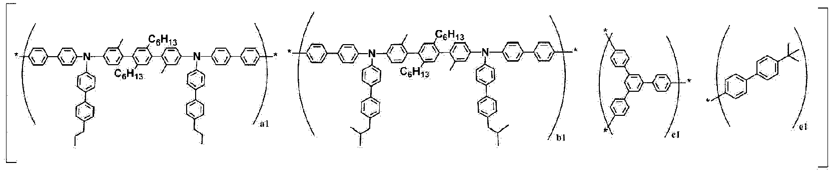

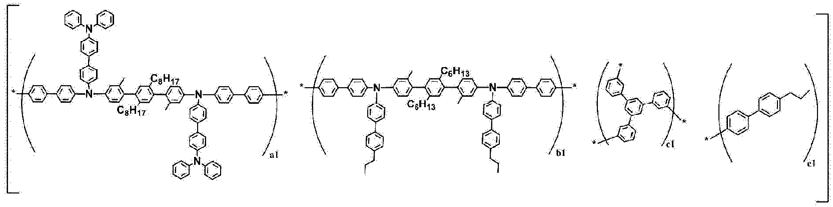

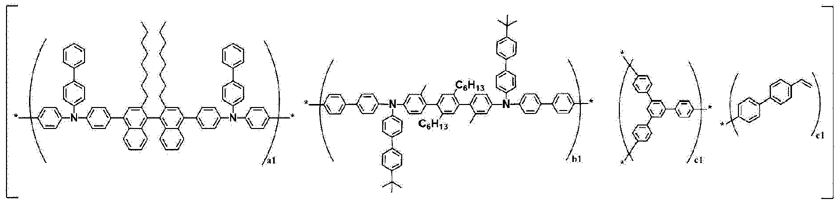

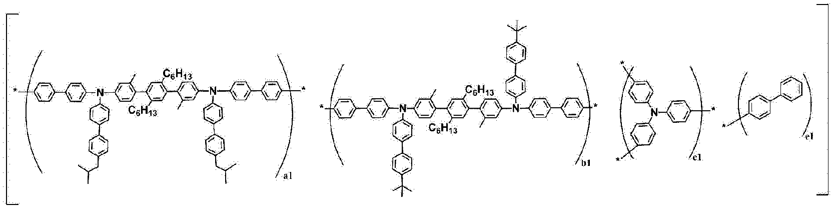

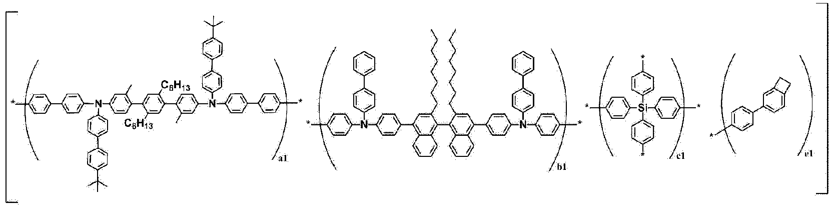

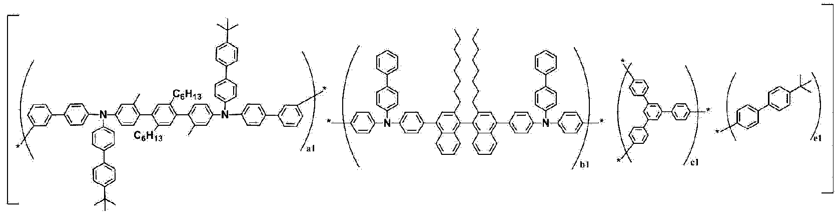

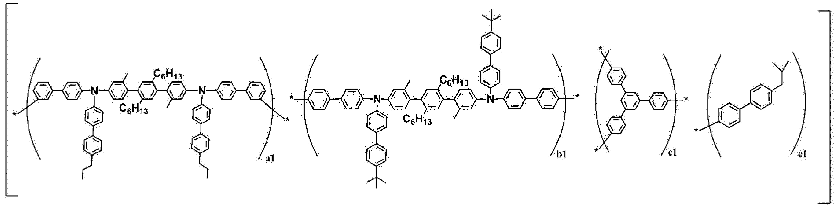

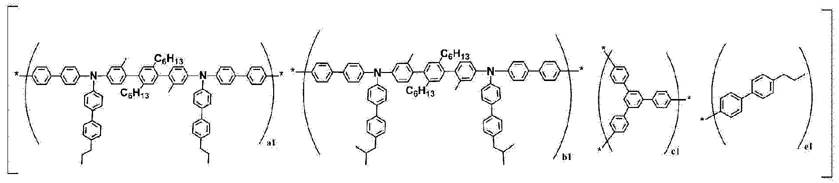

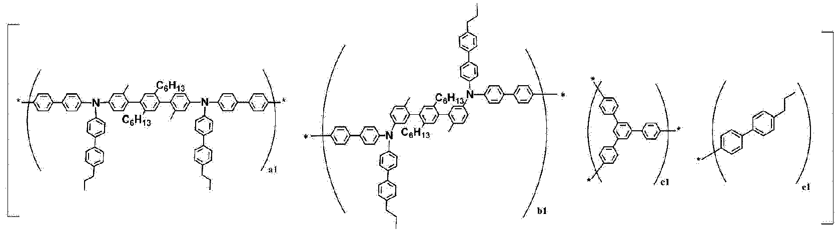

In the structures, a1 is a real number of 0<a1<1, b1 is a real number of 0<b1<1, c1 is a real number of 0<c1<1, e1 is a real number of 0<e1<1, and a1+b1+c1+e1 is 1.

Specifically, a1 is a real number of 0.05 or more and less than 1, b1 is a real number of 0.05 or more and less than 1, c1 is a real number from 0.05 to 0.9, e1 is a real number from 0.05 to 0.9, and a1+b1+c1+e1=1.

In an exemplary embodiment of the present specification, a1 is a real number from 0.05 to 0.8, b1 is a real number from 0.05 to 0.8, c1 is a real number from 0.1 to 0.8, e1 is a real number from 0.05 to 0.8, and a1+b1+c1+e1=1.

In the structures, a1, b1, c1, and e1 are determined by the equivalent weights of the monomers added during the preparation of the polymer.

In an exemplary embodiment of the present specification, the polymer may be prepared by using a publicly-known polymerization technique. For example, preparation methods such as Suzuki, Yamamoto, Stille, a C-N coupling reaction using a metal catalyst, and an arylation reaction using a metal catalyst may be applied.

In an exemplary embodiment of the present specification, the polymer may be substituted with deuterium. In this case, deuterium may be substituted by applying a method using a precursor material. For example, deuterium may be substituted by treating a non-deuterated monomer and/or polymer with a deuterated solvent in the presence of a Lewis acid H/D exchange catalyst.

In an exemplary embodiment of the present specification, the molecular weight of the polymer may be controlled by adjusting the ratio of the used monomers. In addition, in some exemplary embodiment, the molecular weight of the polymer may be controlled by using a quenching reaction.

In an exemplary embodiment of the present specification, the polymer may be used as a hole transport material. For example, the polymer may be a 'polymer for transporting holes'.

In an exemplary embodiment of the present specification, the polymer may be formed into a layer by a solution process. The term 'layer' is used interchangeably with the term 'membrane' or 'film', and refers to a coating which covers a desired region. This term is not limited by size. The region may be as large as the entire device, as small as a specific functional area such as an actual visual display, or as small as a single sub-pixel.

In an exemplary embodiment of the present specification, the layers, membranes and films may be formed by any typical deposition technique including deposition, liquid deposition (continuous and discontinuous techniques), and thermal transfer. The continuous deposition technique includes spin coating, gravure coating, curtain coating, dip coating, slot-die coating, spray coating, and continuous nozzle coating, but is not limited thereto. The discontinuous deposition technique includes inkjet printing, gravure printing, and screen printing, but is not limited thereto.

In an exemplary embodiment of the present specification, the polymer has an intrinsic viscosity of less than 20 cP. This is especially useful for inkjet printing applications, but the lower viscosity may allow the inkjet printing to spray a thicker liquid. Specifically, the polymer has an intrinsic viscosity of less than 15 cP, more specifically less than 10 cP, and more specifically less than 8 cP.

In an exemplary embodiment of the present specification, the polymer has an intrinsic viscosity of 1 cP or more and less than 20 cP, specifically 1 cP to 10 cP, and more specifically 1 cP to 8 cP.

The intrinsic viscosity is a value measured at 25°C using an Ubbelohde viscometer after dissolving the polymer to be measured in a chloroform solvent at a concentration of 0.5 g/dl.
Hereinafter, a coating composition including the polymer will be described.

An exemplary embodiment of the present specification provides a coating composition including the above-described polymer.

In an exemplary embodiment of the present specification, the coating composition further includes a solvent. In an exemplary embodiment of the present specification, the coating composition includes the polymer and the solvent.

In an exemplary embodiment of the present specification, the coating composition may be in a liquid phase. The "liquid phase" means that the composition is in a liquid state at room temperature under atmospheric pressure.

In an exemplary embodiment of the present specification, it is preferred that the solvent does not dissolve a material applied to a lower layer.

In an exemplary embodiment of the present specification, when the coating composition is applied to an organic material layer of an organic light emitting device, a solvent that does not dissolve a material in a lower layer is used. For example, when the coating composition is applied to a hole transport layer, a solvent that does not dissolve the material in the lower layer (first electrode, hole injection layer, and the like) is used. Accordingly, there is an advantage in that the hole transport layer can be introduced by the solution process.

In an exemplary embodiment of the present specification, the coating composition has an improved resistance to solvent during heat treatment after coating.

For example, even though a coating composition is prepared by using a solvent that dissolves the polymer and a layer is manufactured by a solution process, the layer may have resistance to the same solvent after the heat treatment.

Therefore, when an organic material layer is formed by using the polymer and then subjected to a heat treatment process, a solution process can be performed when another organic material layer is applied.

In an exemplary embodiment of the present specification, examples of the solvent included in the coating composition include: a chlorine-based solvent such as chloroform, methylene chloride, 1,2-dichloroethane, 1,1,2-trichloroethane, chlorobenzene, and o-dichlorobenzene; an ether-based solvent such as tetrahydrofuran and dioxane; an aromatic hydrocarbon-based solvent such as toluene, xylene, trimethylbenzene, and mesitylene; a ketone-based solvent such as acetone, methyl ethyl ketone, and cyclohexanone; an ester-based solvent such as ethyl acetate, butyl acetate, and ethyl cellosolve acetate; a polyhydric alcohol such as ethylene glycol, ethylene glycol monobutyl ether, ethylene glycol monoethyl ether, ethylene glycol monomethyl ether, dimethoxy ethane, propylene glycol, diethoxymethane, triethylene glycol monoethyl ether, glycerin, and 1,2-hexanediol and a derivative thereof; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; a benzoate-based solvent such as methyl benzoate, butyl benzoate, and 3-phenoxybenzoate; and a solvent such as tetralin, but the solvent can be used as long as the solvent can dissolve or disperse the polymer according to an exemplary embodiment of the present specification, and is not limited thereto.

In an exemplary embodiment of the present specification, the solvents may be used either alone or in a mixture of two or more solvents.

In an exemplary embodiment of the present specification, a boiling point of the solvent is preferably 40°C to 350°C, and more preferably 80°C to 330°C, but is not limited thereto.

In an exemplary embodiment of the present specification, a concentration of the polymer in the coating composition is preferably 0.1 wt/v% to 20 wt/v%, and more preferably 0.5 wt/v% to 10 wt/v%, but is not limited thereto.

In an exemplary embodiment of the present specification, the remaining components except for the polymer in the coating composition are solvents.

Hereinafter, an organic light emitting device including the polymer will be described.

An exemplary embodiment of the present specification provides an organic light emitting device including: a first electrode; a second electrode; and an organic material layer including one or more layers provided between the first electrode and the second electrode, in which one or more layers of the organic material layer include the polymer.

The organic material layer of the organic light emitting device of the present specification may also be composed of a single-layered structure, but may be composed of a multi-layered structure in which two or more organic material layers are stacked. For example, the organic light emitting device of the present invention may have a structure including a hole injection layer, a hole transport layer, a light emitting layer, an electron transport layer, an electron injection layer, a layer which simultaneously injects and transports holes, a layer which simultaneously injects and transports electrons, and the like as an organic material layer. However, the structure of the organic light emitting device is not limited thereto, and may include a fewer number of organic layers.

When the organic light emitting device includes a plurality of organic material layers, the organic material layers may be formed of the same material or different materials.

In an exemplary embodiment of the present specification, the organic light emitting device includes: a first electrode; a second electrode; and a light emitting layer provided between the first electrode and the second electrode, and further includes an organic material layer having a single layer between the light emitting layer and the first electrode, in which the organic material layer includes the polymer.

In an exemplary embodiment of the present specification, the organic light emitting device includes: a first electrode; a second electrode; and a light emitting layer between the first electrode and the second electrode, and further includes an organic material layer having multi-layers between the light emitting layer and the first electrode, in which one or more layers of the organic material layer include the polymer.

In an exemplary embodiment of the present specification, the organic material layer including the polymer is a hole injection layer, a hole transport layer, or a layer which simultaneously injects and transports holes.

In an exemplary embodiment of the present specification, the organic light emitting device includes: a first electrode; a second electrode; and a light emitting layer provided between the first electrode and the second electrode, and further includes one or more layers of a hole injection layer, a hole transport layer and an electron blocking layer between the light emitting layer and the first electrode, in which one or more layers of the hole injection layer, the hole transport layer and the electron blocking layer include the polymer.

In an exemplary embodiment of the present specification, the organic light emitting device includes: a first electrode; a second electrode; and a light emitting layer provided between the first electrode and the second electrode, and includes the hole injection layer and the hole transport layer between the first electrode and the light emitting layer, and one or more layers of the hole injection layer and the hole transport layer include the polymer.

In an exemplary embodiment of the present specification, the organic light emitting device has a structure in which a first electrode; a hole injection layer; a hole transport layer; a light emitting layer; and a second electrode are sequentially provided, and one or more layers of the hole injection layer and the hole transport layer include the polymer.

In an exemplary embodiment of the present specification, the organic light emitting device has a structure in which a first electrode; a hole injection layer; a hole transport layer; a light emitting layer; and a second electrode are sequentially stacked, and the hole injection layer or the hole transport layer includes the polymer.

In an exemplary embodiment of the present specification, the organic light emitting device has a structure in which a first electrode; a hole injection layer; a hole transport layer; a light emitting layer; and a second electrode are sequentially stacked, and the hole transport layer includes the polymer.

In an exemplary embodiment of the present specification, an additional organic material layer may be further included between the light emitting layer and the second electrode.

In an exemplary embodiment of the present specification, an organic material layer having a single layer may be further included between the light emitting layer and the second electrode.

In an exemplary embodiment of the present specification, an organic material layer having multi-layers may be further included between the light emitting layer and the second electrode. For example, one or more layers of a hole blocking layer, an electron injection layer, an electron transport layer and a layer which simultaneously injects and transports electrons may be further included between the light emitting layer and the second electrode.

In an exemplary embodiment of the present specification, the organic light emitting device has a structure in which a first electrode; a hole injection layer; a hole transport layer; a light emitting layer; an electron injection and transport layer; and a second electrode are sequentially stacked, and one or more layers of the hole injection layer and the hole transport layer include the polymer.

In an exemplary embodiment of the present specification, the organic light emitting device has a structure in which a first electrode; a hole injection layer; a hole transport layer; a light emitting layer; an electron injection and transport layer; and a second electrode are sequentially stacked, and the hole injection layer or the hole transport layer includes the polymer.

In an exemplary embodiment of the present specification, the organic light emitting device has a structure in which a first electrode; a hole injection layer; a hole transport layer; a light emitting layer; an electron injection and transport layer; and a second electrode are sequentially stacked, and the hole transport layer includes the polymer.

The structures of the organic light emitting device according to an exemplary embodiment of the present specification are exemplified in FIGS. 1 and 2.

FIG. 1 exemplifies the structure of an organic light emitting device in which a substrate 1, an anode 2, a light emitting layer 3, and a cathode 4 are sequentially stacked.

FIG. 2 exemplifies the structure of an organic light emitting device in which a substrate 1, an anode 2, a hole injection layer 5, a hole transport layer 6, a light emitting layer 3, an electron injection and transport layer 7, and a cathode 4 are sequentially stacked.

FIGS. 1 and 2 exemplify an organic light emitting device , and the structure of the organic light emitting device of the present invention is not limited thereto.

In an exemplary embodiment of the present specification, the first electrode is an anode, and the second electrode is a cathode. In another exemplary embodiment, the first electrode is a cathode, and the second electrode is an anode.

In still another exemplary embodiment, the organic light emitting device may be a normal type organic light emitting device in which an anode, an organic material layer having one or more layers, and a cathode are sequentially stacked on a substrate.

In yet another exemplary embodiment, the organic light emitting device may be an inverted type organic light emitting device in which a cathode, an organic material layer having one or more layers, and an anode are sequentially stacked on a substrate.

The organic light emitting device of the present invention may be stacked as a structure in the following examples.
(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/Cathode
(9) Anode/Hole injection layer/Hole buffer layer/Hole transport layer/Light emitting layer/Electron transport layer/Electron injection layer/Cathode
(10) Anode/Hole transport layer/Electron inhibiting layer/Light emitting layer/Electron transport layer/Cathode
(11) Anode/Hole transport layer/Electron inhibiting layer/Light emitting layer/Electron transport layer/Electron injection layer/Cathode
(12) Anode/Hole injection layer/Hole transport layer/Electron inhibiting layer/Light emitting layer/Electron transport layer/Cathode
(13) Anode/Hole injection layer/Hole transport layer/Electron inhibiting layer/Light emitting layer/Electron transport layer/Electron injection layer/Cathode
(14) Anode/Hole transport layer/Light emitting layer/Hole inhibiting layer/Electron transport layer/Cathode
(15) Anode/Hole transport layer/Light emitting layer/ Hole inhibiting layer/Electron transport layer/Electron injection layer/Cathode
(16) Anode/Hole injection layer/Hole transport layer/Light emitting layer/Hole inhibiting layer/Electron transport layer/Cathode
(17) Anode/Hole injection layer/Hole transport layer/Light emitting layer/Hole inhibiting layer/Electron transport layer/Electron injection layer/Cathode
(18) Anode/Hole injection layer/Hole transport layer/Electron inhibiting layer/Light emitting layer/Hole blocking layer/Electron injection layer and transport layer/Cathode

In the structures, the "Electron transport layer/Electron injection layer" may be replaced with "Electron injection and transport layer" or "Layer which simultaneously injects and transports electrons".

For example, the organic light emitting device of the present invention may be stacked as a structure such as 'Anode/Hole injection layer/Hole transport layer/Light emitting layer/Electron injection and transport layer/Cathode' in which the Electron transport layer/Electron injection layer of (7) is replaced with the electron injection and transport layer.

In the structures, the "Hole injection layer/Hole transport layer" may be replaced with the "hole injection and transport layer" or the "layer which simultaneously injects and transports holes".

The organic light emitting device of the present specification may be manufactured by the materials and methods known in the art, except that one or more layers of the organic material layer are manufactured so as to include the polymer. Specifically, for the organic light emitting device, one or more layers of the organic material layer may be formed by using a coating composition including the polymer.

For example, the organic light emitting device of the present specification may be manufactured by sequentially stacking an anode, an organic material layer, and a cathode on a substrate. In this case, the organic light emitting device may be manufactured by depositing a metal or a metal oxide having conductivity, or an alloy thereof on a substrate to form an anode, forming an organic material layer including a hole injection layer, a hole transport layer, a light emitting layer, and an electron injection and transport layer thereon, and then depositing a material, which may be used as a cathode, thereon, by using a physical vapor deposition (PVD) method such as sputtering or e-beam evaporation. In addition to the method described above, an organic light emitting device may be made by sequentially depositing a cathode material, an organic material layer, and an anode material on a substrate.

The present specification also provides a method for manufacturing an organic light emitting device formed by using the coating composition.

Specifically, in an exemplary embodiment of the present specification, the method includes: preparing a substrate; forming a first electrode on the substrate; forming an organic material layer having one or more layers on the first electrode; and forming a second electrode on the organic material layer, and one or more layers of the organic material layer are formed by using the coating composition.

In an exemplary embodiment of the present specification, the organic material layer formed by using the coating composition is formed by using spin coating.

In another exemplary embodiment, the organic material layer formed by using the coating composition is formed by a printing method.

In still another exemplary embodiment of the present specification, examples of the printing method include inkjet printing, nozzle printing, offset printing, transfer printing or screen printing, and the like, but are not limited thereto.

The coating composition according to an exemplary embodiment of the present specification is suitable for a solution process due to the structural characteristic thereof, so that the organic material layer may be formed by a printing method, and as a result, there is an economic effect in terms of time and costs when a device is manufactured.

In an exemplary embodiment of the present specification, the forming of the organic material layer formed by using the coating composition includes: coating the first electrode with the coating composition; and heat-treating or light-treating the coated coating composition.

In another exemplary embodiment, a heat treatment time in the heat-treating of the coating composition may be within 1 hour. The heat treatment time may be specifically within 30 minutes.

In an exemplary embodiment of the present specification, the atmosphere for heat-treating the organic material layer formed by using the coating composition is preferably an inert gas atmosphere such as argon or nitrogen.

When the organic material layer formed by using the coating composition is formed by a method including the heat-treating or light-treating of the coated coating composition, resistance to a solvent is increased, so that a plurality of layers may be formed by repeatedly performing solution deposition and cross-linking methods, and stability is increased, so that the service life characteristic of the device may be increased.

In an exemplary embodiment of the present specification, layers other than the organic material layer formed using the coating composition are formed by spin coating, a printing method or a deposition process. For example, when the coating composition is applied to a hole injection layer or a hole transport layer, the hole injection layer or the hole transport layer is formed by spin coating, and the other organic material layers may be formed by spin coating, a printing method or a deposition process. Furthermore, an upper layer provided to be brought into contact with the organic material layer formed using the coating composition may be formed by spin coating. As an example, when the coating composition is applied to a hole transport layer, the hole transport layer is formed by spin coating, the light emitting layer formed on the hole transport layer so as to be brought into contact with the hole transport layer is formed by spin coating, and the electron injection and transport layer formed on the light emitting layer may be formed by a deposition process.

In an exemplary embodiment of the present specification, as the anode material, materials having a high work function are usually preferred so as to facilitate the injection of holes into an organic material layer. Specific examples of the anode material which may be used in the present invention include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO : Al or SnO₂ : Sb; a conductive polymer such as poly(3-methylthiophene), poly[3,4-(ethylene-1,2-dioxy)thiophene] (PEDOT), polypyrrole, and polyaniline; and the like, but are not limited thereto.

In an exemplary embodiment of the present specification, as the cathode material, materials having a low work function are usually preferred so as to facilitate the injection of electrons into an organic material layer. Specific examples of the cathode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

In an exemplary embodiment of the present specification, the hole injection layer is a layer which injects holes from an electrode, and a hole injection material is preferably a compound which has a capability of transporting holes and thus has an excellent effect of injecting holes into a light emitting layer or a light emitting material, prevents excitons produced from the light emitting layer from moving to an electron injection layer or an electron injection material, and is also excellent in the ability to form a thin film. In addition, the highest occupied molecular orbital (HOMO) of the hole injection material is preferably a value between the work function of the anode material and the HOMO of the neighboring organic material layer. Specific examples of the hole injection material include metal porphyrin, oligothiophene, arylamine-based organic materials, hexanitrile hexaazatriphenylene-based organic materials, quinacridone-based organic materials, perylene-based organic materials, carbazole-based organic materials, anthraquinone, polyaniline-based and polythiophene-based electrically conductive polymers, and the like, but are not limited thereto. Specifically, the hole injection layer may be a carbazole-based compound, an arylamine-based compound, or a compound in which a substituted or unsubstituted carbazole and an arylamine group are linked, but is not limited thereto.

In an exemplary embodiment of the present specification, the hole transport layer is a layer which accepts holes from a hole injection layer and transports the holes to a light emitting layer, and a hole transport material is suitably a material having high hole mobility which may accept holes from an anode or a hole injection layer and transfer the holes to a light emitting layer. In an exemplary embodiment of the present specification, the hole transport layer includes the polymer.

In an exemplary embodiment of the present specification, the light emitting layer includes an organic compound. The organic compound is a material which may receive holes and electrons from a hole transport layer and an electron transport layer, respectively, and combine the holes and the electrons to emit light in a visible ray region, and is preferably a material having good quantum efficiency to fluorescence or phosphorescence. Specific examples thereof include: 8-hydroxy-quinoline aluminum complexes (Alq₃); carbazole-based compounds; dimerized styryl compounds; BAlq; 10-hydroxybenzoquinoline-metal compounds; benzoxazole-based, benzothiazole-based and benzimidazole-based compounds; poly(p-phenylenevinylene) (PPV)-based polymers; spiro compounds; polyfluorene, rubrene, and the like, but are not limited thereto.

In an exemplary embodiment of the present specification, the light emitting layer may include a host material and a dopant material. Examples of the host material include fused aromatic ring derivatives, or hetero ring-containing compounds, and the like. For example, examples of the fused aromatic ring derivatives include anthracene derivatives, pyrene derivatives, naphthalene derivatives, pentacene derivatives, phenanthrene compounds, fluoranthene compounds, and the like, and examples of the hetero ring-containing compounds include carbazole derivatives, dibenzofuran derivatives, ladder-type furan compounds, pyrimidine derivatives, and the like, but the examples thereof are not limited thereto. Examples of the dopant material include aromatic amine derivatives, styrylamine compounds, boron complexes, compounds including boron, fluoranthene compounds, metal complexes, and the like. Specifically, the aromatic amine derivative is a fused aromatic ring derivative substituted with a substituted or unsubstituted arylamino group, and examples thereof include fluorene substituted with an arylamino group, benzofluorene, pyrene, anthracene, chrysene, periflanthene, and the like, and the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamino group is or are substituted or unsubstituted. Specifically, examples of the styrylamine compound include styrylamine, styryldiamine, styryltriamine, styryltetramine, and the like, but are not limited thereto. Further, examples of the metal complex include an iridium complex, a platinum complex, and the like, but are not limited thereto.

In an exemplary embodiment of the present specification, the host material is an anthracene derivative, and the dopant material is a benzofluorene-based compound substituted with an arylamine group or a compound including boron. Specifically, the host material may be an anthracene derivative unsubstituted or substituted with deuterium, and the dopant material may be a bis(diarylamino)benzofluorene-based compound or a compound including boron, but is not limited thereto.

In an exemplary embodiment of the present specification, the light emitting layer includes a quantum dot. For example, the light emitting layer may include a matrix resin and a quantum dot, and as the types and contents of quantum dots, those known in the art may be used.

The case where the light emitting layer includes a quantum dot exhibits a lower HOMO energy level than the case where the light emitting layer includes an organic compound, so that a common layer also needs to show a low HOMO energy level. Since the compound according to an exemplary embodiment of the present specification exhibits a low HOMO energy level by including a halogen group, it is possible to introduce a quantum dot into the light emitting layer.

In an exemplary embodiment of the present specification, the common layer is a hole injection layer, a hole transport layer, a layer which simultaneously injects and transport holes, an electron injection layer, an electron transport layer, or a layer which simultaneously injects and transports electrons.

In an exemplary embodiment of the present specification, the electron transport layer is a layer which accepts electrons and transports the electrons to a light emitting layer, and an electron transport material is suitably a material having high electron mobility which may proficiently accept electrons from a cathode and transfer the electrons to a light emitting layer. Specific examples thereof include: Al complexes of 8-hydroxyquinoline; complexes including Alq₃; organic radical compounds; hydroxyflavone-metal complexes, and the like, but are not limited thereto. The electron transport layer may be used with any desired cathode material, as used according to the related art. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

In an exemplary embodiment of the present specification, the electron injection layer is a layer which injects electrons from an electrode, and an electron injection material is preferably a compound which has a capability of transporting electrons, has an excellent effect of injecting electrons into a light emitting layer or a light emitting material, prevents excitons produced from the light emitting layer from moving to a hole injection layer, and is also excellent in the ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, bathocuproine (BCP), and the like, and derivatives thereof, metal complex compounds, nitrogen-containing 5-membered ring derivatives, and the like, but are not limited thereto.

In an exemplary embodiment of the present specification, examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

In an exemplary embodiment of the present specification, the hole blocking layer is a layer which blocks holes from reaching a cathode, and may be generally formed under the same conditions as those of the hole injection layer. Specific examples thereof include oxadiazole derivatives or triazole derivatives, phenanthroline derivatives, BCP, aluminum complexes, and the like, but are not limited thereto.

In an exemplary embodiment of the present specification, a layer adjacent to an organic material layer including the polymer represented by Chemical Formula 4; or the polymer including the third unit represented by Chemical Formula 1 and the end group represented by Chemical Formula 3, for example, a bank layer includes a compound having fluorine as a substituent.

For example, when the polymer represented by Chemical Formula 4 is included in a hole transport layer, one or more of a bank layer adjacent to a hole transport layer, a hole injection layer, and a light emitting layer include fluorine.

As described above, when a layer adjacent to an organic material layer including the polymer including the first unit, the second unit, the third unit and the end group includes fluorine, there is an effect capable of forming a uniform layer because the dipole moment is changed depending on the fluorine.

The organic light emitting device according to the present specification may be a top emission type, a bottom emission type, or a dual emission type according to the materials to be used.

### [Mode for Invention]

Hereinafter, the present specification will be described in detail with reference to Examples for specifically describing the present specification. However, the Examples according to the present specification may be modified in various forms, and it is not interpreted that the scope of the present application is limited to the Examples described in detail below. The Examples of the present application are provided to explain the present specification more completely to a person with ordinary skill in the art.

### Synthesis Example 1. Preparation of monomer

### (1) Preparation of Monomer A-2

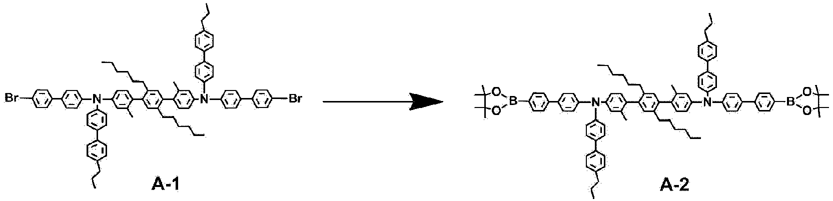

10.00 g (1.00 eq) of Monomer A-1, 14 g (2.00 eq) of bis(pinacolato)diboron, and 1.60 g (3.00 eq) of potassium tert-butoxide were dissolved in 200 mL of toluene in a round bottom flask equipped with a condenser. When the solution was completely dissolved, 0.20 g (0.04 eq) of [1,1'-bis(diphenylphosphino)ferrocene]dichloropalladium(II) (Pd(dppf)) was introduced thereinto, and then the resulting mixture was refluxed at 90°C for 8 hours. After the reaction was terminated with DI water, an organic solvent was extracted with ethyl acetate and distilled water, and 99.4% pure Monomer A-2 was obtained by column chromatography.

### (2) Preparation of Monomer B-2

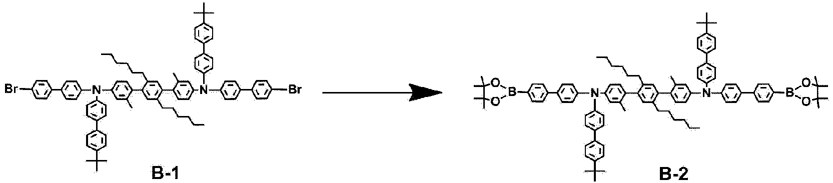

Monomer B-2 was prepared in the same manner as in (1) of Synthesis Example 1, except that Monomer B-1 was used instead of Monomer A-1 in (1) of Synthesis Example 1.

### (3) Preparation of Monomer C-2

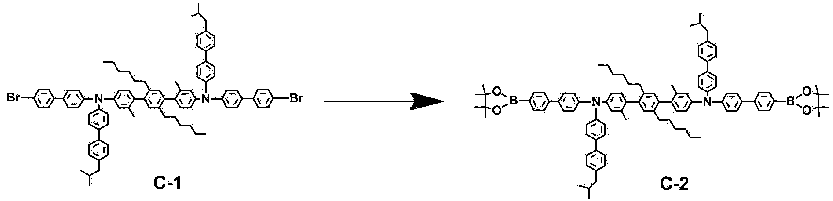

Monomer C-2 was prepared in the same manner as in (1) of Synthesis Example 1, except that Monomer C-1 was used instead of Monomer A-1 in (1) of Synthesis Example 1.

### (4) Preparation of Monomer D-2

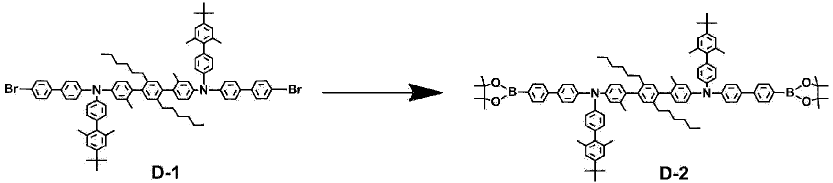

Monomer D-2 was prepared in the same manner as in (1) of Synthesis Example 1, except that Monomer D-1 was used instead of Monomer A-1 in (1) of Synthesis Example 1.

### Synthesis Example 2. Preparation of Polymer 1

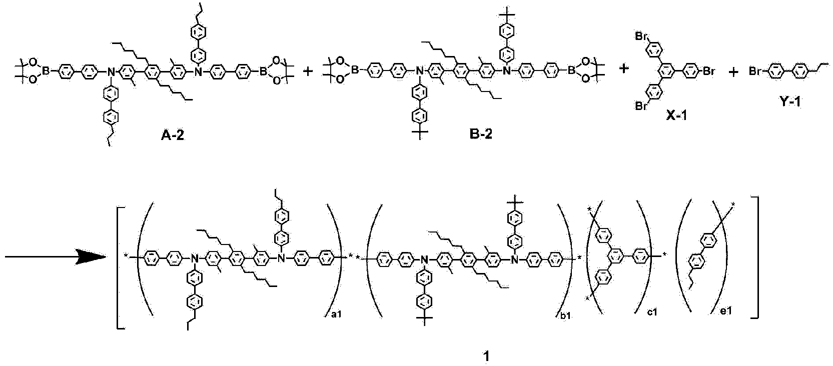

After Monomer A-2 (0.382 mmol), Monomer B-2 (0.382 mmol), Monomer X-1 (0.158 mmol) and Monomer Y-1 (0.369 mmol) were put into a round bottom flask and dissolved in toluene (11 mL),
tetrakis(triphenylphosphine)palladium(0)(Pd(PPh₃)₄) (0.05 mmol), 5 mL of a 2 M potassium carbonate (K₂CO₃) solution, and 0.1 mL of a phase transition catalyst Aliquat336 were injected thereinto, and then the resulting mixture was refluxed at 100°C for 12 hours. The reaction was terminated by slowly adding the reactant dropwise to methanol, and then the mixture was stirred for 45 minutes, and the resulting solid was filtered. The dried solid was dissolved in toluene (1% wt/v) and purified by being allowed to pass through a column containing silica gel and basic aluminum oxide (6 g each). Polymer 1 (5.2 g) was prepared by triturating the obtained toluene solution with acetone.

### Synthesis Example 3. Preparation of Polymer 2

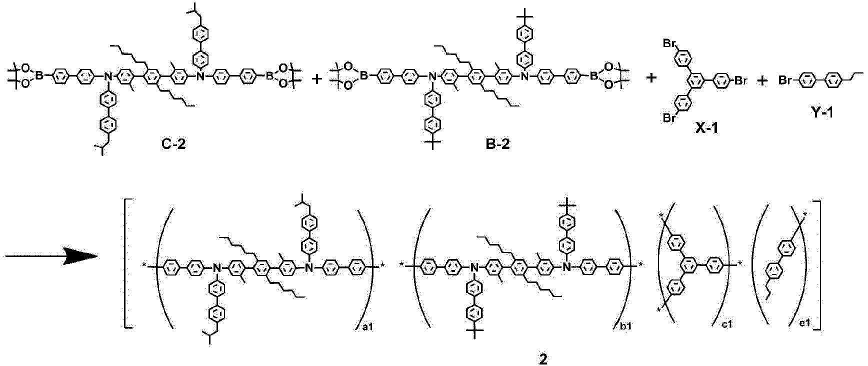

Polymer 2 was prepared in the same manner as in Synthesis Example 2, except that Monomer C-2 was used instead of Monomer A-2 in Synthesis Example 2.

### Synthesis Example 4. Preparation of Polymer 3

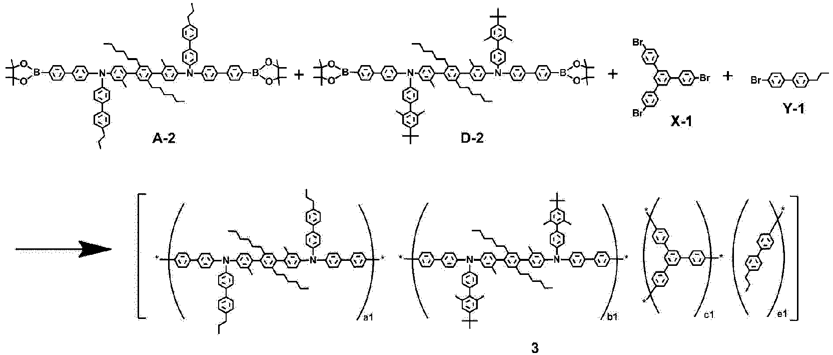

Polymer 3 was prepared in the same manner as in Synthesis Example 2, except that Monomer D-2 was used instead of Monomer B-2 in Synthesis Example 2.

### Synthesis Example 5. Preparation of Polymer 4

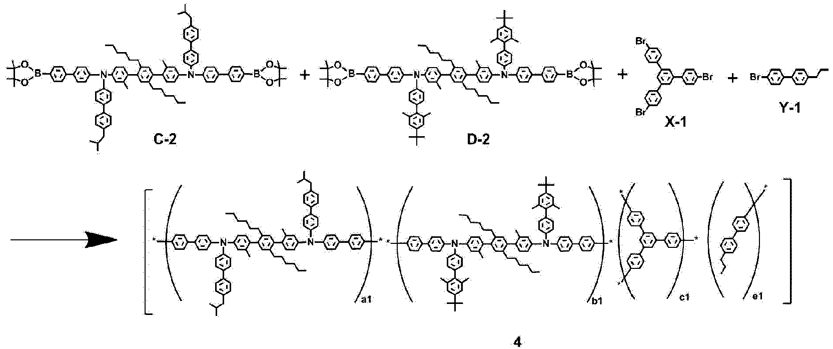

Polymer 4 was prepared in the same manner as in Synthesis Example 2, except that Monomer C-2 and Monomer D-2 were used instead of Monomer A-2 and Monomer B-2, respectively, in Synthesis Example 2.

### Synthesis Example 6. Preparation of Polymer 5

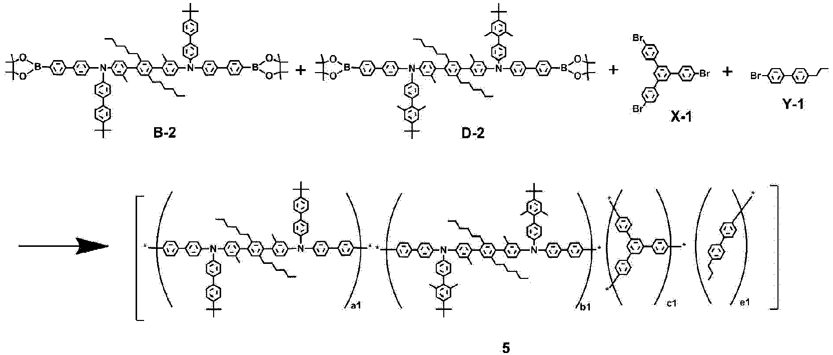

Polymer 5 was prepared in the same manner as in Synthesis Example 2, except that Monomer D-2 was used instead of Monomer A-2 in Synthesis Example 2.

### Synthesis Example 7. Preparation of Polymer 6

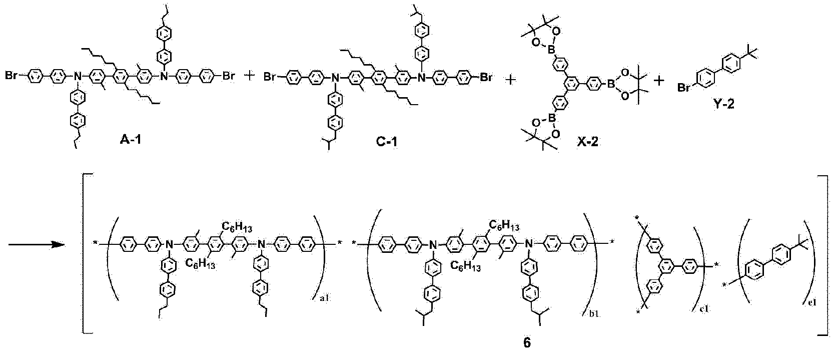

Under inert gas conditions, Monomer A-1 (0.26 mmol), Monomer C-1 (0.20 mmol), Monomer X-2 (0.24 mmol), Aliquat 336 (0.041 mmol), 1.24 mL of an aqueous potassium carbonate solution (0.5 M), bis(di-tert-butyl(4-dimethylaminophenyl)phosphine)dichloropalladium(II) (0.013 mmol) and toluene (6.0 mL) were added to a scintillation vial equipped with a magnetic stirring bar. The vial was sealed with a screw-cap with septum, inserted into an aluminum block and heated to an external temperature of 105°C over a time of 30 minutes, and the mixture was stirred at that temperature under reflux for 5 hours. Subsequently, Monomer Y-2 (0.3 mmol) and toluene (1 mL) were added thereto. The reaction product was heated for an additional 1.5 hours, and cooled to room temperature. The aqueous layer was removed and the organic layer was washed twice with each of 20 mL of DI water. The toluene layer was dried by being allowed to pass through 10 g of silica gel and the silica was rinsed with toluene. The solvent was removed to obtain 250 mg of a product. The product was further purified by passing a toluene solution through alumina, silica gel, and Florisil^{®}. After concentration, the solvent-wet product was diluted with toluene to about 14 mL and then added to ethyl acetate (150 mL) to obtain a copolymer. The product toluene solution was reprecipitated in 3-pentanone to prepare Polymer 6. (yield: 70 %)

### Synthesis Example 8. Preparation of Polymer 7

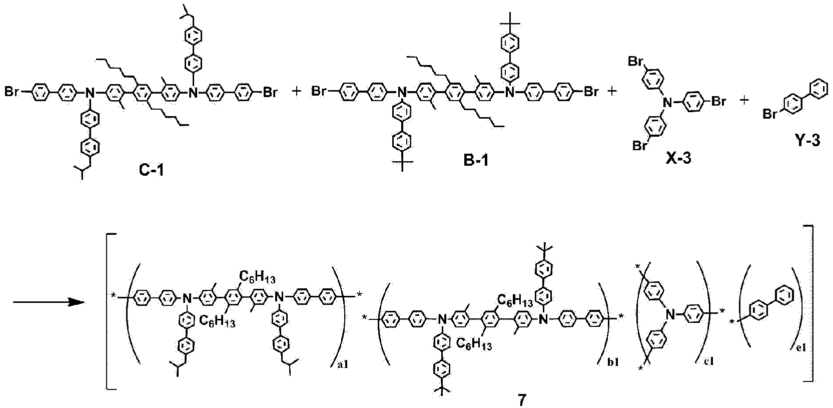

Monomer C-1 (0.3 mmol), Monomer B-1 (0.2 mmol), Monomer X-3 (0.2 mmol) and Monomer Y-3 (0.3 mmol) were added to a scintillation vial and dissolved in toluene (10 mL) to prepare a first solution.

A 50 mL Schlenk tube was charged with bis(1,5-cyclooctadiene) nickel (0) (2.1 mmol). 2,2'-dipyridyl (2.1 mmol) and 1,5-cyclooctadiene (2.1 mmol) were weighed and put into a scintillation vial and dissolved in N,N'-dimethylformamide (5.5 mL) and toluene (11 mL) to prepare a second solution.

The second solution was put into a Schlenk tube and stirred at 50°C for 30 minutes. The first solution was additionally added to the Schlenk tube, and the resulting solution was stirred at 50°C for 180 minutes. Subsequently, the Schlenk tube was cooled to room temperature and then poured into HCl/methanol (5% v/v, concentrated HCl). After stirring for 45 minutes, the polymer was collected by vacuum filtration and dried under high vacuum. The polymer was dissolved in toluene (1% wt/v) and passed through a column containing basic aluminum oxide (6 g) layered onto silica gel (6 g). The polymer/toluene filtrate was concentrated (2.5% wt/v toluene) and triturated with 3-pentanone. A toluene/3-pentanone solution was gradient-separated from the semi-solid polymer, dissolved in toluene (15 mL), and then poured into stirring methanol to prepare Polymer 7. (yield: 60%)

### Synthesis Example 9. Preparation of Polymer 8

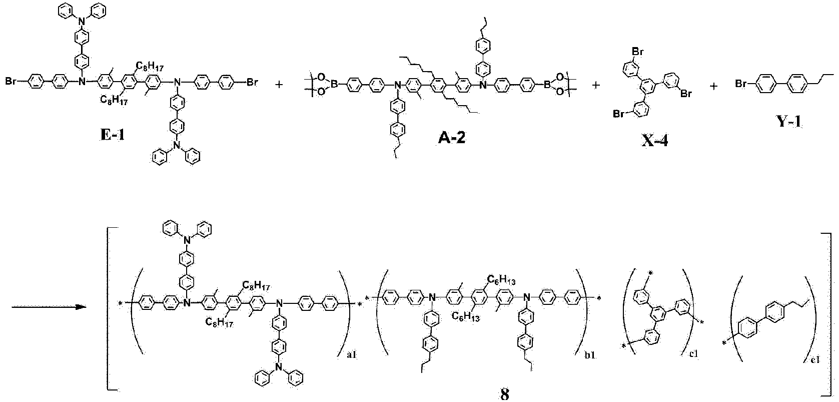

Polymer 8 was prepared in the same manner as in Synthesis Example 7, except that Monomer E-1, Monomer A-2, Monomer X-4, and Monomer Y-1 were used instead of Monomer A-1, Monomer C-1, Monomer X-2 and Monomer Y-2, respectively, in Synthesis Example 7. (yield: 55%)

### Synthesis Example 10. Preparation of Polymer 9

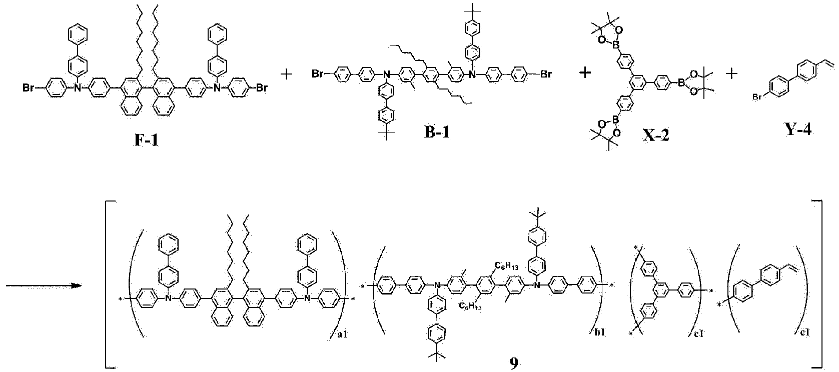

Polymer 9 was prepared in the same manner as in Synthesis Example 7, except that Monomer F-1, Monomer B-1, and Monomer Y-4 were used instead of Monomer A-1, Monomer C-1, and Monomer Y-2, respectively, in Synthesis Example 7. (yield: 60%)

### Synthesis Example 11. Preparation of Polymer 10

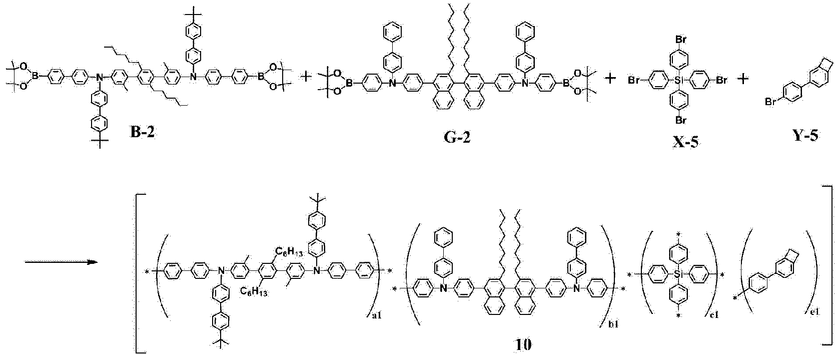

Polymer 10 was prepared in the same manner as in Synthesis Example 7, except that Monomer B-2, Monomer G-2, Monomer X-5, and Monomer Y-5 were used instead of Monomer A-1, Monomer C-1, Monomer X-2 and Monomer Y-2, respectively, in Synthesis Example 7. (yield: 60%)

### Synthesis Example 12. Preparation of Polymer 11

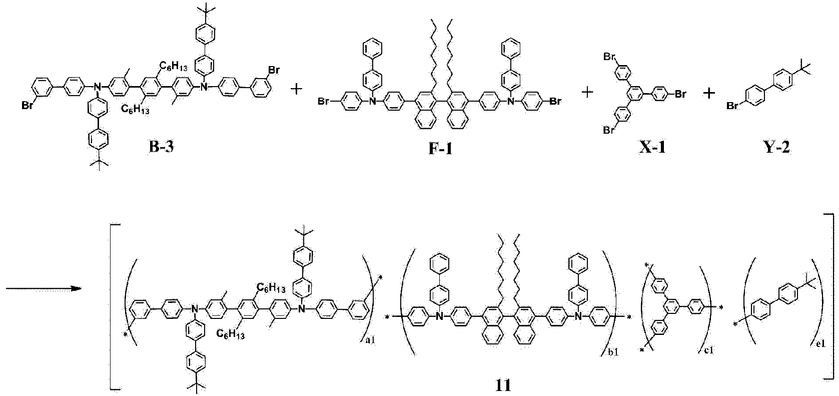

Polymer 11 was prepared in the same manner as in Synthesis Example 8, except that Monomer B-3, Monomer F-1, Monomer X-1, and Monomer Y-2 were used instead of Monomer C-1, Monomer B-1, Monomer X-3 and Monomer Y-3, respectively, in Synthesis Example 8. (yield: 60%)

### Synthesis Example 13. Preparation of Polymer 12

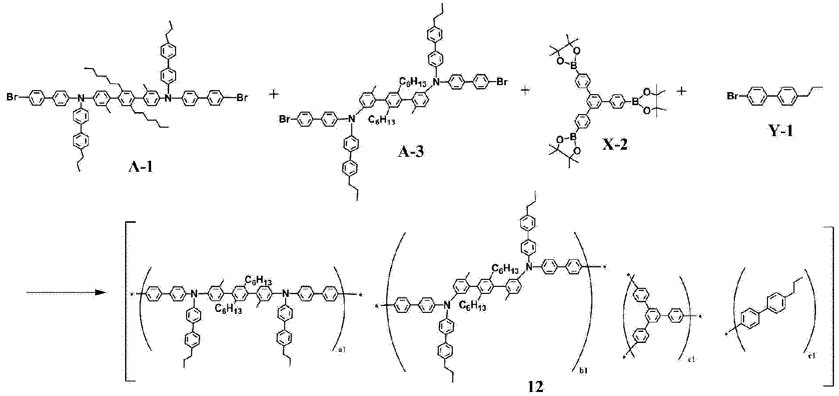

Polymer 12 was prepared in the same manner as in Synthesis Example 7, except that Monomer A-3 and Monomer Y-1 were used instead of Monomer C-1 and Monomer Y-2, respectively, in Synthesis Example 7. (yield: 50%)

### Synthesis Example 14. Preparation of Polymer 13

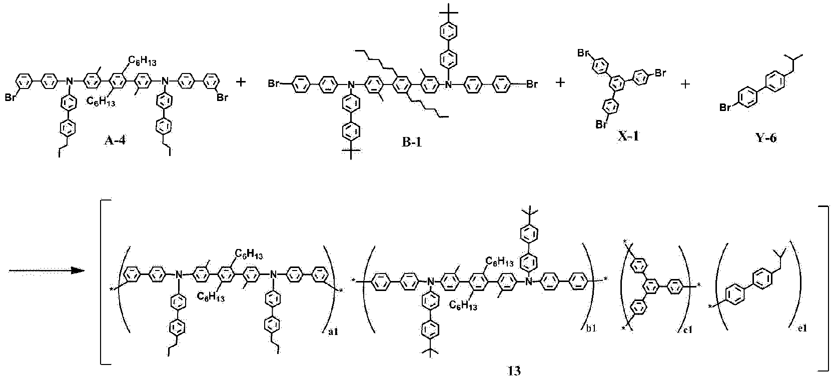

Polymer 13 was prepared in the same manner as in Synthesis Example 8, except that Monomer A-4, Monomer X-1, and Monomer Y-6 were used instead of Monomer C-1, Monomer X-3, and Monomer Y-3, respectively, in Synthesis Example 8. (yield: 60%)

### Synthesis Example 15. Preparation of Polymer 14

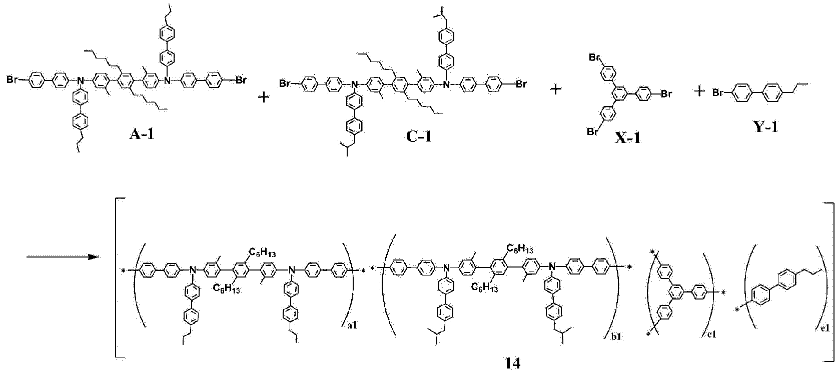

Polymer 14 was prepared in the same manner as in Synthesis Example 8, except that Monomer A-1, Monomer C-1, Monomer X-1, and Monomer Y-1 were used instead of Monomer C-1, Monomer B-1, Monomer X-3 and Monomer Y-3, respectively, in Synthesis Example 8. (yield: 70%)

### Comparative Synthesis Example 1. Preparation of Comparative Polymer Q1

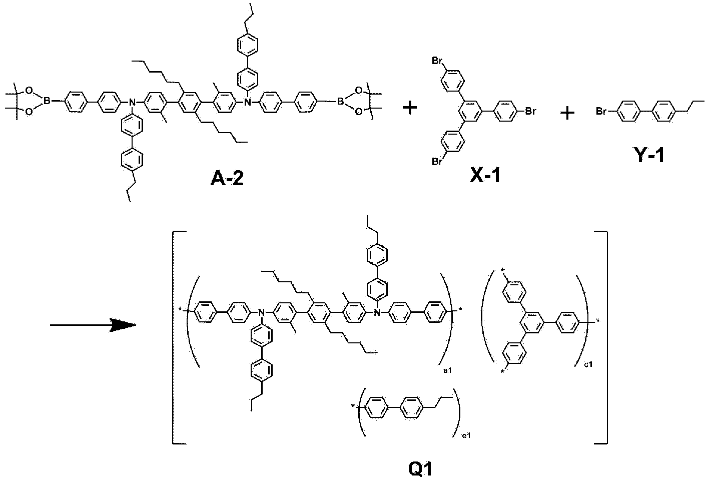

Polymer Q1 was prepared in the same manner as in Synthesis Example 2, except that the polymer was prepared without using Monomer B-2 in Synthesis Example 2.

### Comparative Synthesis Example 2. Preparation of Comparative Polymer Q2

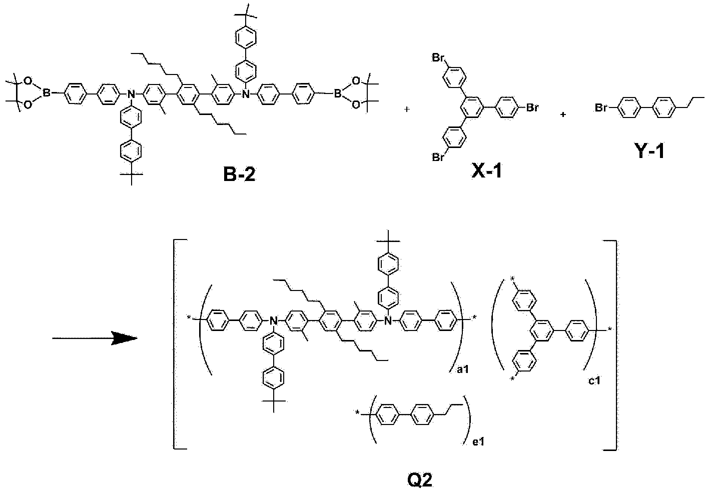

Polymer Q2 was prepared in the same manner as in Synthesis Example 2, except that the polymer was prepared without using Monomer A-2 in Synthesis Example 2.

### Comparative Synthesis Example 3. Preparation of Comparative Polymer Q3

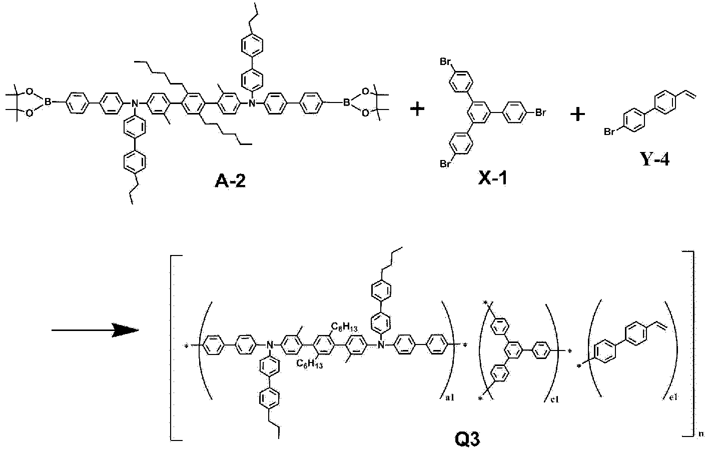

Polymer Q3 was prepared in the same manner as in Comparative Synthesis Example 1, except that Monomer Y-4 was used instead of Monomer Y-1 in Comparative Synthesis Example 1.

### Comparative Synthesis Example 4. Preparation of Comparative Polymer Q4

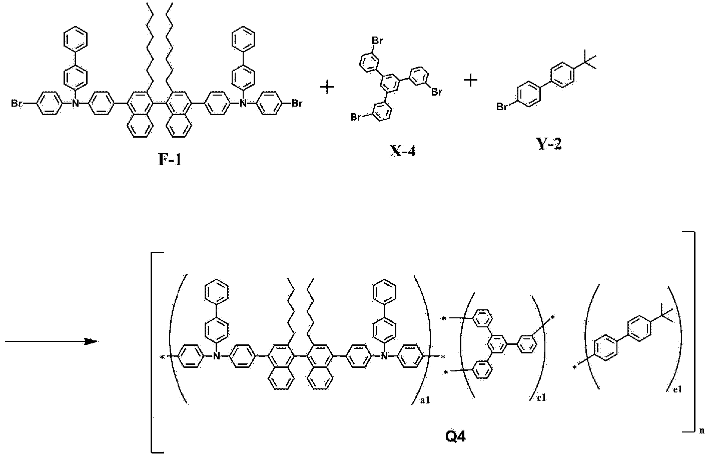

Polymer Q4 was prepared in the same manner as in Synthesis Example 8, except that Monomer F-1, Monomer X-4, and Monomer Y-2 were used instead of Monomer B-1, Monomer X-3 and Monomer Y-3, respectively, without using Monomer C-1 in Synthesis Example 8.

### <Example 1> Measurement of molecular weight

It was confirmed through molecular weight measurement that Polymers 1 to 14 and Comparative Polymers Q1 to Q4 were synthesized.

### Example 1-1.

The number average molecular weight (Mn), weight average molecular weight (Mw) and polydispersity index (PDI) of Polymer 1 prepared in Synthesis Example 2 were measured using GPC (manufactured by Agilent, PLgel HFIPGEL column) using tetrahydrofuran (THF).

The polydispersity index was calculated by the following Equation (1). PDI = Weight average molecular weight (Mw)/Number average molecular weight (Mn)

### Examples 1-2 to 1-14.

In Examples 1-2 to 1-14, the number average molecular weight (Mn), weight average molecular weight (Mw) and polydispersity index (PDI) were measured in the same manner as in Example 1-1, except that the polymers in the following Table 1 were used instead of Polymer 1 in Example 1-1.

### Comparative Examples 1-1 to 1-4

In Comparative Examples 1-1 to 1-4, the number average molecular weight (Mn), weight average molecular weight (Mw) and polydispersity index (PDI) were measured in the same manner as in Example 1-1, except that the polymers in the following Table 2 were used instead of Polymer 1 in Example 1-1.

**[Table 1]**

| | Polymer | a1:b1:c1:e1 (molar ratio) | Mn | Mw | PDI |
|---|---|---|---|---|---|
| Example 1-1 | 1 | 0.27:0.27:0.18: 0.28 | 32,000 | 86,000 | 2.69 |
| Example 1-2 | 2 | 0.27:0.27:0.18: 0.28 | 35,000 | 91,000 | 2.60 |
| Example 1-3 | 3 | 0.29:0.29:0.18: 0.24 | 39,000 | 126,000 | 3.23 |
| Example 1-4 | 4 | 0.29:0.29:0.19: 0.23 | 38,000 | 122,000 | 3.21 |
| Example 1-5 | 5 | 0.28:0.28:0.18: 0.26 | 39,000 | 129,000 | 3.31 |
| Example 1-6 | 6 | 0.26:0.20:0.24: 0.30 | 31,988 | 150,860 | 4.72 |
| Example 1-7 | 7 | 0.30:0.20:0.20: 0.30 | 29,075 | 92,422 | 3.18 |
| Example 1-8 | 8 | 0.25:0.25:0.30: 0.20 | 31,151 | 159,230 | 5.11 |
| Example 1-9 | 9 | 0.25:0.25:0.40: 0.10 | 32,366 | 157,961 | 4.88 |
| Example 1-10 | 10 | 0.30:0.30:0.30: 0.10 | 28,658 | 137,076 | 4.78 |
| Example 1-11 | 11 | 0.05:0.75:0.10: 0.10 | 29,991 | 140,238 | 4.68 |
| Example 1-12 | 12 | 0.30:0.20:0.20: 0.30 | 25,077 | 87,709 | 3.50 |
| Example 1-13 | 13 | 0.05:0.45:0.30: 0.20 | 29,242 | 76,642 | 2.62 |
| Example 1-14 | 14 | 0.50:0.15:0.15: 0.20 | 46,978 | 156,933 | 3.34 |

**[Table 2]**

| | Polymer | a1:c1:e1 (molar ratio) | Mn | Mw | PDI |
|---|---|---|---|---|---|
| Comparative Example 1-1 | Q1 | 0.56:0.18:0.26 | 39,000 | 129,000 | 3.31 |
| Comparative Example 1-2 | Q2 | 0.54:0.18:0.28 | 30,000 | 100,000 | 3.33 |
| Comparative Example 1-3 | Q3 | 0.60:0.10:0.30 | 36,213 | 186,079 | 5.14 |
| Comparative Example 1-4 | Q4 | 0.50:0.25:0.25 | 42,667 | 236,535 | 5.54 |

### <Example 2> Manufacture of organic light emitting device

### Example 2-1.

A glass substrate thinly coated with indium tin oxide (ITO) to have a thickness of 1,500 Å was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the ITO was washed for 30 minutes, ultrasonic washing was conducted twice repeatedly using distilled water for 10 minutes. After the washing with distilled water was completed, the substrate was ultrasonically washed with isopropyl alcohol and acetone solvents, and dried, and then the substrate was cleaned for 5 minutes, and then dried.

Immediately before the device was manufactured, the washed and patterned ITO was treated with UV ozone for 10 minutes. After ozone treatment, a 2 wt% cyclohexanone solution including Compound A and the following Compound B at a weight ratio of 8:2 is spin-coated on the ITO surface, and the solvent is removed by heat treatment, thereby forming a hole injection layer having a thickness of about 40 nm. A toluene solution in which 1.5 wt% of Polymer 1 prepared in Synthesis Example 2 was dissolved was spin-coated on the hole injection layer formed above and the solvent was removed by heat treatment, thereby forming a hole transport layer having a thickness of about 100 nm. A methylbenzoate solution in which the following Compound C and Compound D (Compound C:Compound D = 93:7 (wt%)) were dissolved at a concentration of 2.0 wt% was spin-coated on the hole transport layer, thereby forming a light emitting layer having a thickness of about 100 nm. Thereafter, the ITO was transported to a vacuum deposition apparatus, and then BCP was vacuum-deposited on the light emitting layer to have a thickness of 35 nm, thereby forming an electron injection and transport layer. LiF and aluminum were sequentially deposited on the electron injection and transport layer to have a thickness of 1 nm and 100 nm, respectively, thereby forming a cathode.

The deposition rates of lithium fluoride and aluminum of the cathode were maintained at 0.3 Å/sec and 2 Å/sec, respectively, during the aforementioned procedure, and the degree of vacuum during the deposition was maintained at 2 × 10⁻⁷ torr to 5 × 10⁻⁶ torr (1 Torr = 133.322 Pascal)

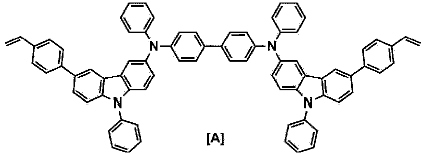

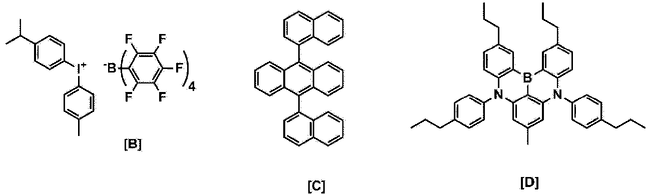

### Examples 2-2 to 2-5.

In Examples 2-2 to 2-5, organic light emitting devices were manufactured in the same manner as in Example 2-1, except that the polymers of the following Table 3 were used instead of Polymer 1 in Example 2-1.

### Comparative Examples 2-1 and 2-2.

In Comparative Examples 2-1 and 2-2, organic light emitting devices were manufactured in the same manner as in Example 2-1, except that the polymers of the following Table 3 were used instead of Polymer 1 in Example 2-1.

The results of measuring the performances of the organic light emitting devices manufactured in Examples 2-1 to 2-5 and Comparative Examples 2-1 and 2-2 at a current density of 10 mA/cm² are shown in the following Table 3.

**[Table 3]**

| | **Hole transport layer** | V | J (mA/cm²) | cd/A | Im/W | QE (%) | Cd/m² | CIEx | CIEy | CE/CIEy |
|---|---|---|---|---|---|---|---|---|---|---|
| **Comparative Example 2-1** | **Polymer Q1** | 7.81 | 10.0 | 1.21 | 0.49 | 1.41 | 121.05 | 0.150 | 0.107 | 11.3 |
| **Comparative Example 2-2** | **Polymer Q2** | 5.45 | 10.00 | 5.72 | 3.30 | 5.56 | 572.33 | 0.106 | 0.175 | 32.69 |
| **Example 2-1** | **Polymer 1** | 5.04 | 10.00 | 5.90 | 3.68 | 9.90 | 590.40 | 0.126 | 0.076 | 77.36 |
| **Example 2-2** | **Polymer 2** | 4.96 | 10.00 | 5.66 | 3.59 | 10.87 | 566.40 | 0.132 | 0.062 | 92.10 |
| **Example 2-3** | **Polymer 3** | 5.16 | 10.00 | 5.95 | 3.62 | 10.37 | 595.20 | 0.128 | 0.072 | 83.00 |
| **Example 2-4** | **Polymer 4** | 5.15 | 10.00 | 6.08 | 3.71 | 11.08 | 608.30 | 0.130 | 0.067 | 91.08 |
| **Example 2-5** | **Polymer 5** | 5.29 | 10.00 | 5.48 | 3.26 | 11.48 | 547.90 | 0.135 | 0.054 | 102.50 |

In Table 3, unless otherwise stated, the measured values are those at 1000 nits, V is a driving voltage (in volt units) at 10 mA/cm², the external quantum efficiency (QE) is obtained as (the number of emitted photons)/(the number of injected charge carriers), cd/A (CE) is a current efficiency, lm/W is a light source efficiency, CIEx and CIEy are the x and y coordinates according to the C.I.E chromaticity diagram (Commission Internationalede L'Eclairage, 1931), and the CE/CIEy is a value obtained by dividing the light emitting efficiency (cd/A) by the color coordinate (y) value.

Through Table 3, it can be confirmed that the organic light emitting device (Examples 2-1 to 2-5) to which the polymer according to the present invention is applied exhibits high efficiency compared to the organic light emitting devices (Comparative Examples 2-1 and 2-2) to which other polymers are applied. This is because the charge/hole transfer balance is adjusted by including the first unit and the second unit having different charge mobilities in the polymers of the present invention.

### Example 2-6.

A glass substrate on which ITO was thin-film deposited to a thickness of 1500 Å was ultrasonically cleaned with an acetone solvent for 10 minutes. Then, the glass substrate was put into distilled water in which a detergent was dissolved, and washed with ultrasonic waves for 10 minutes, and then the glass substrate was repeatedly ultrasonically washed twice with distilled water for 10 minutes. After the glass substrate was washed with distilled water, the glass substrate was ultrasonically washed with a solvent of isopropyl alcohol for 10 minutes, and then dried. Thereafter, the substrate was transported to a glove box.

A 2 wt% cyclohexanone solution including the following Compound A and the following Compound B at a weight ratio of 8:2 was spin-coated on the ITO transparent electrode prepared as described above, and heat-treated at 230°C for 30 minutes, thereby forming a hole injection layer having a thickness of 600 Å. A 0.8 wt% toluene solution including Polymer 6 prepared in Synthesis Example 7 was spin-coated on the hole injection layer, thereby forming a hole transport layer having a thickness of 1000 Å. The following Compounds C and D were dissolved in toluene on the hole transport layer at a weight ratio of 9:1, thereby forming a light emitting layer having a thickness of 550 Å through a solution process. The following Compound E was vacuum-deposited on the light emitting layer, thereby forming an electron injection and transport layer having a thickness of 400 Å. LiF and aluminum were sequentially deposited on the electron injection and transport layer to have a thickness of 5 Å and 1000 Å, respectively, thereby forming a cathode.

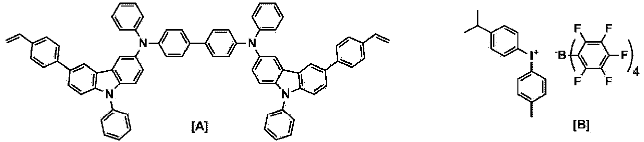

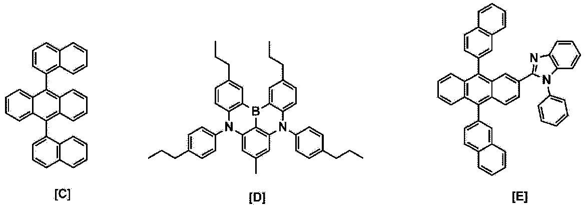

In the aforementioned procedure, the deposition rate of the organic material was maintained at 0.4 Å/sec to 1.0 Å/sec, the deposition rates of LiF and aluminum of the cathode were maintained at 0.3 Å/sec and at 2 Å/sec, respectively, and the degree of vacuum during the deposition was maintained at 2×10⁻⁸ torr to 5×10⁻⁶ torr.

### Examples 2-7 to 2-14.

In Examples 2-7 to 2-14, organic light emitting devices were manufactured in the same manner as in Example 2-6, except that the polymers of the following Table 4 were used instead of Polymer 6 in Example 2-6.

### Comparative Examples 2-3 to 2-5.

In Comparative Examples 2-3 to 2-5, organic light emitting devices were manufactured in the same manner as in Example 2-6, except that the following Compound Q5, Polymer Q3 and Polymer Q4 were used instead of Polymer 6 in Example 2-6.

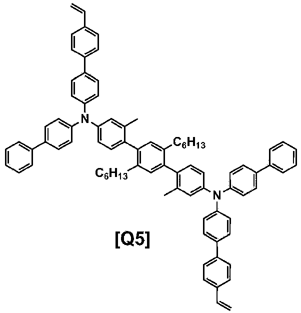

**[Table 4]**

| | Hole transport layer | Volt (V) | J (mA/cm²) | EQE (%) | T95 (h) |
|---|---|---|---|---|---|
| Example 2-6 | Polymer 6 | 4.50 | 10 | 6.08 | 201 |
| Example 2-7 | Polymer 7 | 4.47 | 10 | 5.86 | 173 |
| Example 2-8 | Polymer 8 | 4.24 | 10 | 5.46 | 188 |
| Example 2-9 | Polymer 9 | 4.42 | 10 | 5.99 | 184 |
| Example 2-10 | Polymer 10 | 4.51 | 10 | 6.25 | 199 |
| Example 2-11 | Polymer 11 | 4.24 | 10 | 5.41 | 146 |
| Example 2-12 | Polymer 12 | 4.67 | 10 | 6.72 | 110 |
| Example 2-13 | Polymer 13 | 4.34 | 10 | 6.66 | 225 |
| Example 2-14 | Polymer 14 | 4.32 | 10 | 6.63 | 217 |
| Comparative Example 2-3 | Compound Q5 | 3.89 | 10 | 3.24 | 19 |
| Comparative Example 2-4 | Polymer Q3 | 4.46 | 10 | 5.16 | 53 |
| Comparative Example 2-5 | Polymer Q4 | 4.00 | 10 | 3.7 | 32 |

Through Table 4, it can be confirmed that the organic light emitting devices (Examples 2-6 to 2-14) to which the polymer according to the present invention is applied exhibits high efficiency compared to the organic light emitting devices (Comparative Examples 2-3 to 2-5) to which another polymer or Compound Q5 is applied. This is because the charge/hole transfer balance is adjusted by including the first unit and the second unit having different charge mobilities in the polymers of the present invention.

In summary, through Tables 3 and 4, it can be confirmed that the polymer including the first unit and the second unit has excellent performance compared to the polymer including only one of the two units.

Although the preferred exemplary embodiments (a hole transport layer) of the present invention have been described above, the present invention is not limited thereto, and various modifications can be made and carried out within the scope of the claims and the detailed description of the invention, and also fall within the scope of the invention.

## Claims

1. A polymer comprising:
a first unit represented by the following Chemical Formula 1;
a second unit represented by the following Chemical Formula 1 and different from the first unit;
a third unit represented by the following Chemical Formula 2; and
an end group represented by the following Chemical Formula 3: 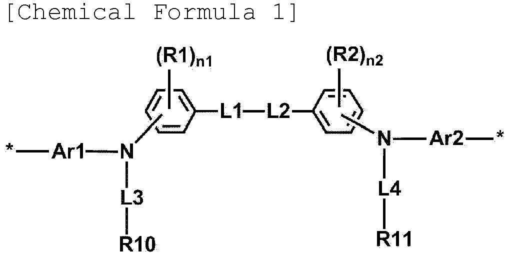 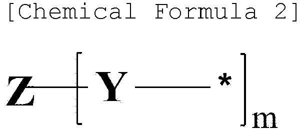
[Chemical Formula 3] *-[E]
wherein, in Chemical Formulae 1 to 3,
L1, L3 and L4 are the same as or different from each other, and are each independently a direct bond; or a substituted or unsubstituted arylene group,
Ar1, Ar2 and L2 are the same as or different from each other, and are each independently a substituted or unsubstituted arylene group,
R1 and R2 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
R10 and R11 are the same as or different from each other, and are each independently a substituted or unsubstituted alkyl group; a substituted or unsubstituted aryl group; a substituted or unsubstituted heterocyclic group; or a substituted or unsubstituted arylamine group,
n1 and n2 are each an integer from 1 to 4, and when n1 and n2 are each 2 or higher, substituents in the parenthesis are the same as or different from each other,
m is an integer of 3 or 4,
when m is 3, Z is CRa; SiRa; N; or a substituted or unsubstituted trivalent aryl group,
when m is 4, Z is C; Si; or a substituted or unsubstituted tetravalent aryl group,
Ra is hydrogen; deuterium; a substituted or unsubstituted alkyl group; or a substituted or unsubstituted aryl group,
Y is a direct bond; a substituted or unsubstituted alkylene group; or a substituted or unsubstituted arylene group,
when Y is a direct bond; or a substituted or unsubstituted alkylene group, Z is a substituted or unsubstituted trivalent or tetravalent aryl group,
E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a substituted or unsubstituted heterocyclic group; a cross-linkable group; or a combination thereof, and
* is an attachment point in the polymer.

2. The polymer of claim 1, wherein the polymer is represented by the following Chemical Formula 4:
[Chemical Formula 4] E1-[A1]ₐ-[B1]_{b}-[C1]_{c}-E2
in Chemical Formula 4,
A1 is the first unit represented by Chemical Formula 1,
B1 is a second unit represented by Chemical Formula 1 and different from the first unit,
C1 is the third unit represented by Chemical Formula 2,
E1 and E2 are the same as or different from each other, and are each independently the end group represented by Chemical Formula 3, and
a, b and c are each a mole fraction, a is a real number of 0<a<1, b is a real number of 0<b<1, c is a real number of 0<c<1, and a+b+c is 1.

3. The polymer of claim 1, wherein Chemical Formula 1 is represented by any one of the following Chemical Formulae 1-1 to 1-4: 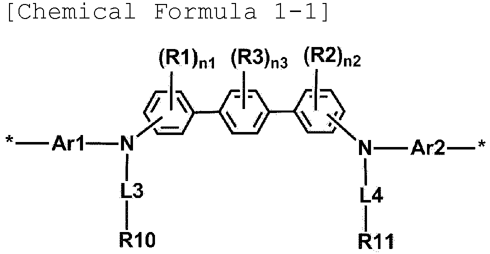 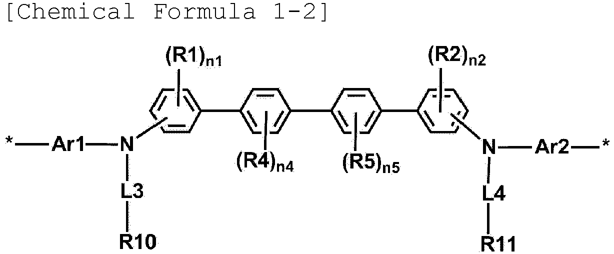 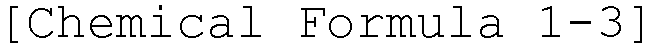 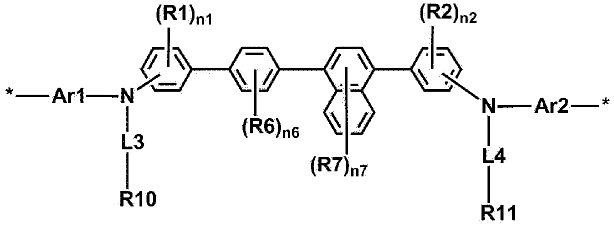 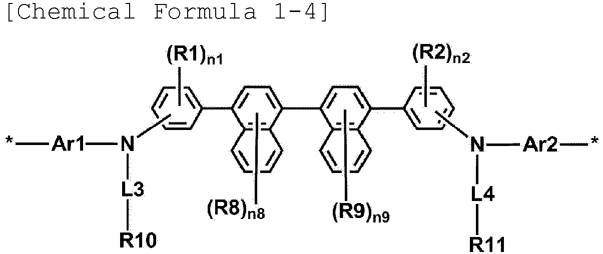 in Chemical Formulae 1-1 to 1-4,
R1, R2, R10, R11, Ar1, Ar2, L3, L4, n1 and n2 are the same as those defined in Chemical Formula 1,
R3 to R9 are the same as or different from each other, and are each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n3 to n6 are each an integer from 1 to 4, and when n3 to n6 are each 2 or higher, substituents in the parenthesis are the same as or different from each other,
n7 to n9 are each an integer from 1 to 6, and when n7 to n9 are each 2 or higher, substituents in the parenthesis are the same as or different from each other, and
* is an attachment point in the polymer.

4. The polymer of claim 1, wherein at least one of the first unit and the second unit is the following Chemical Formula 1-A1: 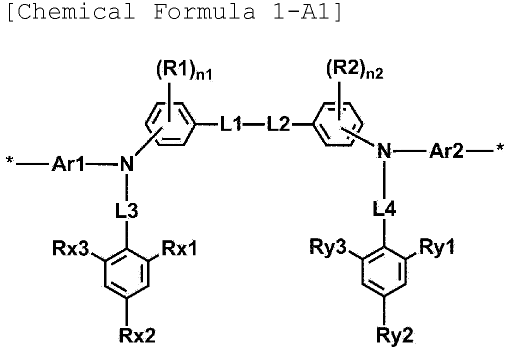 in Chemical Formula 1-A1,
L1 to L4, R1, R2, Ar1, Ar2, n1 and n2 are the same as those defined in Chemical Formula 1,
Rx1 to Rx3 and Ry1 to Ry3 are the same as or different from each other, and are each independently hydrogen; or a substituted or unsubstituted alkyl group,
at least one of Rx1 to Rx3 and at least one of Ry1 to Ry3 are a substituted or unsubstituted alkyl group, and
* is an attachment point in the polymer.

5. The polymer of claim 4, wherein Rx2 and Ry2 are the same as or different from each other, and are each independently a branched alkyl group having 4 to 30 carbon atoms.

6. The polymer of claim 4, wherein L1 is a direct bond, and L2 is a substituted or unsubstituted phenylene group.

7. The polymer of claim 1, wherein Chemical Formula 2 is any one of the following Chemical Formulae 2-1 to 2-4: 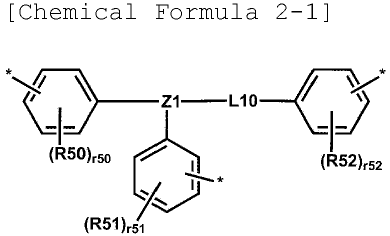 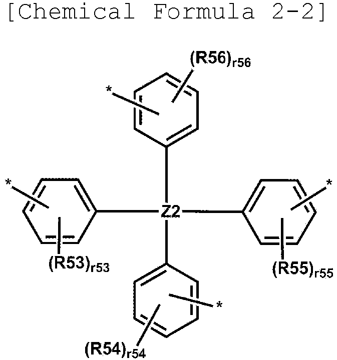 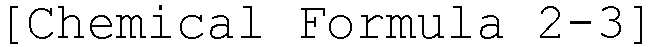 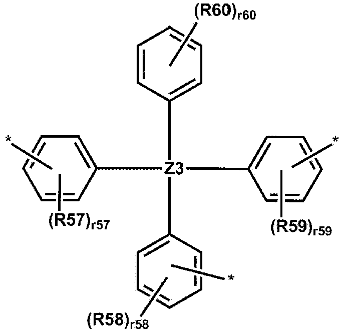 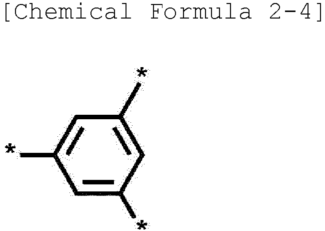 in Chemical Formulae 2-1 to 2-4,
Z1 is CRa; SiRa; N; or a substituted or unsubstituted trivalent aryl group,
Z2 and Z3 are the same as or different from each other, and are each independently C; Si; or a substituted or unsubstituted tetravalent aryl group,
L10 is a direct bond; or a substituted or unsubstituted arylene group,
Ra is hydrogen; deuterium; a substituted or unsubstituted alkyl group; or a substituted or unsubstituted aryl group,
R50 to R60 are the same as or different from each other, and are each independently hydrogen; deuterium; a halogen group; a cyano group; an alkoxy group; an aryloxy group; a siloxane group; a substituted or unsubstituted amine group; a substituted or unsubstituted alkyl group; a substituted or unsubstituted aryl group; a substituted or unsubstituted heterocyclic group; or a cross-linkable group, and adjacent groups may be bonded to each other to form a ring,
r50 to r59 are each an integer from 1 to 4, r60 is an integer from 1 to 5, and when r50 to r60 are each 2 or higher, substituents in the parenthesis are the same as or different from each other, and
* is an attachment point in the polymer.

8. The polymer of claim 1, wherein E is a substituted or unsubstituted alkyl group; a substituted or unsubstituted aryl group; a cross-linkable group; or a combination thereof.

9. The polymer of claim 1, wherein E is a cross-linkable group; or any one of the following structures: 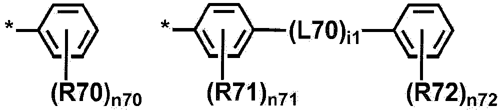 in the structures,
R70 to R72 are the same as or different from each other, and are each independently hydrogen; deuterium; a substituted or unsubstituted alkyl group; a substituted or unsubstituted aryl group; a substituted or unsubstituted heterocyclic group; or a cross-linkable group,
L70 is a direct bond; a substituted or unsubstituted alkylene group; or a substituted or unsubstituted arylene group,
i1 is an integer from 1 to 10, and when i1 is 2 or higher, two or more L70's are the same as or different from each other,
n70 and n72 are each an integer from 1 to 5, n71 is an integer from 1 to 4, and when n70 to n72 are each 2 or higher, substituents in the parenthesis are the same as or different from each other, and
* is an attachment point in the polymer.

10. The polymer of claim 1, wherein the cross-linkable group is any one of the following structures: 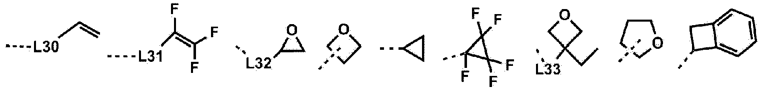 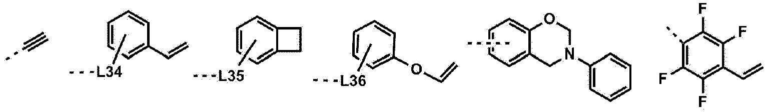 in the structures,
L30 to L36 are the same as or different from each other, and are each independently a direct bond; -O-; -COO-; a substituted or unsubstituted alkylene group; a substituted or unsubstituted arylene group; or a combination thereof, and
------ is a moiety bonded to Chemical Formula 3.

11. The polymer of claim 1, wherein the first unit and the second unit are different from each other, and are each any one of the following structures:

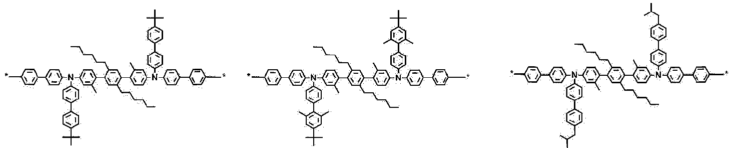

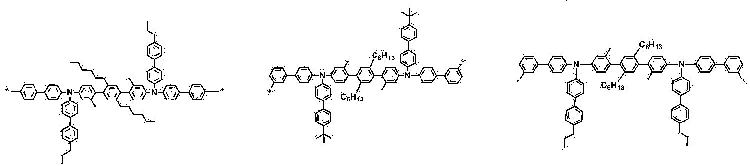

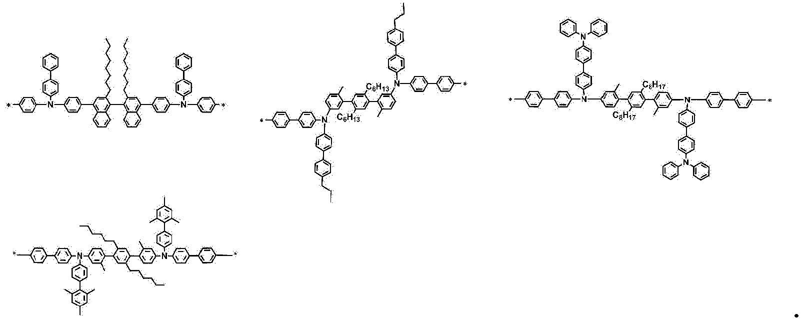

12. The polymer of claim 1, wherein the polymer is any one of the following structures: 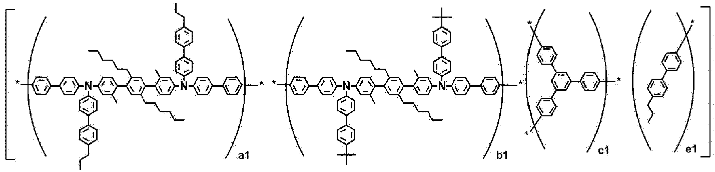 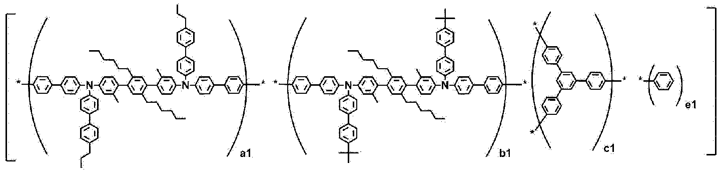 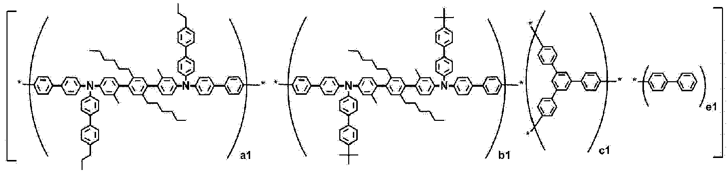 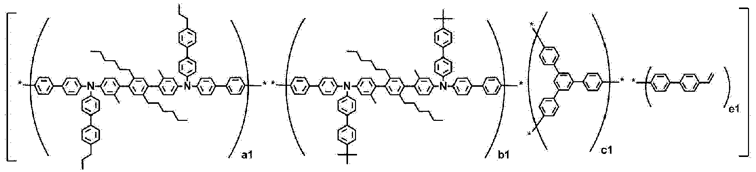 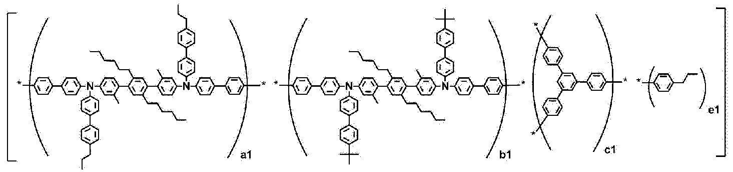 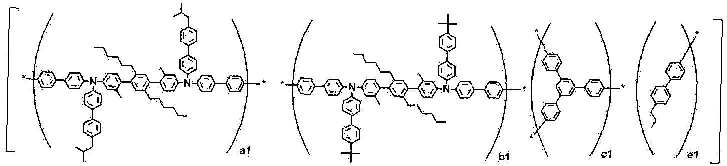 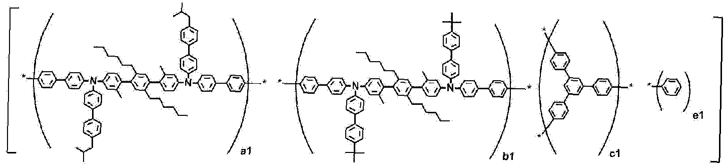 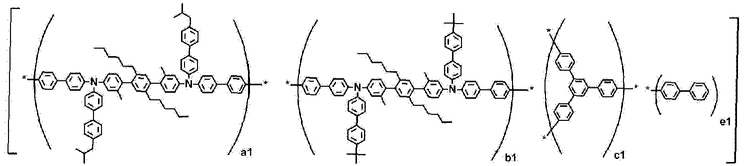 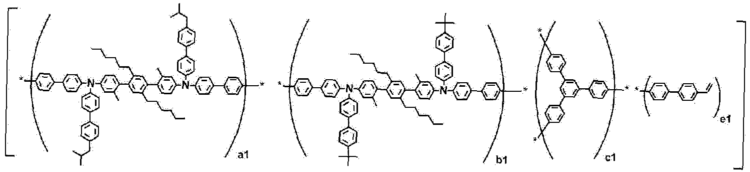 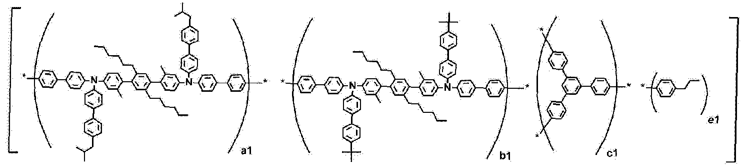 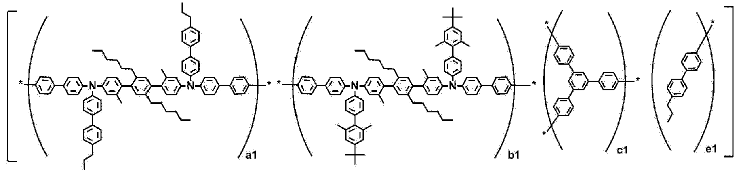 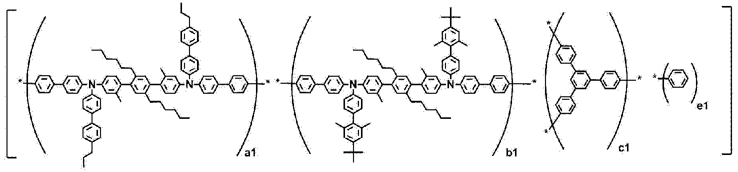 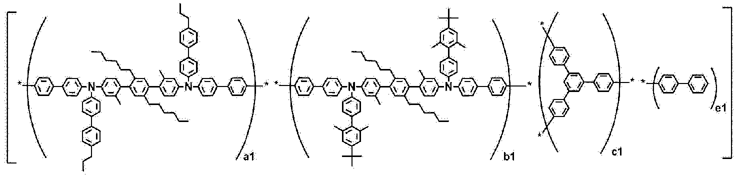 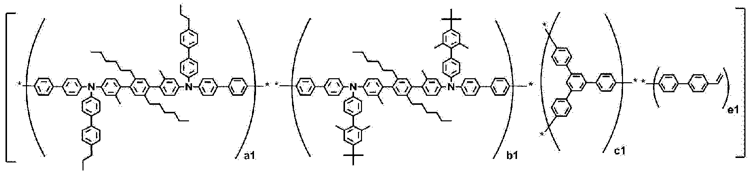 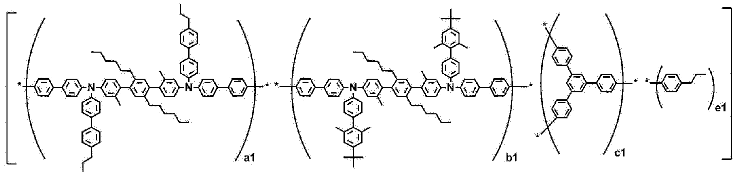 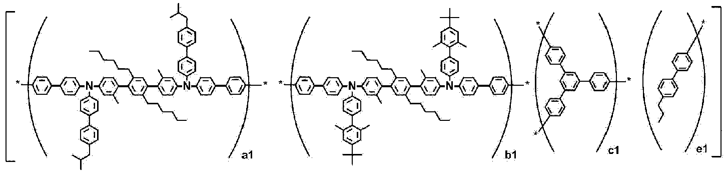 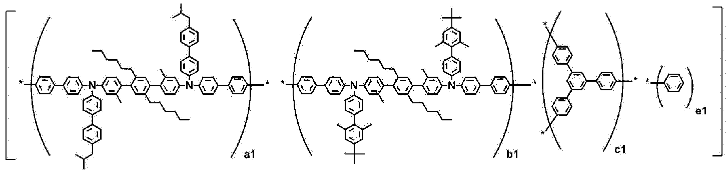 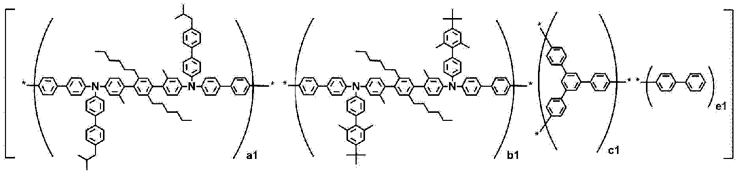 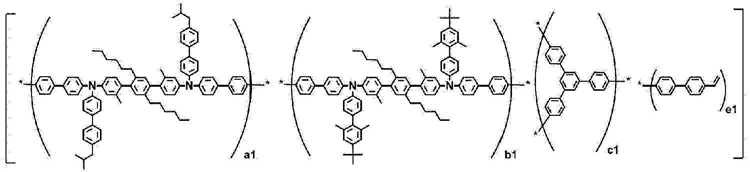 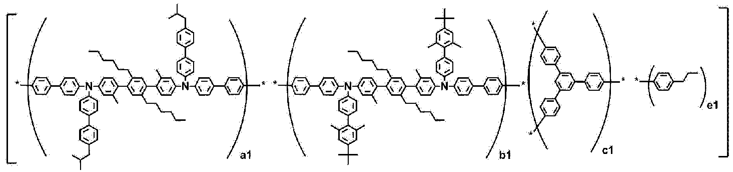 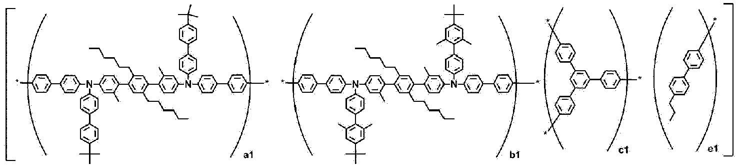 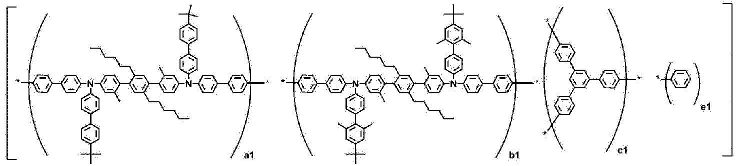 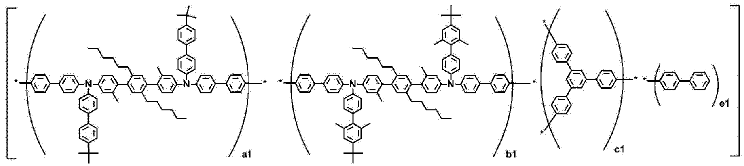 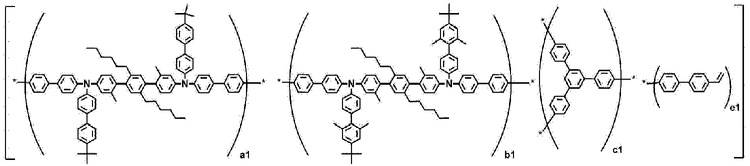 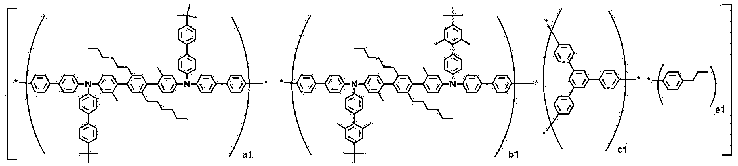 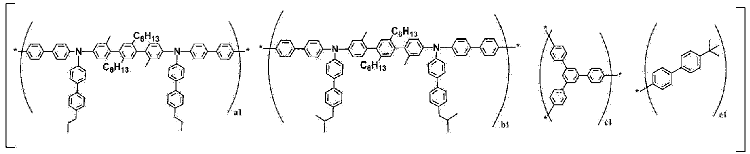 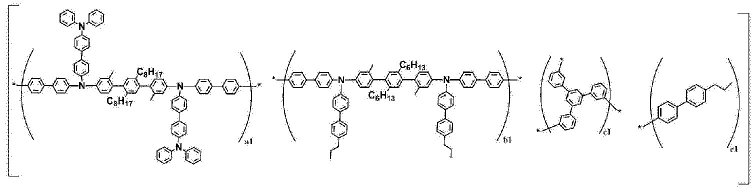 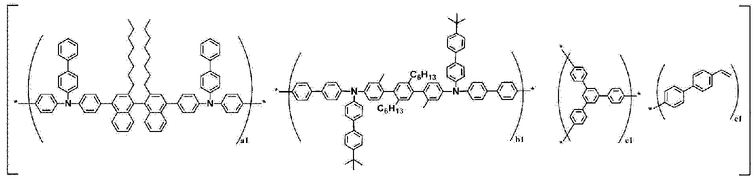 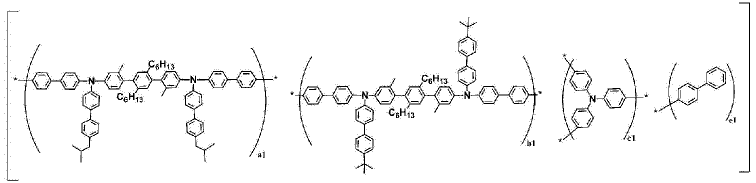 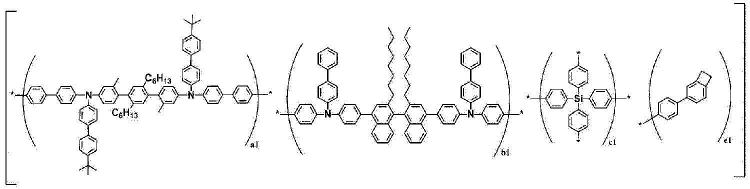 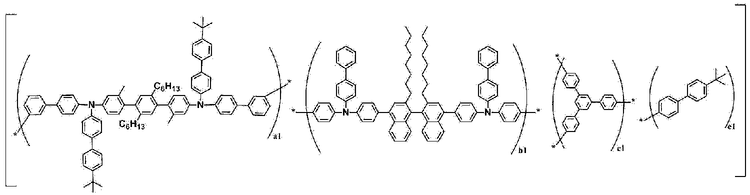 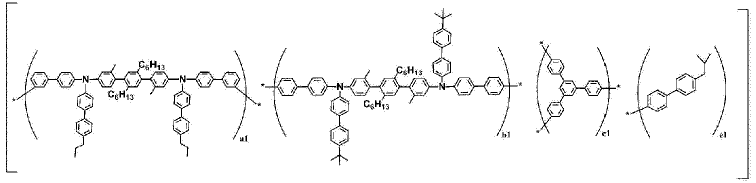 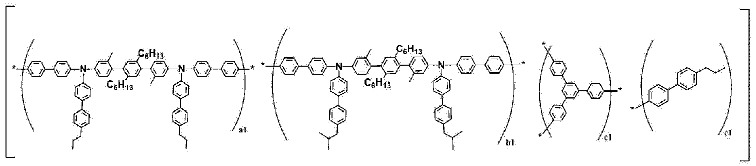 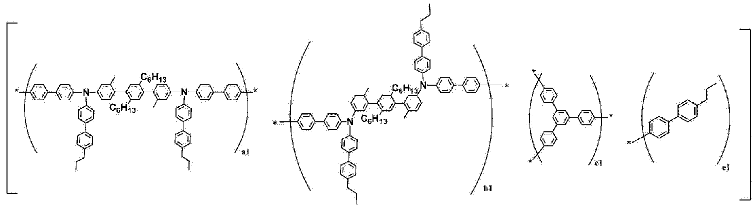 in the structures, a1 is a real number of 0<a1<1, b1 is a real number of 0<b1<1, c1 is a real number of 0<c1<1, e1 is a real number of 0<e1<1, and a1+b1+c1+e1 is 1.

13. An organic light emitting device comprising:
a first electrode;
a second electrode; and
an organic material layer having one or more layers provided between the first electrode and the second electrode,
wherein one or more layers of the organic material layer comprise the polymer of any one of claims 1 to 12.

14. The organic light emitting device of claim 13, wherein the organic material layer comprising the polymer is a hole injection layer, a hole transport layer, or a layer which simultaneously injects and transports holes.

## Patentansprüche

1. Polymer, umfassend:
eine erste Einheit, dargestellt durch die folgende chemische Formel 1;
eine zweite Einheit, dargestellt durch die folgende chemische Formel 1 und sich von der ersten Einheit unterscheidend;
eine dritte Einheit, dargestellt durch die folgende chemische Formel 2; und
eine Endgruppe, dargestellt durch die folgende chemische Formel 3: 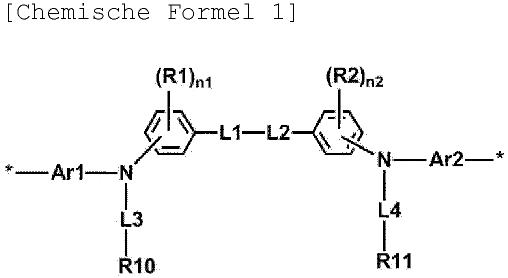 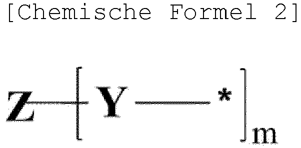 [Chemische Formel 3] *-[E]
worin in den chemischen Formel 1 bis 3
L1, L3 und L4 gleich oder voneinander verschieden sind und jeweils unabhängig eine direkte Bindung; oder eine substituierte oder unsubstituierte Arylengruppe sind,
Ar1, Ar2 und L2 gleich oder voneinander verschieden sind und jeweils unabhängig eine substituierte oder unsubstituierte Arylengruppe sind,
R1 und R2 gleich oder voneinander verschieden sind und jeweils unabhängig Wasserstoff; Deuterium; eine Halogengruppe; eine substituierte oder unsubstituierte Alkylgruppe; eine substituierte oder unsubstituierte Silylgruppe; eine substituierte oder unsubstituierte Arylgruppe; eine substituierte oder unsubstituierte heterocyclische Gruppe; eine substituierte oder unsubstituierte Arylamingruppe; oder eine substituierte oder unsubstituierte Siloxangruppe sind,
R10 und R11 gleich oder voneinander verschieden sind und jeweils unabhängig eine substituierte oder unsubstituierte Alkylgruppe; eine substituierte oder unsubstituierte Arylgruppe; eine substituierte oder unsubstituierte heterocyclische Gruppe; oder eine substituierte oder unsubstituierte Arylamingruppe sind,
n1 und n2 jeweils eine ganze Zahl von 1 bis 4 sind, und wenn n1 und n2 jeweils 2 oder größer sind, die Substituenten in den Klammern gleich oder voneinander verschieden sind,
m eine ganze Zahl von 3 oder 4 ist,
wenn m 3 ist, Z CRa; SiRa; N; oder eine substituierte oder unsubstituierte trivalente Arylgruppe ist,
wenn m 4 ist, Z C; Si; oder eine substituierte oder unsubstituierte tetravalente Arylgruppe ist,
Ra Wasserstoff; Deuterium; eine substituierte oder unsubstituierte Alkylgruppe; oder eine substituierte oder unsubstituierte Arylgruppe ist,
Y eine direkte Bindung; eine substituierte oder unsubstituierte Alkylengruppe; oder eine substituierte oder unsubstituierte Arylengruppe ist,
wenn Y eine direkte Bindung; oder eine substituierte oder unsubstituierte Alkylengruppe ist, Z eine substituierte oder unsubstituierte trivalente oder tetravalente Arylgruppe ist,
E Wasserstoff; Deuterium; eine substituierte oder unsubstituierte Alkylgruppe; eine substituierte oder unsubstituierte Silylgruppe; eine substituierte oder unsubstituierte Arylgruppe; eine substituierte oder unsubstituierte Arylamingruppe; eine substituierte oder unsubstituierte Siloxangruppe; eine substituierte oder unsubstituierte heterocyclische Gruppe; eine vernetzbare Gruppe; oder eine Kombination hiervon ist, und
* ein Verbindungspunkt in dem Polymer ist.

2. Polymer gemäß Anspruch 1, worin das Polymer durch die folgende chemische Formel 4 dargestellt ist:
[Chemische Formel 4] E1-[A1]ₐ-[B1]_{b}-[C1]_{c}-E2
worin in der chemischen Formel 4
A1 die erste, durch die chemische Formel 1 dargestellte Einheit ist,
B1 eine zweite Einheit ist, die durch die chemische Formel 1 dargestellt ist und sich von der ersten Einheit unterscheidet,
C1 die dritte Einheit ist, die durch die chemische Formel 2 dargestellt ist,
E1 und E2 gleich oder voneinander verschieden sind und jeweils unabhängig die durch die chemische Formel 3 dargestellte Endgruppe sind,
a, b und c jeweils eine Molfraktion sind, a eine reale Zahl von 0<a<1 ist, b eine reale Zahl von 0<b<1 ist, c eine reale Zahl von 0<c<1 ist und a+b+c 1 ist.

3. Polymer gemäß Anspruch 1, worin die chemische Formel 1 durch irgendeine der folgenden chemischen Formeln 1-1 bis 1-4 dargestellt ist: 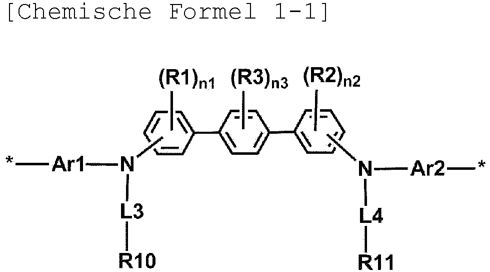 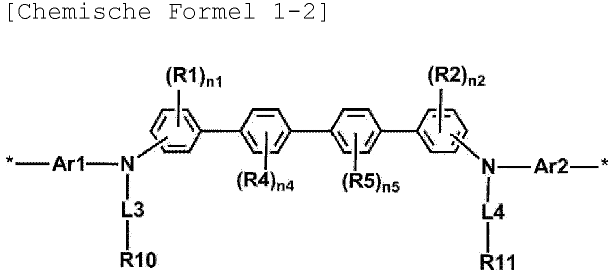 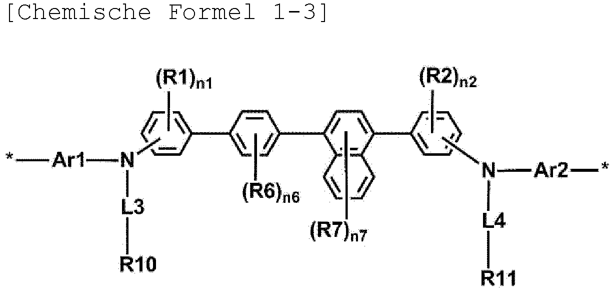 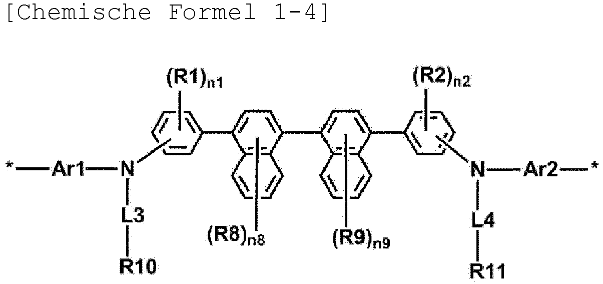 Worin in den chemischen Formel 1-1 bis 1-4
R1, R2, R10, R11, Ar1, Ar2, L3, L4, n1 und n2 jeweils die gleichen sind wie diejenigen, die in der chemischen Formel 1 definiert sind,
R3 bis R9 gleich oder voneinander verschieden sind und jeweils unabhängig Wasserstoff; Deuterium; eine Halogengruppe; eine substituierte oder unsubstituierte Alkylgruppe; eine substituierte oder unsubstituierte Silylgruppe; eine substituierte oder unsubstituierte Arylgruppe; eine substituierte oder unsubstituierte heterocyclische Gruppe; eine substituierte oder unsubstituierte Arylamingruppe; oder eine substituierte oder unsubstituierte Siloxangruppe sind,
n3 bis n6 jeweils ganze Zahlen von 1 bis 4 sind, und wenn n3 bis n6 jeweils 2 oder größer sind, die Substituenten in den Klammern gleich oder voneinander verschieden sind,
n7 bis n9 jeweils eine ganze Zahl von 1 bis 6 sind, und wenn n7 bis n9 jeweils 2 oder größer sind, die Substituenten in den Klammern gleich oder voneinander verschieden sind, und
* ein Verbindungspunkt in dem Polymer ist.

4. Polymer gemäß Anspruch 1, worin zumindest eine von der ersten Einheit und der zweiten Einheit die folgende chemische Formel 1-A1 ist: 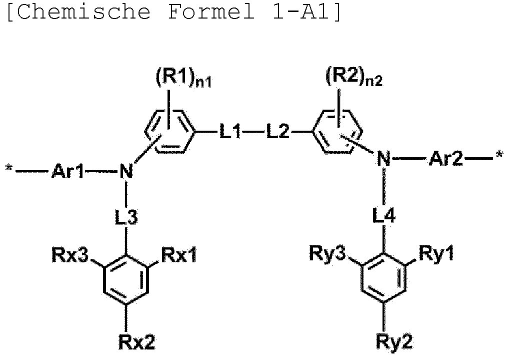 worin in der chemischen Formel 1-A1
L1 bis L4, R1, R2, Ar1, Ar2, n1 und n2 gleich sind wie diejenigen, die in der chemischen Formel 1 definiert sind,
Rx1 bis Rx3 und Ry1 bis Ry3 gleich oder voneinander verschieden sind und jeweils unabhängig Wasserstoff; oder eine substituierte oder unsubstituierte Alkylgruppe sind,
wobei zumindest eines von Rx1 bis Rx3 und zumindest eines von Ry1 bis Ry3 eine substituierte oder unsubstituierte Alkylgruppe ist, und
* ein Verbindungspunkt in dem Polymer ist.

5. Polymer gemäß Anspruch 4, worin Rx2 und Ry2 gleich oder voneinander verschieden sind und jeweils unabhängig eine verzweigte Alkylgruppe mit 4 bis 30 Kohlenstoffatomen sind.

6. Polymer gemäß Anspruch 4, worin L1 eine direkte Bindung ist und L2 eine substituierte oder unsubstituierte Phenylengruppe ist.

7. Polymer gemäß Anspruch 1, worin die chemische Formel 2 irgendeine der folgende chemischen Formeln 2-1 bis 2-4 ist: 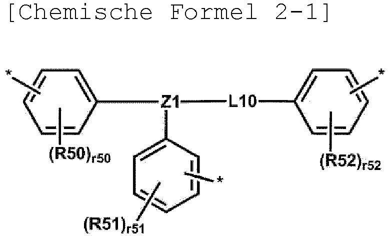 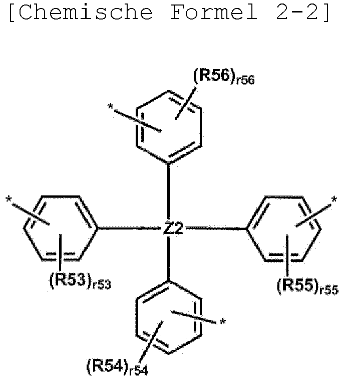 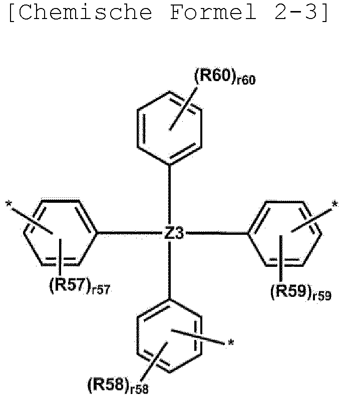 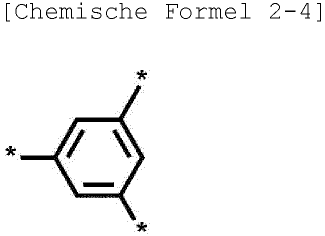 worin in den chemischen Formel 2-1 bis 2-4
Z1 CRA; SiRa; N, oder eine substituierte oder unsubstituierte trivalente Arylgruppe ist,
Z2 und Z3 gleich oder voneinander verschieden sind und jeweils unabhängig C; Si; oder eine substituierte oder unsubstituierte tetravalente Arylgruppe sind,
L10 eine direkte Bindung; oder eine substituierte oder unsubstituierte Arylengruppe ist,
Ra Wasserstoff; Deuterium; eine substituierte oder unsubstituierte Alkylgruppe; oder eine substituierte oder unsubstituierte Arylgruppe ist,
R50 bis R60 gleich oder voneinander verschieden sind und jeweils unabhängig Wasserstoff; Deuterium; eine Halogengruppe; eine Cyanogruppe; eine Alkoxygruppe; eine Aryloxygruppe; eine Siloxangruppe; eine substituierte oder unsubstituierte Amingruppe; eine substituierte oder unsubstituierte Alkylgruppe; eine substituierte oder unsubstituierte Arylgruppe; eine substituierte oder unsubstituierte heterocyclische Gruppe; oder eine vernetzbare Gruppe sind, und benachbarte Gruppen aneinander gebunden sein können, um einen Ring zu bilden,
r50 bis r59 jeweils eine ganze Zahl von 1 bis 4 sind, r60 eine ganze Zahl von 1 bis 5 ist, und wenn r50 bis r60 2 oder größer sind, die Substituenten in den Klammern gleich oder voneinander verschieden sind, und
* ein Verbindungspunkt in dem Polymer ist.

8. Polymer gemäß Anspruch 1, worin E eine substituierte oder unsubstituierte Alkylgruppe; eine substituierte oder unsubstituierte Arylgruppe; eine vernetzbare Gruppe; oder eine Kombination hiervon ist.

9. Polymer gemäß Anspruch 1, worin E eine vernetzbare Gruppe; oder irgendeine der folgenden Strukturen ist: 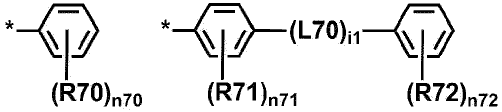 worin in den Strukturen
R70 bis R72 gleich oder voneinander verschieden sind und jeweils unabhängig Wasserstoff; Deuterium; eine substituierte oder unsubstituierte Alkylgruppe; eine substituierte oder unsubstituierte Arylgruppe; eine substituierte oder unsubstituierte heterocyclische Gruppe; oder eine vernetzbare Gruppe sind,
L70 eine direkte Bindung; eine substituierte oder unsubstituierte Alkylengruppe; oder eine substituierte oder unsubstituierte Arylengruppe sind,
i1 eine ganze Zahl von 1 bis 10 ist, und wenn i1 2 oder größer ist, zwei oder mehr der L70 gleich oder voneinander verschieden sind,
n70 und n72 jeweils eine ganze Zahl von 1 bis 5 sind, n71 eine ganze Zahl von 1 bis 4 ist, und wenn n70 bis n72 jeweils 2 oder größer sind, die Substituenten in den Klammern gleich oder voneinander verschieden sind, und
* ein Verbindungspunkt in dem Polymer ist.

10. Polymer gemäß Anspruch 1, worin die vernetzbare Gruppe irgendeine der folgenden Strukturen ist: 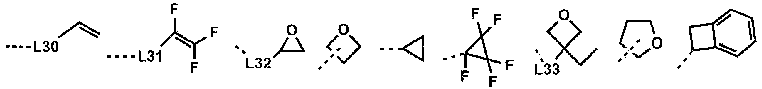 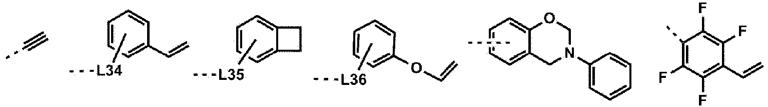 worin in den Strukturen
L30 bis L36 gleich oder voneinander verschieden sind und jeweils unabhängig eine direkte Bindung; -O-; -COO-; eine substituierte oder unsubstituierte Alkylengruppe; eine substituierte oder unsubstituierte Arylengruppe; oder eine Kombination hiervon sind, und
------ ein an die chemische Formel 3 gebundener Rest ist.

11. Polymer gemäß Anspruch 1, worin die erste Einheit und die zweite Einheit sich voneinander unterscheiden und jeweils irgendeine der folgenden Strukturen sind:

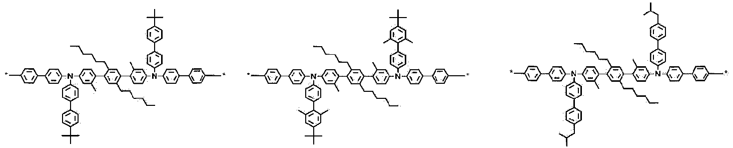

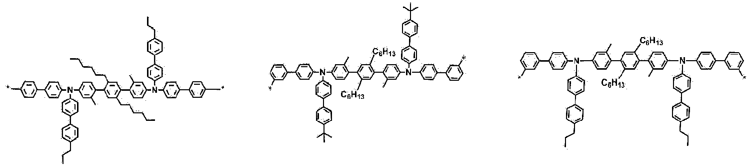

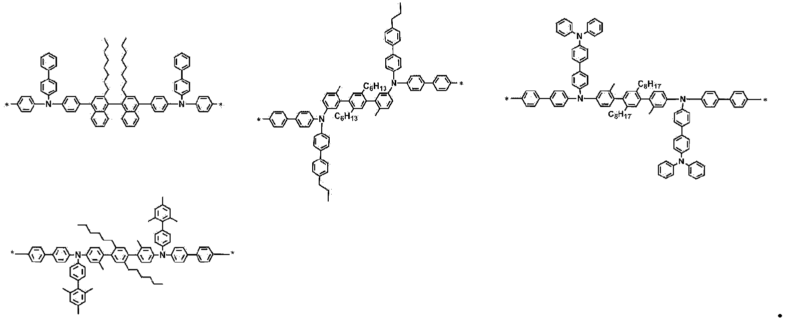

12. Polymer gemäß Anspruch 1, worin das Polymer irgendeine der folgenden Strukturen aufweist: 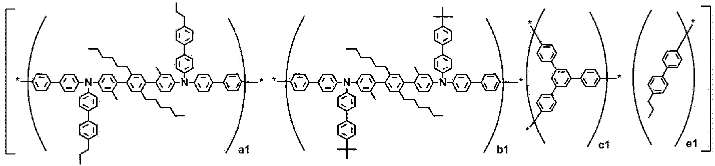 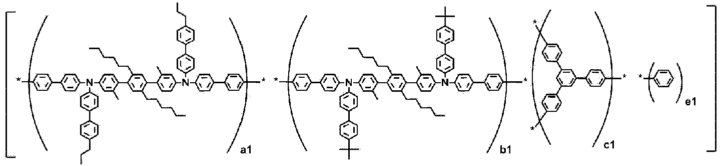 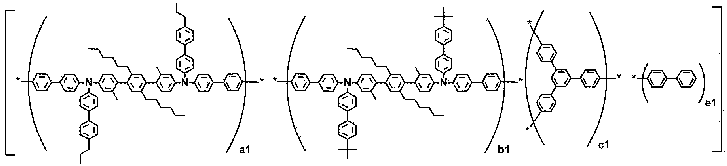 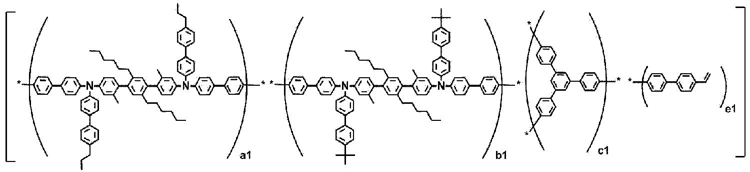 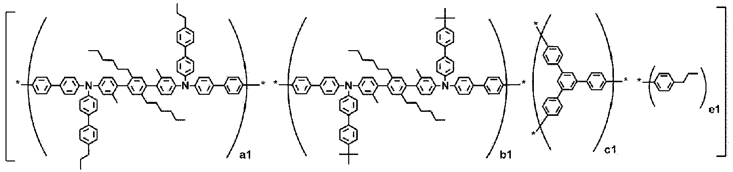 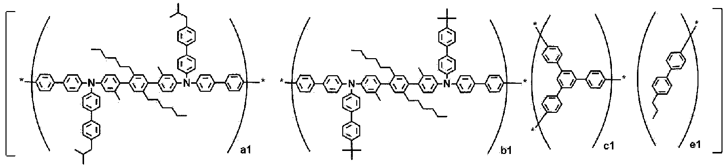 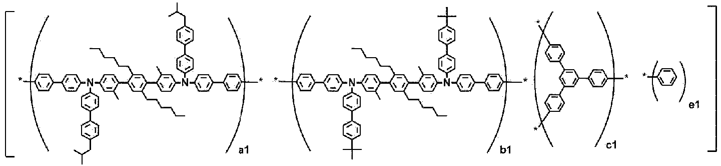 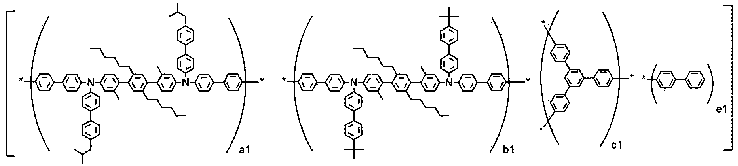 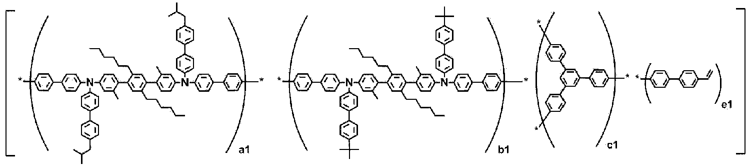 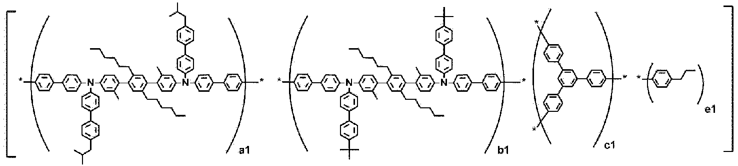 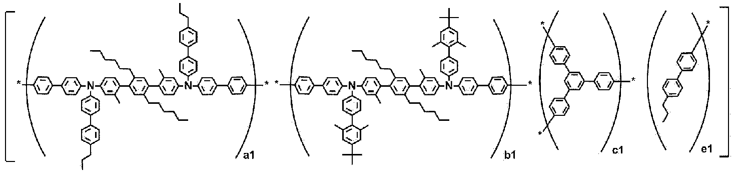 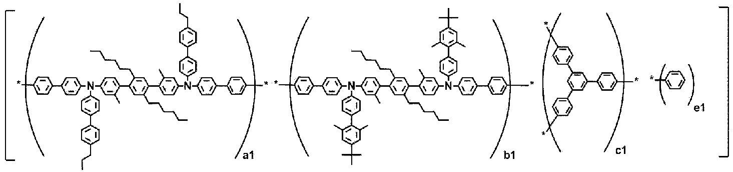 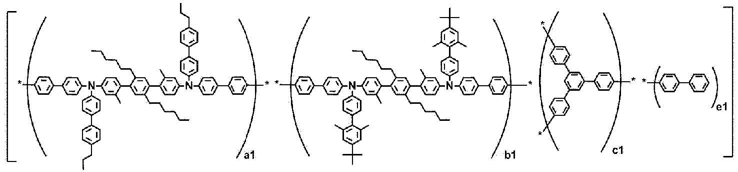 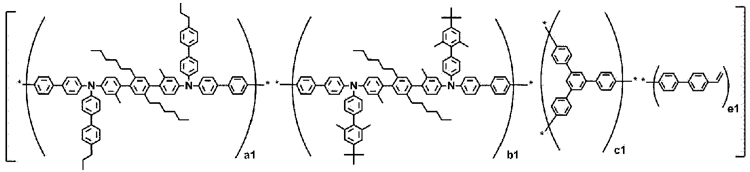 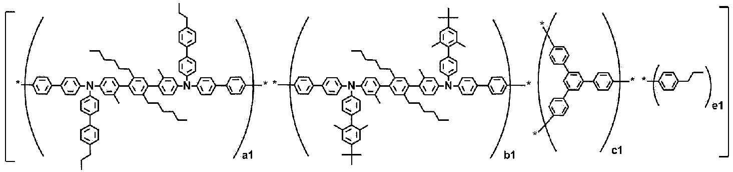 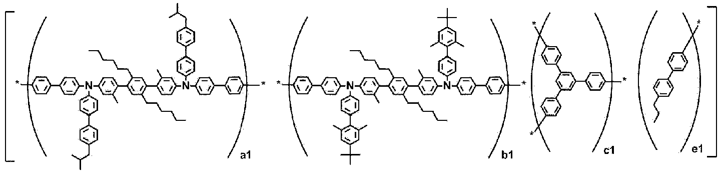 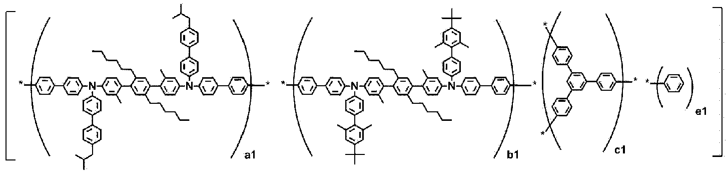 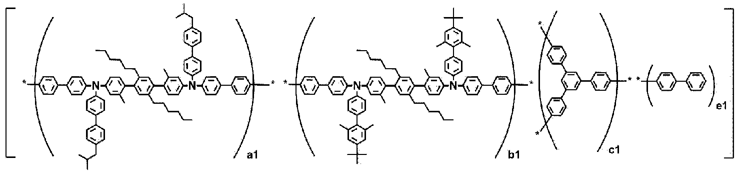 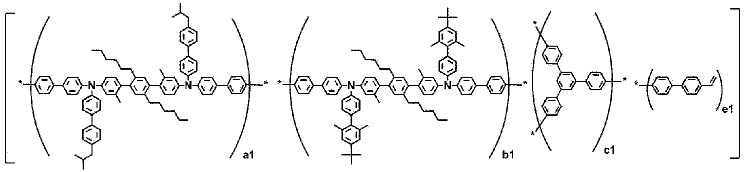 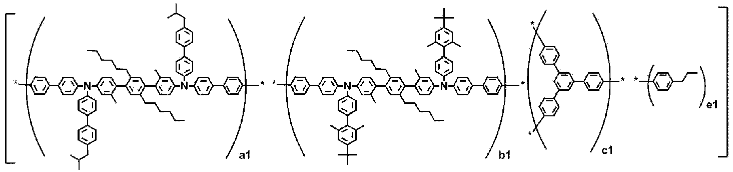 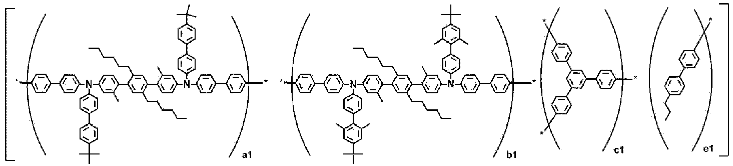 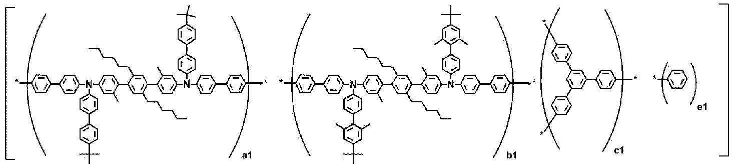 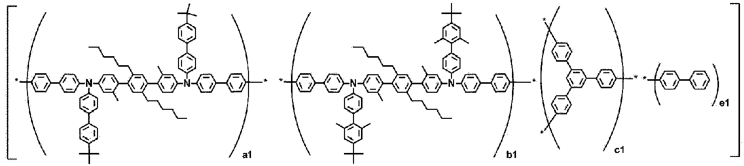 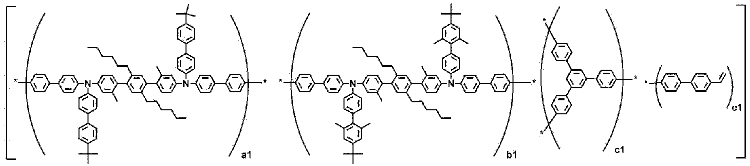 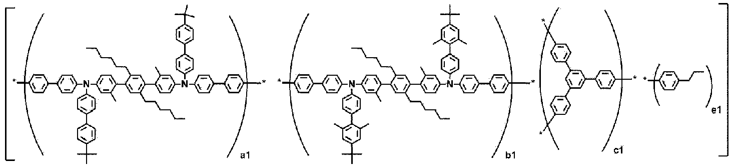 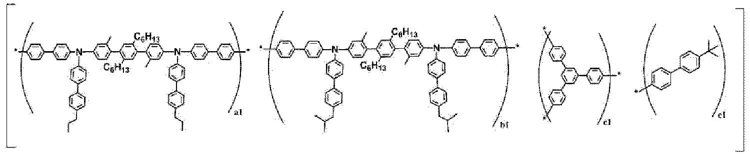 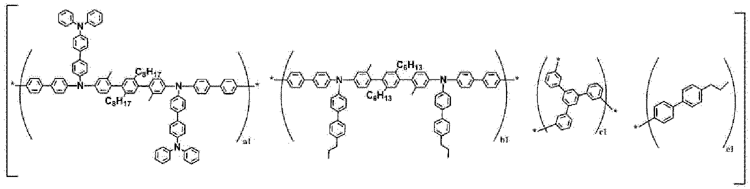 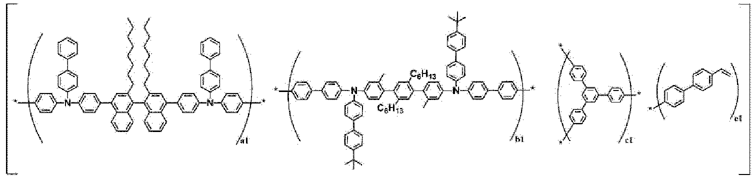 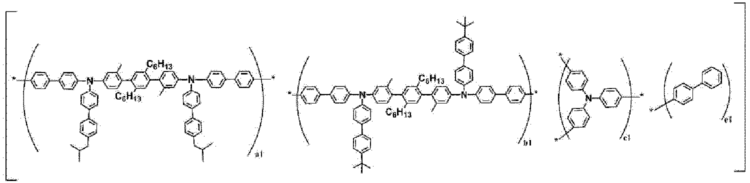 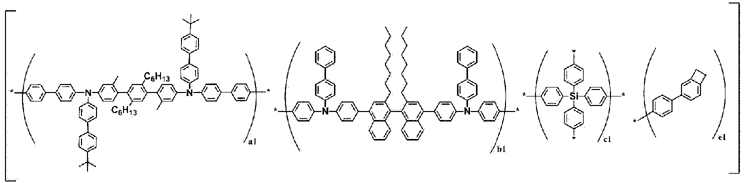 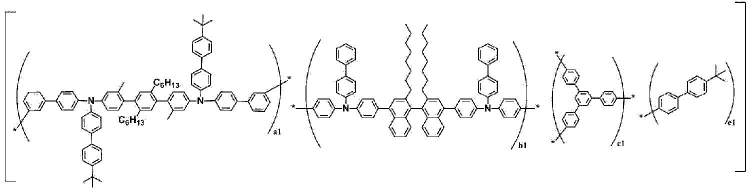 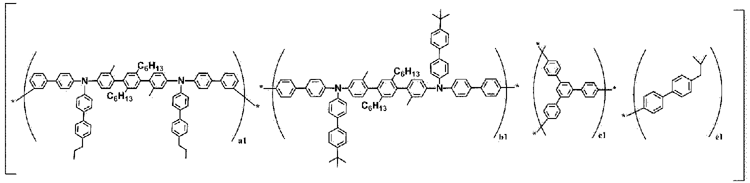 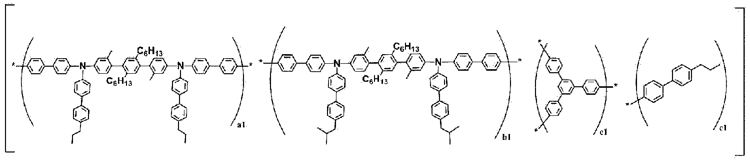 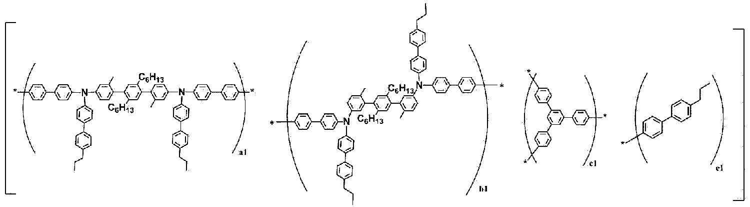 worin in den Strukturen a1 eine reale Zahl von 0<a1<1 ist, b1 eine reale Zahl von 0<b1<1 ist, c1 eine reale Zahl von 0<c1<1 ist, e1 eine reale Zahl von 0<e1<1 ist, und a1+b1+c1+e1 1 ist.

13. Organische lichtemittierende Vorrichtung, umfassend:
eine erste Elektrode;
eine zweite Elektrode; und
eine organische Materialschicht, die eine oder mehr Schicht(en) aufweist, vorgesehen zwischen der ersten Elektrode und der zweiten Elektrode,
worin eine oder mehr Schicht(en) der organischen Materialschicht das Polymer gemäß irgendeinem der Ansprüche 1 bis 12 umfasst.

14. Organische lichtemittierende Vorrichtung gemäß Anspruch 13, worin die organische Materialschicht, die das Polymer umfasst, eine Lochinjektionsschicht, eine Lochtransportschicht oder eine Schicht, die simultan Löcher injiziert und transportiert, ist.

## Revendications

1. Polymère comprenant :
une première unité représentée par la formule chimique 1 suivante ;
une deuxième unité représentée par la formule chimique 1 suivante et différente de la première unité ;
une troisième unité représentée par la formule chimique 2 suivante ; et
un groupe terminal représenté par la formule chimique 3 suivante : 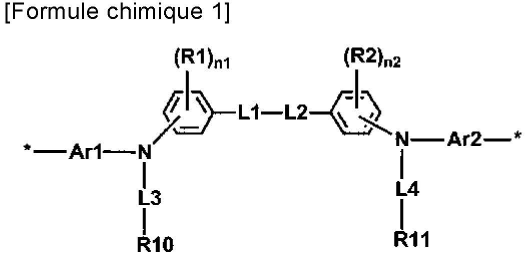 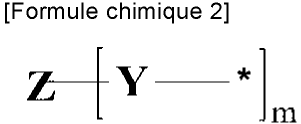
[Formule chimique 3] *-[E]
dans lequel, dans les formules chimiques 1 à 3,
L1, L3 et L4 sont identiques les uns aux autres ou différents les uns des autres, et sont chacun indépendamment une liaison directe ; ou un groupe arylène substitué ou non substitué,
Ar1, Ar2 et L2 sont identiques les uns aux autres ou différents les uns des autres, et sont chacun indépendamment un groupe arylène substitué ou non substitué,
R1 et R2 sont identiques l'un à l'autre ou différents l'un de l'autre, et sont chacun indépendamment hydrogène ; deutérium ; un groupe halogène ; un groupe alkyle substitué ou non substitué ; un groupe silyle substitué ou non substitué ; un groupe aryle substitué ou non substitué ; un groupe hétérocyclique substitué ou non substitué ; un groupe arylamine substitué ou non substitué ; ou un groupe siloxane substitué ou non substitué,
R10 et R11 sont identiques l'un à l'autre ou différents l'un de l'autre, et sont chacun indépendamment un groupe alkyle substitué ou non substitué ; un groupe aryle substitué ou non substitué ; un groupe hétérocyclique substitué ou non substitué ; ou un groupe arylamine substitué ou non substitué,
n1 et n2 sont chacun un nombre entier de 1 à 4, et lorsque n1 et n2 sont chacun 2 ou plus, des substituants entre parenthèses sont identiques les uns aux autres ou différents les uns des autres,
m est un nombre entier de 3 ou 4,
lorsque m est 3, Z est CRa ; SiRa ; N ; ou un groupe aryle trivalent substitué ou non substitué,
lorsque m est 4, Z est C ; Si ; ou un groupe aryle tétravalent substitué ou non substitué,
Ra est hydrogène ; deutérium ; un groupe alkyle substitué ou non substitué ; ou un groupe aryle substitué ou non substitué,
Y est une liaison directe ; un groupe alkylène substitué ou non substitué ; ou un groupe arylène substitué ou non substitué,
lorsque Y est une liaison directe ; ou un groupe alkylène substitué ou non substitué, Z est un groupe aryle trivalent ou tétravalent substitué ou non substitué,
E est hydrogène ; deutérium ; un groupe alkyle substitué ou non substitué ; un groupe silyle substitué ou non substitué ; un groupe aryle substitué ou non substitué ; un groupe arylamine substitué ou non substitué ; un groupe siloxane substitué ou non substitué ; un groupe hétérocyclique substitué ou non substitué ; un groupe réticulable ; ou une combinaison de ceux-ci, et
* est un point d'attache dans le polymère.

2. Polymère selon la revendication 1, dans lequel le polymère est représenté par la formule chimique 4 suivante :
[Formule chimique 4] E1-[A1]ₐ-[B1]_{b}-[C1]_{c}-E2
dans la formule chimique 4,
A1 est la première unité représentée par la formule chimique 1,
B1 est une deuxième unité représentée par la formule chimique 1 suivante et différente de la première unité,
C1 est la troisième unité représentée par la formule chimique 2,
E1 et E2 sont identiques l'un à l'autre ou différents l'un de l'autre, et sont chacun indépendamment le groupe terminal représenté par la formule chimique 3, et
a, b et c sont chacun une fraction molaire, a est un nombre réel de 0<a<1, b est un nombre réel de 0<b<1, c est un nombre réel de 0<c<1, et a+b+c est 1.

3. Polymère selon la revendication 1, dans lequel la formule chimique 1 est représentée par l'une quelconque des formules chimiques 1-1 à 1-4 suivantes : 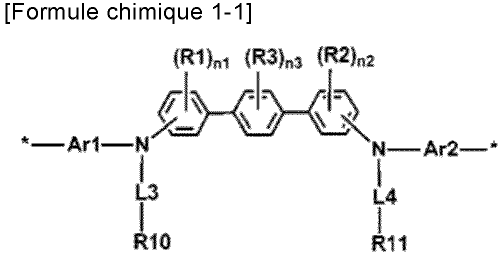 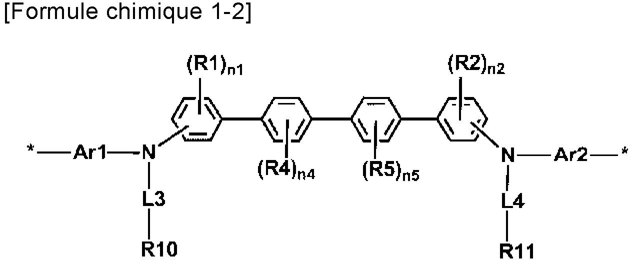 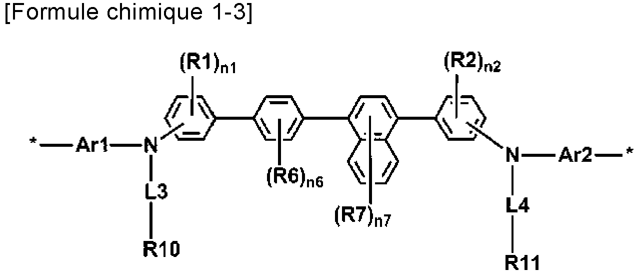 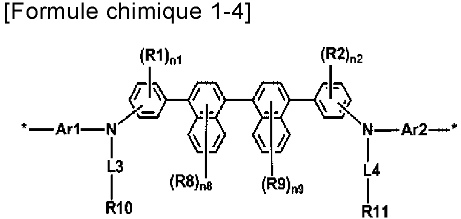 dans les formules chimiques 1-1 à 1-4,
R1, R2, R10, R11, Ar1, Ar2, L3, L4, n1 et n2 sont les mêmes que ceux définis dans la formule chimique 1,
R3 à R9 sont identiques les uns aux autres ou différents les uns des autres, et sont chacun indépendamment hydrogène ; deutérium ; un groupe halogène ; un groupe alkyle substitué ou non substitué ; un groupe silyle substitué ou non substitué ; un groupe aryle substitué ou non substitué ; un groupe hétérocyclique substitué ou non substitué ; un groupe arylamine substitué ou non substitué ; ou un groupe siloxane substitué ou non substitué,
n3 à n6 sont chacun un nombre entier de 1 à 4, et lorsque n3 à n6 sont chacun 2 ou plus, des substituants entre parenthèses sont identiques les uns aux autres ou différents les uns des autres,
n7 à n9 sont chacun un nombre entier de 1 à 6, et lorsque n7 à n9 sont chacun 2 ou plus, des substituants entre parenthèses sont identiques les uns aux autres ou différents les uns des autres, et
* est un point d'attache dans le polymère.

4. Polymère selon la revendication 1, dans lequel au moins l'une de la première unité et de la deuxième unité est la formule chimique 1-A1 suivante : 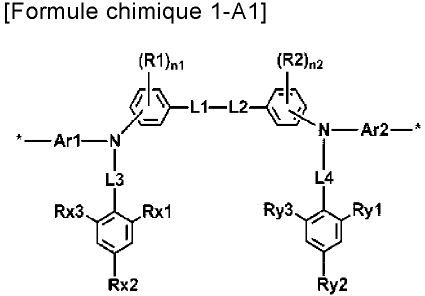 dans la formule chimique 1-A1,
L1 à L4, R1, R2, Ar1, Ar2, n1 et n2 sont les mêmes que ceux définis dans la formule chimique 1,
Rx1 à Rx3 et Ry1 à Ry3 sont identiques les uns aux autres ou différents les uns des autres, et sont chacun indépendamment hydrogène ; ou un groupe alkyle substitué ou non substitué,
au moins l'un de Rx1 à Rx3 et au moins l'un de Ry1 à Ry3 sont un groupe alkyle substitué ou non substitué, et
* est un point d'attache dans le polymère.

5. Polymère selon la revendication 4, dans lequel Rx2 et Ry2 sont identiques l'un à l'autre ou différents l'un de l'autre, et sont chacun indépendamment un groupe alkyle ramifié présentant 4 à 30 atomes de carbone.

6. Polymère selon la revendication 4, dans lequel L1 est une liaison directe, et L2 est un groupe phénylène substitué ou non substitué.

7. Polymère selon la revendication 1, dans lequel la formule chimique 2 est l'une quelconque des formules chimiques 2-1 à 2-4 suivantes : 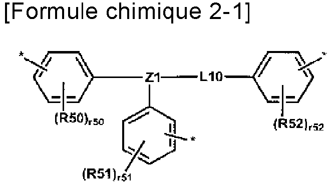 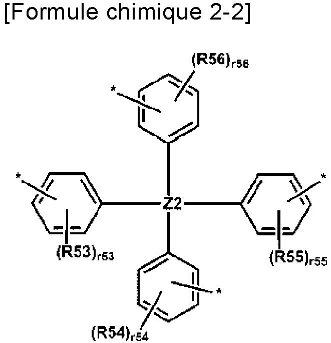 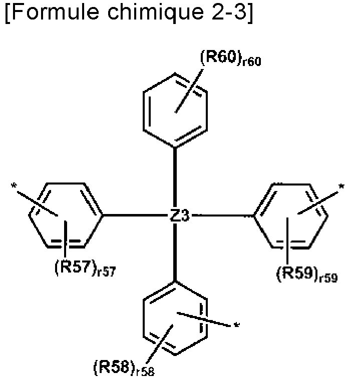 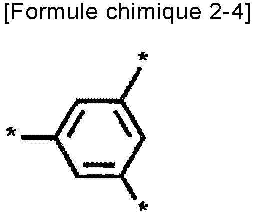 dans les formules chimiques 2-1 à 2-4,
Z1 est CRa ; SiRa ; N ; ou un groupe aryle trivalent substitué ou non substitué,
Z2 et Z3 sont identiques l'un à l'autre ou différents l'un de l'autre, et sont chacun indépendamment C ; Si ; ou un groupe aryle tétravalent substitué ou non substitué,
L10 est une liaison directe ; ou un groupe arylène substitué ou non substitué,
Ra est hydrogène ; deutérium ; un groupe alkyle substitué ou non substitué ; ou un groupe aryle substitué ou non substitué,
R50 à R60 sont identiques les uns aux autres ou différents les uns des autres, et sont chacun indépendamment hydrogène ; deutérium ; un groupe halogène ; un groupe cyano ; un groupe alcoxy ; un groupe aryloxy ; un groupe siloxane ; un groupe amine substitué ou non substitué ; un groupe alkyle substitué ou non substitué ; un groupe aryle substitué ou non substitué ; un groupe hétérocyclique substitué ou non substitué ; ou un groupe réticulable, et des groupes adjacents peuvent être liés entre eux pour former un cycle,
r50 à r59 sont chacun un nombre entier de 1 à 4, r60 est un nombre entier de 1 à 5, et lorsque r50 à r60 sont chacun 2 ou plus, des substituants entre parenthèses sont identiques les uns aux autres ou différents les uns des autres, et
* est un point d'attache dans le polymère.

8. Polymère selon la revendication 1, dans lequel E est un groupe alkyle substitué ou non substitué ; un groupe aryle substitué ou non substitué ; un groupe réticulable ; ou une combinaison de ceux-ci.

9. Polymère selon la revendication 1, dans lequel E est un groupe réticulable ; ou l'une quelconque des structures suivantes : 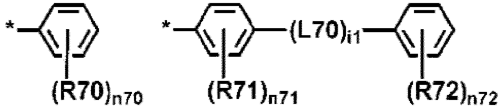 dans les structures,
R70 à R72 sont identiques les uns aux autres ou différents les uns des autres, et sont chacun indépendamment hydrogène ; deutérium ; un groupe alkyle substitué ou non substitué ; un groupe aryle substitué ou non substitué ; un groupe hétérocyclique substitué ou non substitué ; ou un groupe réticulable,
L70 est une liaison directe ; un groupe alkylène substitué ou non substitué ; ou un groupe arylène substitué ou non substitué,
i1 est un nombre entier de 1 à 10, et lorsque i1 est 2 ou plus, deux L70 ou plus sont identiques l'un à l'autre ou différents l'un de l'autre,
n70 et n72 sont chacun un nombre entier de 1 à 5, n71 est un nombre entier de 1 à 4, et lorsque n70 à n72 sont chacun 2 ou plus, des substituants entre parenthèses sont identiques les uns aux autres ou différents les uns des autres, et
* est un point d'attache dans le polymère.

10. Polymère selon la revendication 1, dans lequel le groupe réticulable est l'une quelconque des structures suivantes : 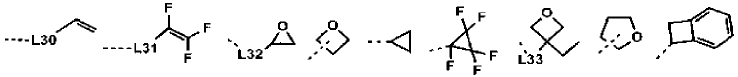 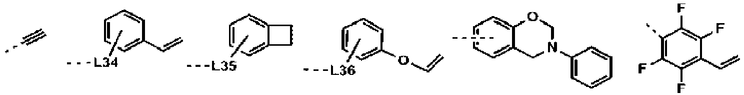 dans les structures,
L30 à L36 sont identiques les uns aux autres ou différents les uns des autres, et sont chacun indépendamment une liaison directe ; -O- ; -COO- ; un groupe alkylène substitué ou non substitué ; un groupe arylène substitué ou non substitué ; ou une combinaison de ceux-ci, et
------ est un fragment lié à la formule chimique 3.

11. Polymère selon la revendication 1, dans lequel la première unité et la deuxième unité sont différentes l'une de l'autre, et sont chacune l'une quelconque des structures suivantes :

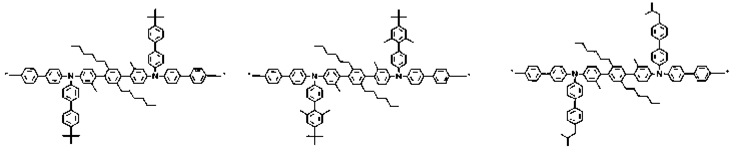

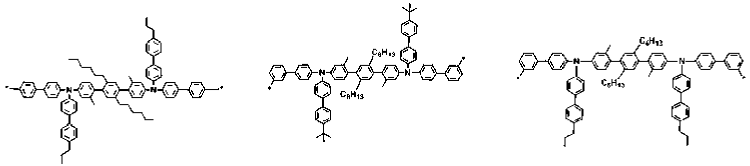

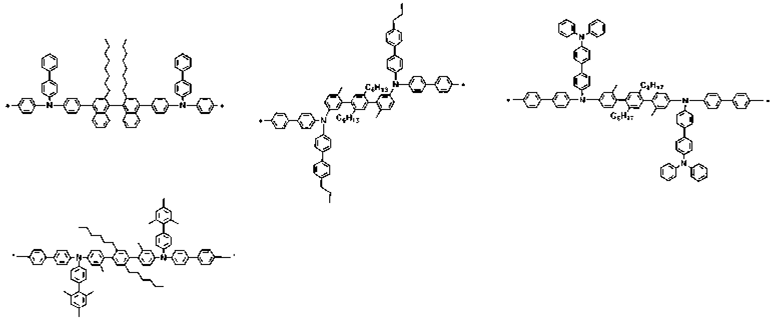

12. Polymère selon la revendication 1, dans lequel le polymère est l'une quelconque des structures suivantes : 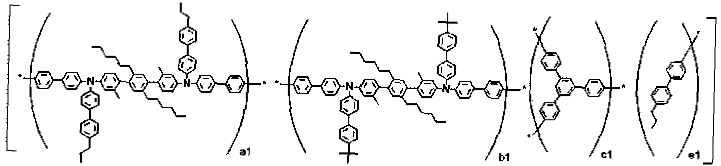 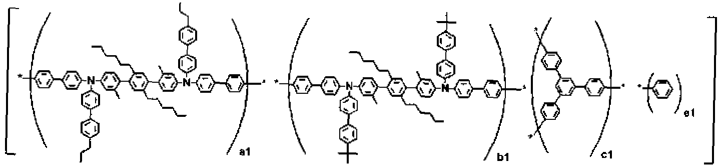 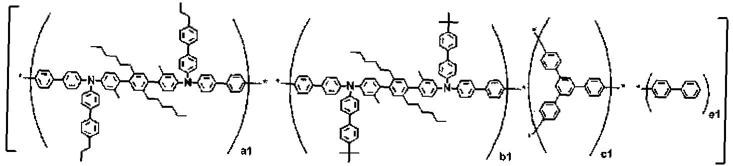 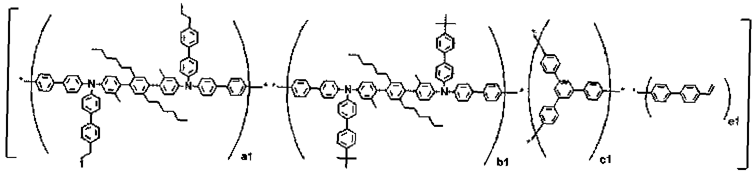 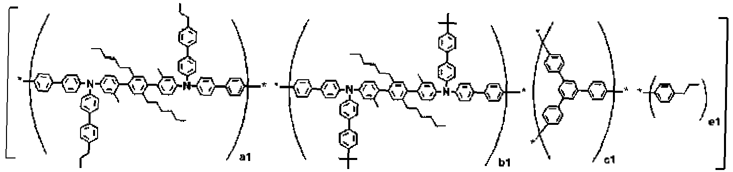 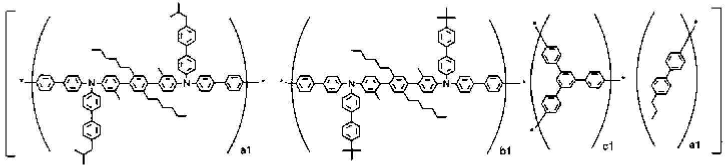 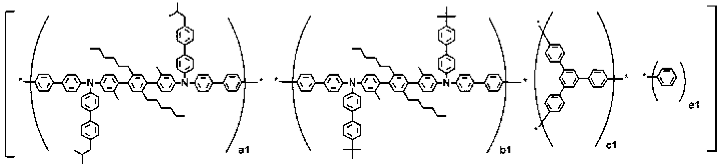 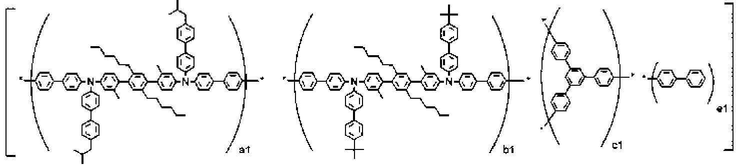 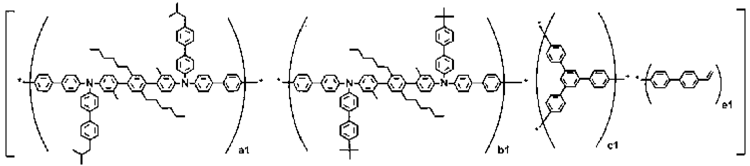 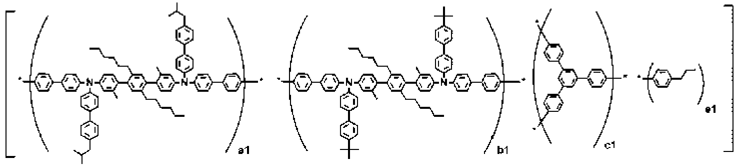 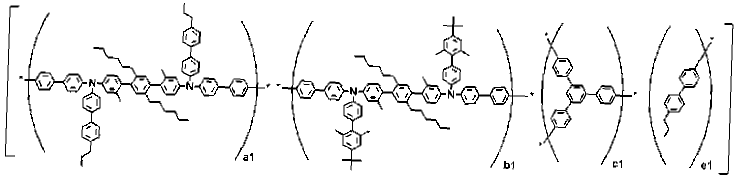 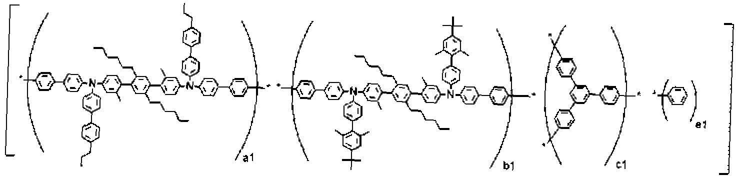 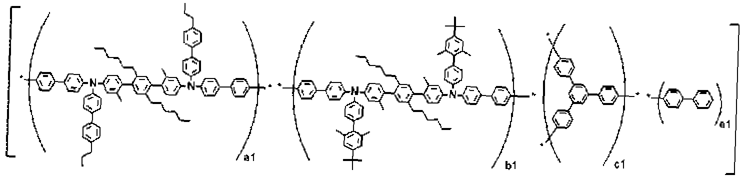 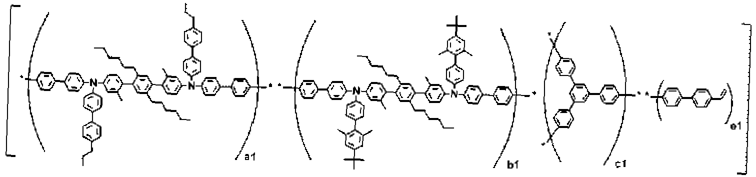 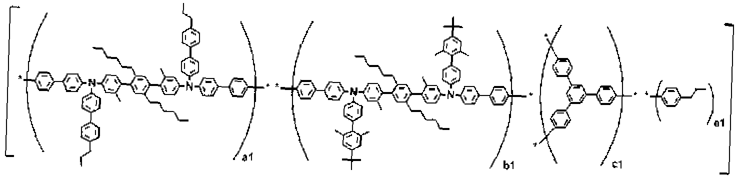 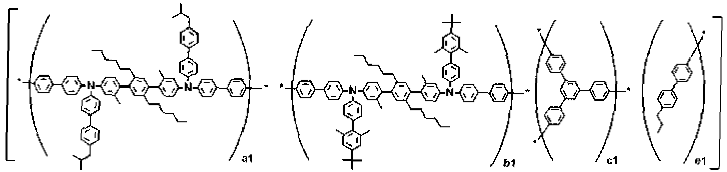 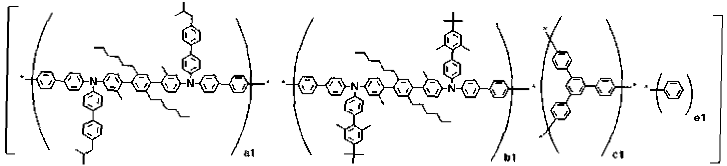 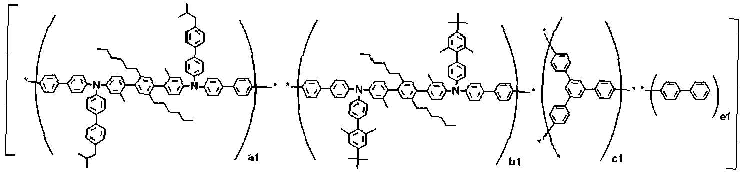 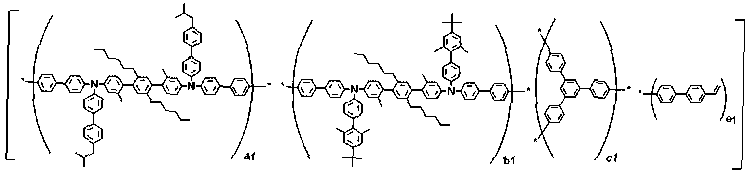 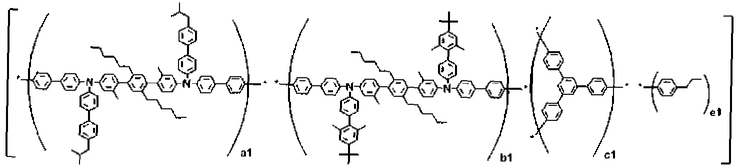 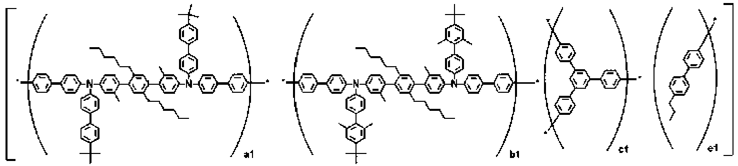 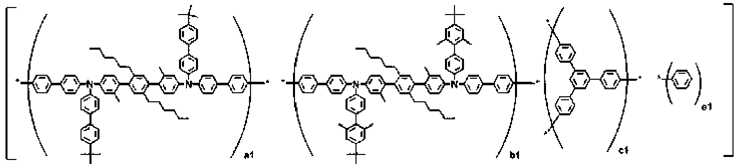 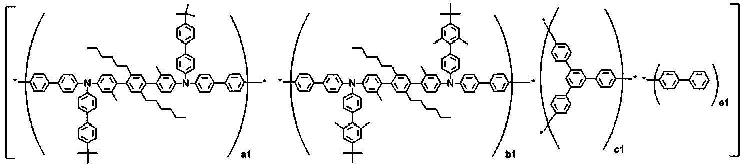 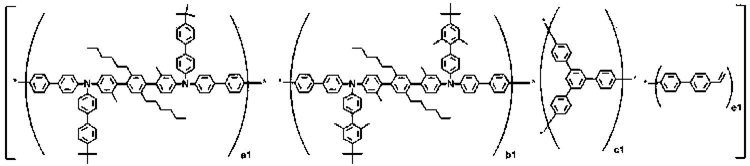 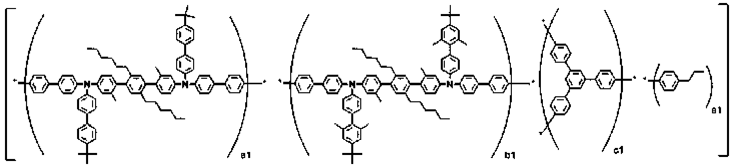 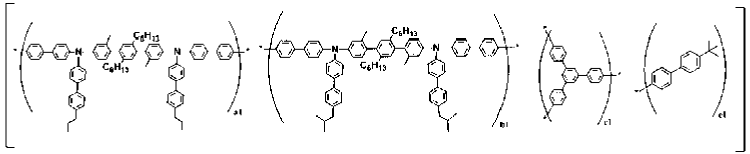 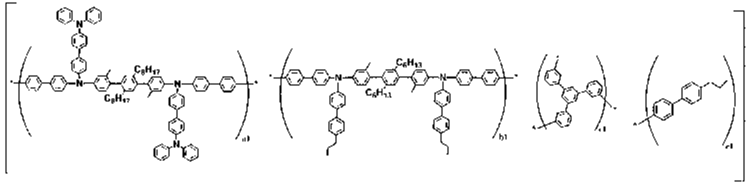 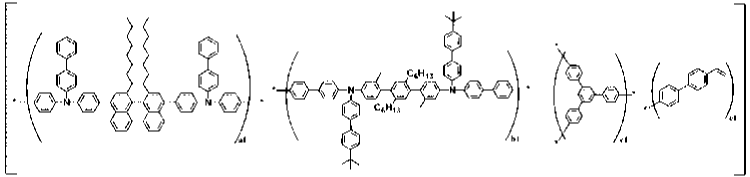 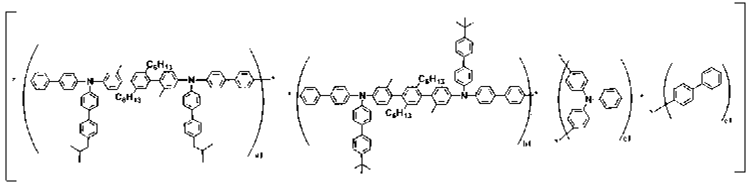 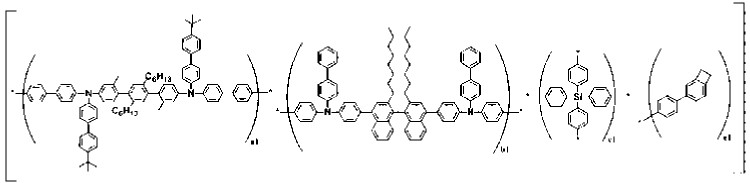 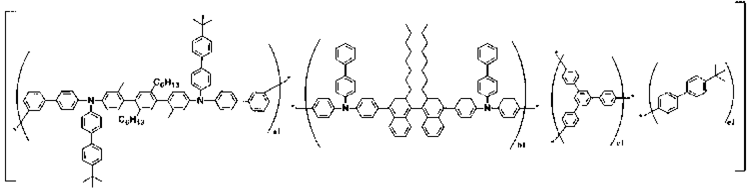 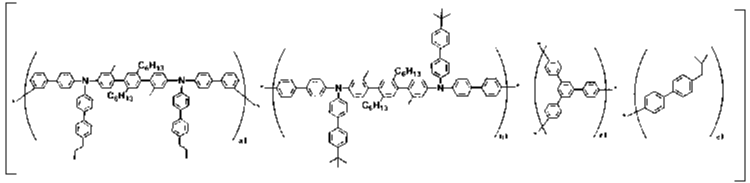 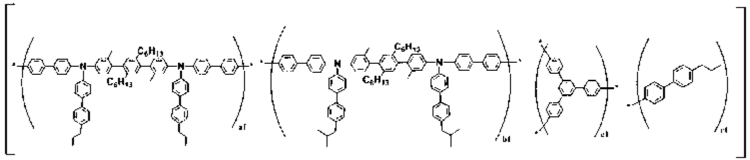 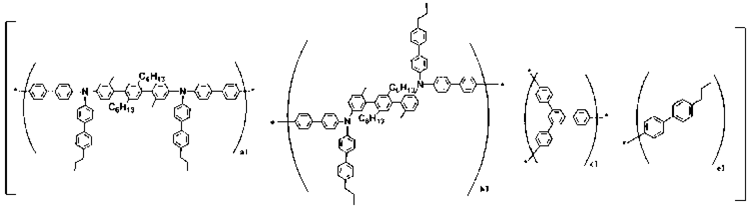 dans les structures, a1 est un nombre réel de 0<a1<1, b1 est un nombre réel de 0<b1<1, c1 est un nombre réel de 0<c1<1, e1 est un nombre réel de 0<e1<1, et a1+b1+c1+e1 est 1.

13. Dispositif électroluminescent organique comprenant :
une première électrode ;
une seconde électrode ; et
une couche de matériau organique présentant une ou plusieurs couches disposées entre la première électrode et la seconde électrode,
dans lequel une ou plusieurs couches de la couche de matériau organique comprennent le polymère selon l'une quelconque des revendications 1 à 12.

14. Dispositif électroluminescent organique selon la revendication 13, dans lequel la couche de matériau organique comprenant le polymère est une couche d'injection de trous, une couche de transport de trous, ou une couche qui injecte et transporte simultanément des trous.
